# EUROPEAN PATENT APPLICATION

(11) **EP 4 624 060 A1**
(43) Date of publication of application: **01.10.2025**
(21) Application number: 25166400.9
(22) Date of filing: 26.03.2025
(51) Int. Cl.: B06B 1/06, H04R 17/02, H10N 30/30, H10N 30/50, H10N 30/87

(54) **ACOUSTIC TRANSDUCER**

(30) Priority: 27.03.2024 JP 2024051669; 27.03.2024 JP 2024051668; 27.03.2024 JP 2024051667; 07.02.2025 JP 2025019549; 07.02.2025 JP 2025019548; 07.02.2025 JP 2025019550
(71) Applicant: MITSUMI ELECTRIC CO., LTD., Tama-Shi, Tokyo 206-8567 (JP)
(72) Inventor: YAMADA, Tsukasa, Tama-shi, 206-8567 (JP); SATO, Seiya, Tama-shi, 206-8567 (JP); TANAKA, Toyoki, Tama-shi, 206-8567 (JP)
(74) Representative: Regimbeau

(57) **Abstract**

An acoustic transducer includes a fixed frame; and a piezoelectric element fixed to the fixed frame. The piezoelectric element includes a plurality of detection regions configured to detect a physical quantity, and a non-detection region configured not to detect the physical quantity. Electrodes of the plurality of detection regions are electrically connected in series.

## Description

### TECHNICAL FIELD

The present disclosure relates to an acoustic transducer.

### BACKGROUND ART

There is, for example, a known piezoelectric element including a piezoelectric film supported at one end with the other end being a free end, and a pair of electrodes disposed across the piezoelectric film (see, for example, Patent Literature 1).

### CITATION LIST

### PATENT LITERATURE

Patent Literature 1: Japanese Patent Laid-Open Application Publication No. 2019-140638

### SUMMARY OF THE INVENTION

### TECHNICAL PROBLEM

An acoustic transducer including a piezoelectric element is required to be increased in sensitivity. An object of the present disclosure is to provide an acoustic transducer configured to be increased in sensitivity.

### SOLUTION TO THE PROBLEM

An acoustic transducer according to a first aspect of the present disclosure includes a fixed frame and a piezoelectric element fixed to the fixed frame, in which the piezoelectric element includes a plurality of detection regions configured to detect a physical quantity, and a non-detection region configured not to detect the physical quantity. Electrodes of the plurality of detection regions are electrically connected in series.

An acoustic transducer according to a second aspect of the present disclosure includes a fixed frame and a piezoelectric element fixed to the fixed frame, in which the piezoelectric element includes a detection region configured to detect a physical quantity, and a non-detection region configured not to detect the physical quantity.

An acoustic transducer according to a third aspect of the present disclosure includes a fixed frame and a piezoelectric element fixed to the fixed frame, in which the piezoelectric element includes a lower electrode, a first piezoelectric layer formed over the lower electrode, an intermediate electrode formed over the first piezoelectric layer, a second piezoelectric layer formed over the intermediate electrode, and an upper electrode formed over the second piezoelectric layer. A thickness of the intermediate electrode is larger than a thickness of the upper electrode or the lower electrode.

### ADVANTAGEOUS EFFECTS OF THE INVENTION

The present disclosure provides an acoustic transducer configured to be increased in sensitivity.

### BRIEF DESCRIPTION OF THE DRAWINGS

FIG. 1 is a plan view illustrating an acoustic transducer according to a first embodiment of a first aspect of the present disclosure;
FIG. 2 is a cross-sectional view illustrating the acoustic transducer according to the first embodiment of the first aspect, a cross section of the acoustic transducer along an XZ plane;
FIG. 3 is a cross-sectional view illustrating the acoustic transducer according to the first embodiment of the first aspect, a cross section of the acoustic transducer along a YZ plane;
FIG. 4 is a circuit diagram of the acoustic transducer according to embodiments of the first aspect;
FIG. 5 is a cross-sectional view illustrating an acoustic transducer according to a second embodiment of the first aspect, a cross section of the acoustic transducer along the YZ plane;
FIG. 6 is a cross-sectional view illustrating an acoustic transducer according to a third embodiment of the first aspect, a cross section of the acoustic transducer along the YZ plane;
FIG. 7 is a partial plan view illustrating a part of an acoustic transducer according to a fourth embodiment of the first aspect;
FIG. 8 is a partial enlarged plan view illustrating a part of the acoustic transducer according to the fourth embodiment of the first aspect;
FIG. 9 is a cross-sectional view illustrating a cut plane along line IX-IX in FIG. 7 in the first aspect;
FIG. 10 is a cross-sectional view illustrating a cut plane along line X-X in FIG. 8 in the first aspect;
FIG. 11 is a partial enlarged perspective view illustrating a part of the acoustic transducer in the first aspect;
FIG. 12 is a plan view illustrating an acoustic transducer according to a fifth embodiment of the first aspect;
FIG. 13 is a perspective view illustrating an acoustic transducer according to the fifth embodiment of the first aspect;
FIG. 14 is a perspective view illustrating, from the bottom, the acoustic transducer according to the fifth embodiment of the first aspect;
FIG. 15 is a cross-sectional view illustrating the acoustic transducer according to the fifth embodiment of the first aspect;
FIG. 16 is a partial enlarged cross-sectional view illustrating a vibration plate (piezoelectric film) in the first aspect;
FIG. 17 is a side view illustrating a distribution of charges generated in a vibration plate configured to deform in response to receiving a sound pressure in the first aspect;
FIG. 18 is a plan view illustrating an acoustic transducer according to a sixth embodiment of the first aspect;
FIG. 19 is a cross-sectional view illustrating the acoustic transducer according to the sixth embodiment of the first aspect, a cross-sectional view of the acoustic transducer taken along line IX-IX in FIG. 18;
FIG. 20 is a circuit diagram of the acoustic transducer according to the sixth embodiment of the first aspect;
FIG. 21 is a graph illustrating a relationship between a sensing area radius ratio and a normalized SNR in the first aspect;
FIG. 22 is a perspective view illustrating an acoustic transducer according to a first embodiment of a second aspect of the present disclosure;
FIG. 23 is a plan view illustrating the acoustic transducer according to the first embodiment of the second aspect;
FIG. 24 is a cross-sectional view illustrating the acoustic transducer according to the first embodiment of the second aspect;
FIG. 25 is a plan view illustrating an acoustic transducer according to a second embodiment of the second aspect;
FIG. 26 is a graph illustrating a relationship between a ratio of a detection region with respect to the overall length of a cantilever, and a signal level in the second aspect;
FIG. 27 is a cross-sectional view illustrating an acoustic transducer according to a third embodiment of the second aspect;
FIG. 28 is a cross-sectional view illustrating an acoustic transducer according to a fourth embodiment of the second aspect;
FIG. 29 is a perspective view illustrating an acoustic transducer according to a fifth embodiment of the second aspect;
FIG. 30 is a circuit diagram of an acoustic transducer according to embodiments of the second aspect;
FIG. 31 is a plan view illustrating an acoustic transducer according to a sixth embodiment of the second aspect;
FIG. 32 is a cross-sectional view illustrating an acoustic transducer according to a seventh embodiment of the second aspect;
FIG. 33 is a plan view illustrating an acoustic transducer according to an eighth embodiment of the second aspect;
FIG. 34 is a perspective view illustrating the acoustic transducer according to the eighth embodiment of the second aspect;
FIG. 35 is a perspective view illustrating, from the bottom, the acoustic transducer according to the eighth embodiment of the second aspect;
FIG. 36 is a cross-sectional view illustrating the acoustic transducer according to the eighth embodiment of the second aspect;
FIG. 37 is a partial enlarged cross-sectional view illustrating a vibration plate (piezoelectric film) in the second aspect;
FIG. 38 is a side view illustrating a distribution of charges generated in a vibration plate configured to deform in response to receiving a sound pressure in the second aspect;
FIG. 39 is a plan view illustrating an acoustic transducer according to a ninth embodiment of the second aspect;
FIG. 40 is a cross-sectional view illustrating the acoustic transducer according to the ninth embodiment of the second aspect, a cross-sectional view of the acoustic transducer taken along line IX-IX in FIG. 39;
FIG. 41 is a circuit diagram of the acoustic transducer according to the sixth embodiment of the second aspect;
FIG. 42 is a graph illustrating a relationship between a sensing area radius ratio and a normalized SNR in the second aspect;
FIG. 43 is a perspective view illustrating an acoustic transducer according to a first embodiment of a third aspect of the present disclosure;
FIG. 44 is a cross-sectional view illustrating the acoustic transducer according to the first embodiment of the third aspect;
FIG. 45 is a cross-sectional view illustrating a cantilever in the third aspect;
FIG. 46 is a cross-sectional view illustrating a cantilever according to a Comparative Example in the third aspect;
FIG. 47 is a graph illustrating a relationship between a thickness ratio of an intermediate electrode and a voltage in the third aspect;
FIG. 48 is a plan view illustrating an acoustic transducer according to a second embodiment of the third aspect;
FIG. 49 is a cross-sectional view illustrating the acoustic transducer according to the second embodiment of the third aspect;
FIG. 50 is a plan view illustrating an acoustic transducer according to a third embodiment of the third aspect;
FIG. 51 is a perspective view illustrating the acoustic transducer according to the third embodiment of the third aspect;
FIG. 52 is a perspective view illustrating, from the bottom, the acoustic transducer according to the third embodiment of the third aspect;
FIG. 53 is a cross-sectional view illustrating the acoustic transducer according to the third embodiment of the third aspect;
FIG. 54 is a partial enlarged cross-sectional view illustrating a vibration plate (piezoelectric film) in the third embodiment of the third aspect;
FIG. 55 is a side view illustrating a distribution of charges generated in a vibration plate configured to deform in response to receiving a sound pressure in the third aspect;
FIG. 56 is a plan view illustrating an acoustic transducer according to a fourth embodiment of the third aspect;
FIG. 57 is a cross-sectional view illustrating the acoustic transducer according to the fourth embodiment of the third aspect, a cross-sectional view of the acoustic transducer taken along line IX-IX in FIG. 56;
FIG. 58 is a circuit diagram of the acoustic transducer according to the fourth embodiment of the third aspect; and
FIG. 59 is a graph illustrating a relationship between a sensing area radius ratio and a normalized SNR in the third aspect.

### DETAILED DESCRIPTION OF THE INVENTION

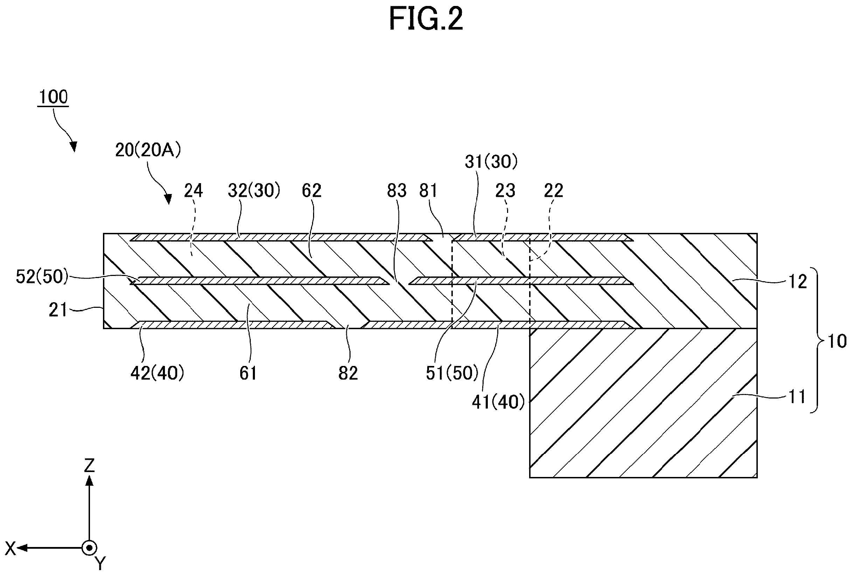

Hereinafter, the acoustic transducers according to the first, second, and third aspects will be described with reference to the attached drawings. In the present specification and drawings, substantially the same components may be denoted by the same reference symbols, and thus duplicate description thereof may be omitted. In the present specification, the term "top" or "upper" and the term "bottom" or "lower" may be used. These are, for example, "top" or "upper" and "bottom" or "lower" in the states illustrated in FIGS. 2, 24, and 44. Specifically, in a Z-axis direction, a side on which an upper electrode 30 is located is referred to as "top" or "upper", and a side on which a lower electrode 40 is located is referred to as "bottom" or "lower". An actual arrangement of the acoustic transducer 100 is not limited to this. In the embodiments of the first and second aspects, the upper electrode 30 may be located at the bottom, and the lower electrode 40 may be located at the top.

### [Acoustic Transducer 100 according to First Embodiment of First Aspect]

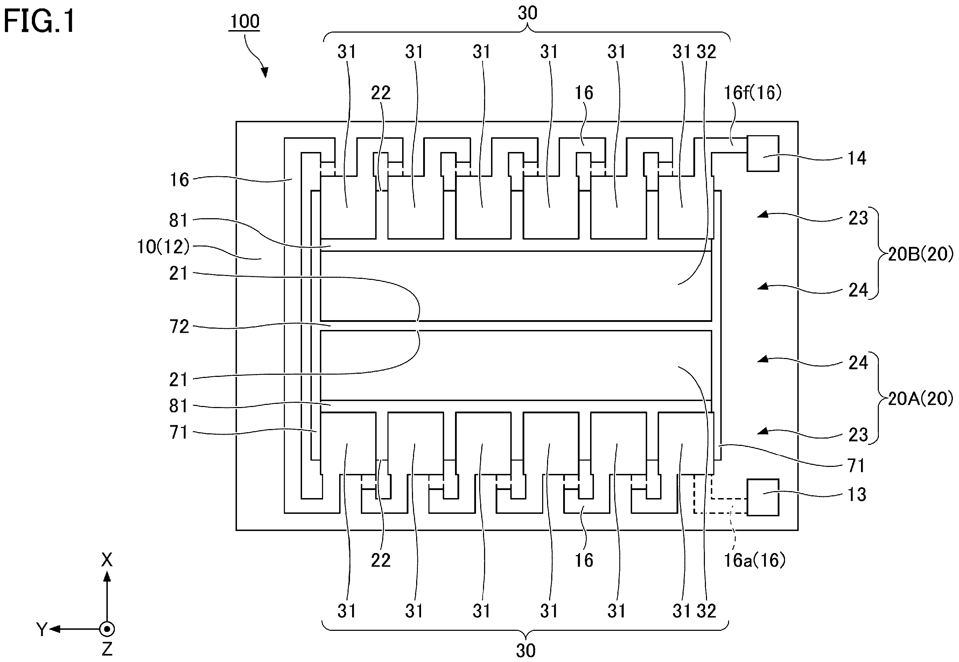

FIG. 1 is a plan view illustrating an acoustic transducer 100 according to the first embodiment of the first aspect. FIG. 2 is a cross-sectional view illustrating the acoustic transducer 100 according to the first embodiment of the first aspect, a cross section of the acoustic transducer 100 along the XZ plane. In the drawings, an X-axis direction, a Y-axis direction, and a Z-axis direction that are orthogonal to each other may be illustrated. The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a second direction crossing the first direction. The Z-axis direction is an example of a thickness direction of a piezoelectric film.

The acoustic transducer 100 illustrated in FIGS. 1 and 2 is a piezoelectric acoustic transducer including a piezoelectric element (piezoelectric film). The acoustic transducer 100 may be, for example, a microphone (MEMS microphone). The acoustic transducer 100 may be used for noise cancellation. The acoustic transducer 100 may be a true wireless stereo (TWS) or may be an in-vehicle device mounted on an automobile. The acoustic transducer 100 may be used, for example, as a hearing aid. As long as the acoustic transducer 100 is configured to detect a physical quantity, no particular limitation is imposed on the use of the acoustic transducer 100. The physical quantity may be, for example, a sound pressure.

### [Fixed Frame 10]

The acoustic transducer 100 includes a fixed frame 10 and a pair of cantilevers 20. The fixed frame 10 is a frame having a rectangular shape as viewed in the Z-axis direction. The length of the fixed frame 10 in the X-axis direction is shorter than the length of the fixed frame 10 in the Y-axis direction. The fixed frame 10 includes a first base 11 and a second base 12. The first base 11 may be a substrate. The second base 12 is formed over the first base 11.

### [Cantilevers 20]

The pair of cantilevers 20 each include a piezoelectric film. The cantilevers 20 each project from the fixed frame 10 inward of the fixed frame 10 in the X-axis direction. One end of each of the cantilevers 20 is a fixed end 22, and the other end is a free end 21.

The pair of cantilevers 20 include cantilevers 20A and 20B disposed to face each other in the X-axis direction. The cantilever 20A is an example of a first cantilever, and the cantilever 20B is an example of a second cantilever. The free ends 21 of the pair of cantilevers 20 face each other.

As illustrated in FIG. 1, a pair of slits 71 and a slit 72 are formed around the cantilevers 20A and 20B. The slits 71 and 72 are gaps formed between the fixed frame 10 and the cantilevers 20, and penetrate through the substrate in the Z-axis direction. The pair of slits 71 extend in the X-axis direction, and are formed apart from each other in the Y-axis direction. The slit 72 is a gap formed between the free end 21 and the fixed frame 10. The fixed end 22 of the cantilever 20 is connected to the fixed frame 10. The widths of the slits 71 and 72 may be, for example, 100 nanometers (nm) or more and 5 micrometers (µm) or less. The widths of the slits 71 and 72 may be, for example, 0.5 µm.

FIG. 2 illustrates a cross section of the cantilever 20 (20A) and the fixed frame 10 along the XZ plane. As illustrated in FIG. 2, the piezoelectric film of the cantilever 20 includes the lower electrode 40, a lower piezoelectric layer 61, an intermediate electrode 50, an upper piezoelectric layer 62, and the upper electrode 30.

### [Lower Electrode 40]

The lower electrode 40 is a thin electrode film, and includes a lower electrode 41 and a lower electrode 42. The lower electrode 41 and the lower electrode 42 are disposed apart from each other in the X-axis direction. Between the lower electrode 41 and the lower electrode 42, there is an electrode-free region 82 in which no electrode is formed. After the lower electrode 40 is formed, the electrode is removed through etching, thereby forming the electrode-free region 82. The electrode-free region 82 may be formed by the lift-off method.

The lower electrode 41 is formed closer to the fixed end 22 in the X-axis direction. The lower electrode 42 is formed closer to the free end 21 in the X-axis direction.

### [Lower Piezoelectric Layer 61]

The lower piezoelectric layer 61 is a piezoelectric thin film, and is formed over the lower electrode 40. The lower piezoelectric layer 61 is formed to be continuous in the X-axis direction.

### [Intermediate Electrode 50]

The intermediate electrode 50 is a thin electrode film, and includes an intermediate electrode 51 and an intermediate electrode 52. The intermediate electrode 51 and the intermediate electrode 52 are disposed apart from each other in the X-axis direction. Between the intermediate electrode 51 and the intermediate electrode 52, there is an electrode-free region 83 in which no electrode is formed. After the intermediate electrode 50 is formed, the electrode is removed through etching, thereby forming the electrode-free region 83. The electrode-free region 83 may be formed by the lift-off method.

The intermediate electrode 51 is formed closer to the fixed end 22 in the X-axis direction. The intermediate electrode 52 is formed closer to the free end 21 in the X-axis direction.

### [Upper Piezoelectric Layer 62]

The upper piezoelectric layer 62 is a piezoelectric thin film, and is formed over the intermediate electrode 50. The upper piezoelectric layer 62 is formed to be continuous in the X-axis direction.

### [Upper Electrode 30]

The upper electrode 30 is a thin electrode film, and includes an upper electrode 31 and an upper electrode 32. The upper electrode 31 and the upper electrode 32 are disposed apart from each other in the X-axis direction. Between the upper electrode 31 and the upper electrode 32, there is an electrode-free region 81 in which no electrode is formed. After the upper electrode 30 is formed, the electrode is removed through etching, thereby forming the electrode-free region 81. The electrode-free region 81 may be formed by the lift-off method.

The upper electrode 31 is formed closer to the fixed end 22 in the X-axis direction. The upper electrode 32 is formed closer to the free end 21 in the X-axis direction.

### [Material and Thickness of Piezoelectric Thin Film]

The materials of the lower piezoelectric layer 61 and the upper piezoelectric layer 62 may be, for example, ScAlN. The material of the lower piezoelectric layer 61 may be AlN. The Sc may be 0 atomic % (at%) or more and 50 atomic % (at%) or less. The thicknesses of the lower piezoelectric layer 61 and the upper piezoelectric layer 62 may be, for example, 100 nm or more and 1 µm or less. The thicknesses of the lower piezoelectric layer 61 and the upper piezoelectric layer 62 may be, for example, 500 nm.

The lower piezoelectric layer 61 and the upper piezoelectric layer 62 may be a fluorite structure (hafnium oxide, zirconium oxide, or cesium oxide) or may be a wurtzite structure (zinc oxide).

### [Material and Thickness of Thin Electrode Film]

The materials of the upper electrode 30, the lower electrode 40, and the intermediate electrode 50 may be Al, Mo, Pt, Ti, or the like. The thicknesses of the upper electrode 30, the lower electrode 40, and the intermediate electrode 50 may be, for example, 5 nm or more and 100 nm or less. The thicknesses of the upper electrode 30, the lower electrode 40, and the intermediate electrode 50 may be, for example, 50 nm.

### [Detection Region 23 and Non-Detection Region 24]

The cantilever 20 includes a plurality of detection regions 23 configured to detect a physical quantity, and a non-detection region 24 configured not to detect the physical quantity. The physical quantity is, for example, a sound pressure. The plurality of detection regions 23 may be a region in which the upper electrode 31, the intermediate electrode 51, and the lower electrode 41 are stacked in the Z-axis direction. The upper electrode 31, the intermediate electrode 51, and the lower electrode 41 are electrically connected. The acoustic transducer 100 can detect piezoelectric output charges between the upper electrode 31 and the intermediate electrode 51. The acoustic transducer 100 can detect piezoelectric output charges between the lower electrode 41 and the intermediate electrode 51.

The detection region 23 is disposed closer to the fixed end 22 than is the non-detection region 24. In other words, the non-detection region 24 is disposed closer to the free end 21 than is the detection region 23.

The upper electrode 32, the intermediate electrode 52, and the lower electrode 42 are not electrically connected.

### [Detection Regions 23]

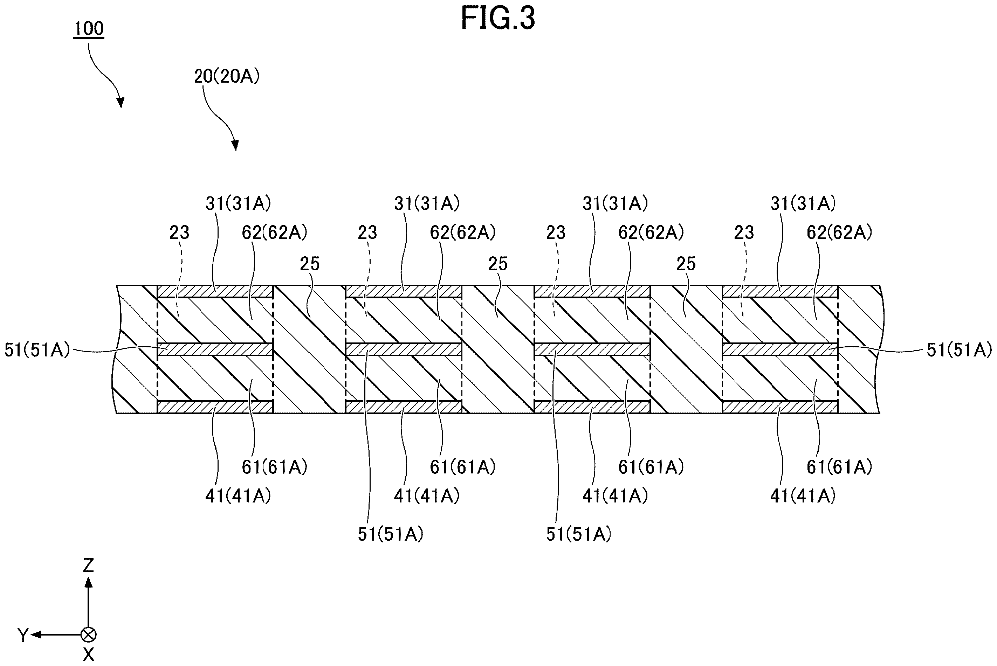

FIG. 3 is a cross-sectional view illustrating the acoustic transducer 100 according to the first embodiment of the first aspect, a cross section of the acoustic transducer 100 along the YZ plane. As illustrated in FIG. 3, the acoustic transducer 100 includes the plurality of detection regions 23 arranged along the Y-axis direction. The plurality of detection regions 23 each include the upper electrode 31 (upper electrode 31A), the lower electrode 41 (lower electrode 41A), the intermediate electrode 51 (intermediate electrode 51A), the lower piezoelectric layer 61 (lower piezoelectric layer 61A), and the upper piezoelectric layer 62 (upper piezoelectric layer 62A).

A non-detection region 25 is formed between each pair of adjacent detection regions of the detection regions 23 in the Y-axis direction. The non-detection region 25 is a region configured not to detect the physical quantity. A piezoelectric layer is formed in the non-detection region 25. The piezoelectric layer of the non-detection region 25 is formed integrally with the lower piezoelectric layer 61 and the upper piezoelectric layer 62. The non-detection region 25 is an example of a first electrode-free region in which the upper electrode 31 and the lower electrode 41 are not formed. Also, the non-detection region 25 is an example of a second electrode-free region in which the intermediate electrode 51 is not formed.

### [Circuit Diagram of Acoustic Transducer 100 according to Embodiment of First Aspect]

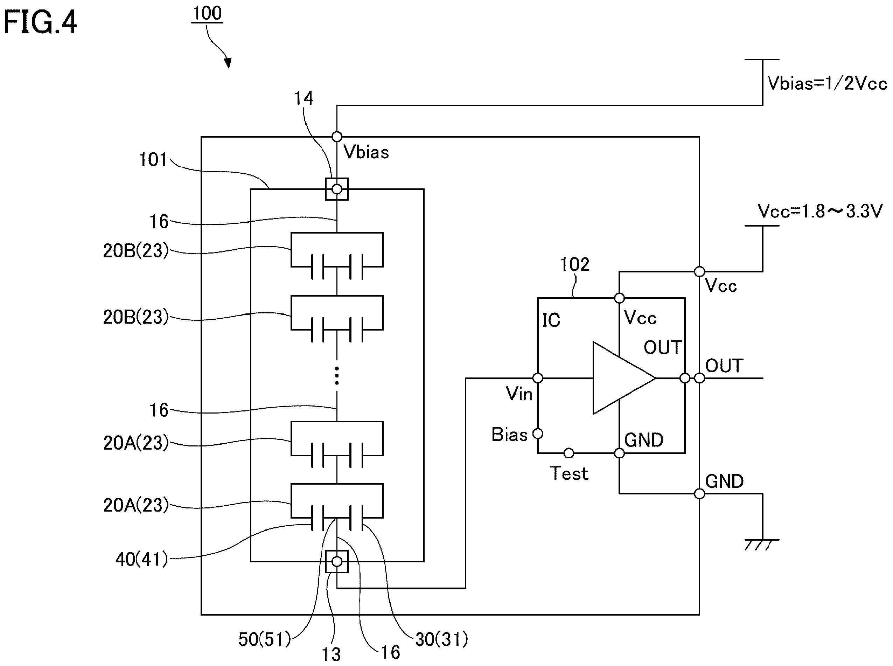

Next, a circuit diagram of the acoustic transducer 100 according to the embodiment of the first aspect will be described. FIG. 4 is a circuit diagram of the acoustic transducer 100 according to the embodiment of the first aspect.

As illustrated in FIG. 4, the acoustic transducer 100 includes an MEMS microphone chip 101. The MEMS microphone chip 101 includes a pair of cantilevers 20A and 20B. The MEMS microphone chip 101 may include three or more cantilevers 20. The cantilevers 20A and 20B include a plurality of detection regions 23. The plurality of detection regions 23 include the upper electrode 31, the lower electrode 41, and the intermediate electrode 51. The acoustic transducer 100 can detect piezoelectric output charges between the upper electrode 31 and the intermediate electrode 51, and piezoelectric output charges between the lower electrode 41 and the intermediate electrode 51. The plurality of cantilevers 20A and 20B are connected in series. In the cantilever 20A, the plurality of detection regions 23 are connected in series. In the cantilever 20B, the plurality of detection regions 23 are connected in series. The plurality of detection regions 23 of the cantilever 20A and the plurality of detection regions 23 of the cantilever 20B are connected in series.

The MEMS microphone chip 101 includes pads 13 and 14. The cantilever 20A is connected to the pad 13, and the cantilever 20B is connected to the pad 14. The acoustic transducer 100 includes an IC 102 connected to the pad 13. The IC 102 is an amplifier configured to amplify an output signal of the cantilever 20. The IC 102 may be provided with a function of performing analog-to-digital (AD) conversion after amplifying the output signal of the cantilever 20.

### [Interconnects 16]

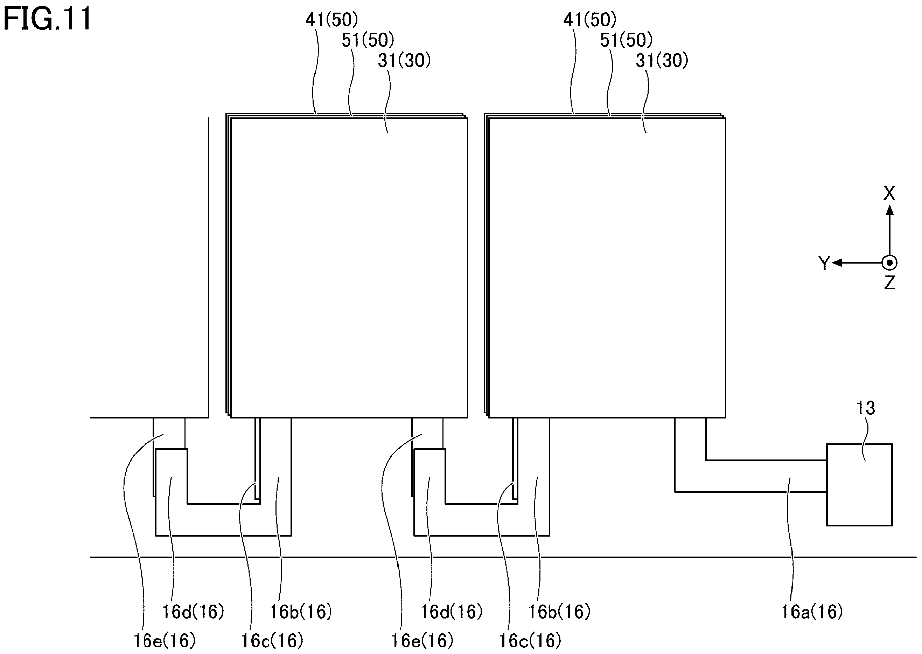

FIG. 11 is a partial enlarged perspective view illustrating a part of the acoustic transducer 100. As illustrated in FIGS. 1, 4, and 11, the acoustic transducer 100 includes interconnects 16 electrically connecting the plurality of detection regions 23 to the pads 13 and 14. The interconnects 16 may be formed, for example, on the upper surface (front surface) of the fixed frame 10. A part of the interconnects 16 may be formed inside the fixed frame 10. The interconnects 16 connect the electrodes of the plurality of detection regions 23 in series.

As illustrated in FIG. 11, the interconnects 16 include an interconnect 16a, an interconnect 16b, an interconnect 16c, an interconnect 16d, and an interconnect 16e. The interconnect 16a electrically connects the intermediate electrode 51 to the pad 13. The interconnect 16a is routed from the intermediate electrode 51 and connected to the pad 13.

The interconnect 16b routed from the upper electrode 31 toward the fixed frame 10 is electrically connected to the interconnect 16c routed from the lower electrode 41 toward the fixed frame 10. The interconnect 16b and the interconnect 16c are connected over the fixed frame 10. The interconnect 16d is connected to the interconnect 16b.

The interconnect 16d routed from the upper electrode 31 is connected, over the fixed frame 10, to the interconnect 16e routed from the intermediate electrode 51 toward the fixed frame 10.

As illustrated in FIG. 1, the interconnects 16 include an interconnect 16f. The interconnect 16f routed from the upper electrode 31 toward the fixed frame 10 is connected to the pad 14 over the fixed frame 10.

### [Shape of Cantilever 20]

As described above, the shape of the cantilever 20 is rectangular as viewed in the Z-axis direction. When the cantilever 20 is rectangular, the area of the cantilever 20 in the chip can be increased, and thus the cantilever 20 can be increased in sensitivity. In other words, the acoustic transducer 100 can be reduced in size compared to an existing acoustic transducer having a size the same as that of the acoustic transducer 100. The acoustic transducer 100 can be reduced in size and thus can be reduced in cost.

### [Overall Length of Cantilever 20]

In the acoustic transducer 100, the resonance frequency of the cantilever 20 can be readily changed by changing the overall length of the cantilever 20. The resonance frequency can be lowered by increasing the overall length of the cantilever 20 at the time of design. The resonance frequency when the overall length of the cantilever 20 is long is lower than the resonance frequency when the overall length of the cantilever 20 is short. The overall length of the cantilever 20 may be the length of a region in which the upper electrode 30, the lower electrode 40, and the intermediate electrode 50 overlap with each other.

### [Width of Cantilever 20]

The width of the cantilever 20 is the width of the cantilever 20 along the Y-axis direction. The width of the cantilever 20 may be the width of a region in which the upper electrode 30, the lower electrode 40, and the intermediate electrode 50 overlap with each other. In the acoustic transducer 100, by changing the width of the cantilever 20, the cantilever 20 can be changed in sensitivity regardless of the resonance frequency. The sensitivity can be increased by increasing the width of the cantilever 20 at the time of design. The sensitivity when the width of the cantilever 20 is large is higher than the sensitivity when the width of the cantilever 20 is small.

### [Operations and Effects of Acoustic Transducer 100 according to First Embodiment of First Aspect]

The acoustic transducer 100 according to the first embodiment of the first aspect includes a fixed frame 10 and a cantilever 20. The cantilever 20 includes a fixed end 22 and a free end 21, and projects from the fixed frame 10 inward of the fixed frame 10. The fixed end 22 is one end of the cantilever 20 fixed to the fixed frame 10, and the free end 21 is the other end of the cantilever 20. The cantilever 20 includes a plurality of detection regions 23 configured to detect a physical quantity, and a non-detection region 24 configured not to detect the physical quantity. Electrodes of the plurality of detection regions 23 are electrically connected in series.

The acoustic transducer 100 according to the embodiment of the first aspect can detect, in response to deformation of the cantilever 20, the physical quantity by detecting the deformation of the cantilever 20. In the acoustic transducer 100, the plurality of detection regions 23 are formed, and the electrodes of the plurality of detection regions 23 are electrically connected in series, thereby enabling increasing the sensitivity of the cantilever 20.

In the acoustic transducer 100, the capacitance of the overall piezoelectric film (the total of the plurality of detection regions 23) can be adjusted as desired by dividing the piezoelectric film of the cantilever 20 at desired planes and electrically connecting the divided films in series.

In the acoustic transducer 100, the electrodes are divided in the widthwise direction (Y-axis direction) of the cantilever 20, thereby forming the plurality of detection regions and enabling increasing the sensitivity.

Also, in the acoustic transducer 100, the electrodes are divided in the lengthwise direction (X-axis direction) of the cantilever 20, thereby forming the detection regions 23 and the non-detection regions 24 and enabling increasing the sensitivity.

The cantilever 20 includes the cantilever (first cantilever) 20A and the cantilever (second cantilever) 20B facing each other in the X-axis direction (first direction), which is a direction in which the cantilever 20 projects. According to the acoustic transducer 100 with this configuration, the sensitivity of the cantilever 20 can be increased.

Also, in the acoustic transducer 100 according to the embodiment of the first aspect, the electrodes of the plurality of detection regions 23 of the cantilever 20A and the electrodes of the plurality of detection regions 23 of the cantilever 20B are electrically connected in series. According to the acoustic transducer 100 with this configuration, the sensitivity of the cantilever 20 can be increased.

Also, in the acoustic transducer 100 according to the embodiment of the first aspect, the plurality of detection regions 23 are disposed closer to the fixed end 22, and the non-detection region 24 is disposed closer to the free end 21. According to the acoustic transducer 100 with this configuration, the sensitivity of the cantilever 20 can be increased. In the cantilever 20, stress is concentrated in the root portion near the first base 11 on the fixed end 22 side, and thus a large amount of charges are generated. On the other hand, little stress is generated on the free end 21 side of the cantilever 20, and thus a small amount of charges are generated. Therefore, the charges generated per unit area can be increased by electrically separating the root portion of the first base 11 on the fixed end 22 side from the tip on the free end 21 side, and using the root portion alone for the detection regions 23. This can increase a signal level, and thus increase sensitivity.

Also, in the acoustic transducer 100, the cantilever 20 includes a piezoelectric film, and the piezoelectric film includes the lower electrode 40, the lower piezoelectric layer 61 formed over the lower electrode 40, the intermediate electrode 50 formed over the lower piezoelectric layer 61, the upper piezoelectric layer 62 formed over the intermediate electrode 50, and the upper electrode 30 formed over the upper piezoelectric layer 62. The non-detection region (first electrode-free region or second electrode-free region) 25 is included between the plurality of detection regions 23.

In the acoustic transducer 100 with this configuration, in response to deformation of the cantilever 20, which is a piezoelectric film, piezoelectric output charges generated between the upper electrode 31 and the intermediate electrode 51 in the plurality of detection regions 23 and piezoelectric output charges generated between the lower electrode 41 and the intermediate electrode 51 in the plurality of detection regions 23 are connected to the intermediate electrode 51. By forming the non-detection region (electrode-free region) 25 in which the upper electrode 30, the lower electrode 40, and the intermediate electrode 50 are not formed, the plurality of divided detection regions 23 can be formed.

Also, in the acoustic transducer 100, the electrode-free region 82, in which the lower electrode 40 is not formed, is formed at a position farther from the fixed end 22 than is the electrode-free region 81, in which the upper electrode 30 is not formed. Thus, it is possible to avoid a reduction in crystallinity of the lower piezoelectric layer 61 between the lower electrode 41 and the intermediate electrode 51 and a reduction in crystallinity of the upper piezoelectric layer 62 between the intermediate electrode 51 and the upper electrode 31. Therefore, charges can be stably generated in the lower piezoelectric layer 61 and the upper piezoelectric layer 62.

Also, the acoustic transducer 100 is a piezoelectric acoustic transducer, and is more resistant to dust and water droplets than existing electrostatic acoustic transducers.

Also, the acoustic transducer 100 has a rectangular shape, and thus the area of the cantilever 20 in a chip can be increased, and the sensitivity can be increased. The acoustic transducer 100 is configured to be increased in sensitivity, and thus the acoustic transducer 100 can be reduced in size. In the acoustic transducer 100, the resonance frequency can be readily changed by changing the length of the detection region 23 of the cantilever 20. In the acoustic transducer 100, by changing a width W20 of the detection region 23, the sensitivity can be changed regardless of the resonance frequency.

### [Acoustic Transducer 100B according to Second Embodiment of First Aspect]

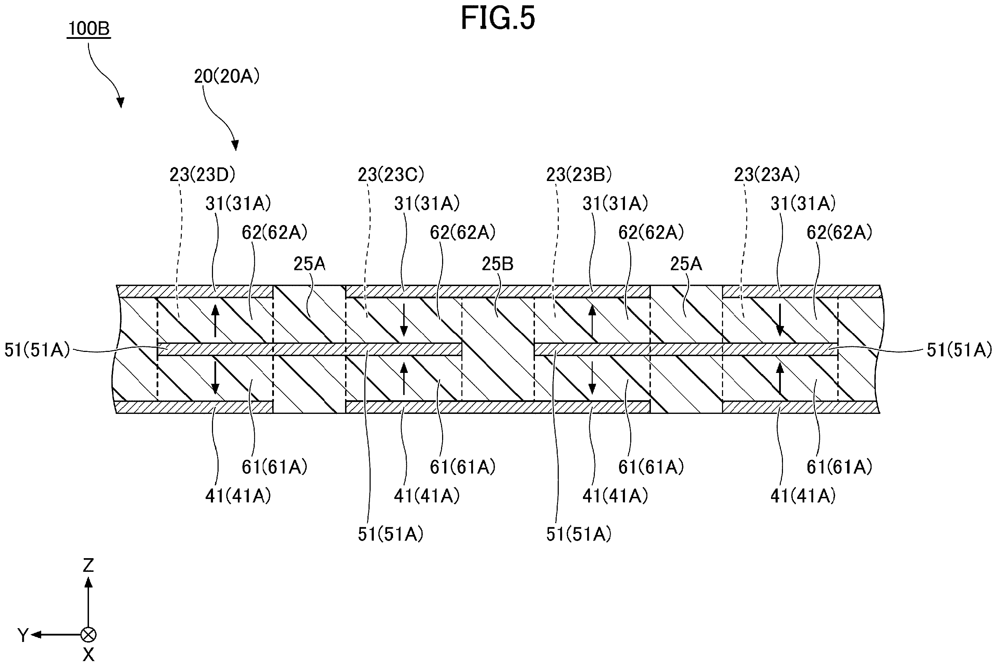

Next, an acoustic transducer 100B according to the second embodiment of the first aspect will be described. FIG. 5 is a cross-sectional view illustrating the acoustic transducer 100B according to the second embodiment of the first aspect, a cross section of the acoustic transducer 100B along the YZ plane. The acoustic transducer 100B according to the second embodiment of the first aspect illustrated in FIG. 5 differs from the acoustic transducer 100 according to the first embodiment of the first aspect illustrated in FIG. 3 in that non-detection regions 25A and 25B are formed instead of the non-detection regions 25, and the arrangement of the upper electrode 31, the lower electrode 41, and the intermediate electrode 51 is different. In the description of the acoustic transducer 100B according to the second embodiment of the first aspect, the same description as that of the acoustic transducer 100 according to the first embodiment of the first aspect may be omitted.

### [Non-Detection Regions 25A and 25B]

The cantilever 20 of the acoustic transducer 100B includes a plurality of detection regions 23A, 23B, 23C, and 23D. The plurality of detection regions 23A, 23B, 23C, and 23D are arranged along the Y-axis direction.

The non-detection region 25A is formed between the detection region 23A and the detection region 23B. The non-detection region 25B is formed between the detection region 23B and the detection region 23C. The non-detection region 25A is formed between the detection region 23C and the detection region 23D.

The intermediate electrode 51 of the detection region 23A and the intermediate electrode 51 of the detection region 23B are electrically connected. The upper electrode 31 of the detection region 23A and the upper electrode 31 of the detection region 23B are not electrically connected. The lower electrode 41 of the detection region 23A and the lower electrode 41 of the detection region 23B are not electrically connected. The intermediate electrode 51 connecting the detection regions 23A and 23B in series is formed in the non-detection region 25A. The non-detection region 25A is an example of the first electrode-free region in which the upper electrode 31 and the lower electrode 41 are not formed.

The upper electrode 31 of the detection region 23B and the upper electrode 31 of the detection region 23C are electrically connected. The lower electrode 41 of the detection region 23B and the lower electrode 41 of the detection region 23C are electrically connected. The intermediate electrode 51 of the detection region 23B and the intermediate electrode 51 of the detection region 23C are not electrically connected. The upper electrode 31 and the lower electrode 41 each connecting the detection regions 23B and 23C in series are formed in the non-detection region 25B. The non-detection region 25B is an example of the second electrode-free region in which the intermediate electrode 51 is not formed.

The intermediate electrode 51 of the detection region 23C and the intermediate electrode 51 of the detection region 23D are electrically connected. The upper electrode 31 of the detection region 23C and the upper electrode 31 of the detection region 23D are not electrically connected. The lower electrode 41 of the detection region 23C and the lower electrode 41 of the detection region 23D are not electrically connected. The intermediate electrode 51 connecting the detection regions 23C and 23D in series is formed in the non-detection region 25A. The non-detection region 25A is an example of the first electrode-free region in which the upper electrode 31 and the lower electrode 41 are not formed.

In the acoustic transducer 100B, the non-detection regions 25A and the non-detection regions 25B are disposed alternately in the Y-axis direction.

### [Polarization Direction of Piezoelectric Film of Cantilever 20]

Next, the polarization direction of the piezoelectric film of the cantilever 20 will be described. In FIG. 5, the polarization directions in the lower piezoelectric layer 61 and the upper piezoelectric layer 62 are shown by arrows. For example, a terminal B (pad 13) is electrically connected to the upper electrode 31 and the lower electrode 41 of the detection region 23A, and a terminal A (pad 14) is electrically connected to the upper electrode 31 and the lower electrode 41 of the detection region 23D. Other electrodes and interconnects may be electrically connected between the upper and lower electrodes 31 and 41 and the terminals A and B. For example, the terminal B is GND. For example, when a value is denoted by "x", the potentials of the electrodes between the terminals A and B (the upper electrode 31, the lower electrode 41, and the intermediate electrode 51) are in the following relationship, and thus a connection in series is realized.

The potentials of the upper electrode 31 and the lower electrode 41 of the detection region 23D may be +4x V. The potential of the intermediate electrode 51 of the detection region 23D and the detection region 23C may be +3x V. The potentials of the upper electrode 31 and the lower electrode 41 of the detection region 23C and the detection region 23B may be +2x V. The potential of the intermediate electrode 51 of the detection region 23B and the detection region 23A may be +x V. The potential of the upper electrode 31 and the lower electrode 41 of the detection region 23A may be 0 V.

The polarization direction in the detection region 23A is a direction from the upper electrode 31 and the lower electrode 41 toward the intermediate electrode 51. The polarization direction in the detection region 23B is a direction from the intermediate electrode 51 toward the upper electrode 31 and the lower electrode 41. The polarization direction in the detection region 23C is a direction from the upper electrode 31 and the lower electrode 41 toward the intermediate electrode 51. The polarization direction in the detection region 23D is a direction from the intermediate electrode 51 toward the upper electrode 31 and the lower electrode 41.

By applying a DC (direct current) voltage between the terminals A and B in advance, the polarization directions of the piezoelectric film as described above can be realized.

### [Operations and Effects of Acoustic Transducer 100B according to Second Embodiment of First Aspect]

The acoustic transducer 100B according to the second embodiment of the first aspect exhibits operations and effects similar to those exhibited by the acoustic transducer 100 according to the first embodiment of the first aspect. In the acoustic transducer 100B according to the second embodiment of the first aspect, the non-detection regions 25A and the non-detection regions 25B may be alternately disposed.

In the acoustic transducer 100B with this configuration, the plurality of detection regions (divided regions) 23 can be electrically connected in series without the need to form the interconnects 16 independently. What is meant by "without the need to form the interconnects 16 independently" is that there is no need to form interconnects outward of the piezoelectric film as the interconnects connecting the plurality of detection regions 23. In the acoustic transducer 100, by differing the polarization directions between adjacent regions of the plurality of detection regions 23 of the piezoelectric film, connection in series can be realized.

In the acoustic transducer 100B, there is no need to provide the external interconnects 16 connecting the plurality of detection regions 23, thereby achieving saving of a space, enabling a reduction in complexity of a film-forming process, and enabling a suppression in an unintentional leakage current and an unintentional increase in the capacitance value of the overall device due to a parasitic capacitance. In the acoustic transducer 100B, the interconnects 16 to be formed over the upper surface of the fixed frame 10 can be reduced, and the acoustic transducer 100B can be disposed in a smaller space and reduced in size. For example, when the area of the acoustic transducer 100B is the same as that of an acoustic transducer of the related art, an attempt to increase the sensitivity may be made by increasing the area of the piezoelectric film of the cantilever 20.

### [Acoustic Transducer 100C according to Third Embodiment of First Aspect]

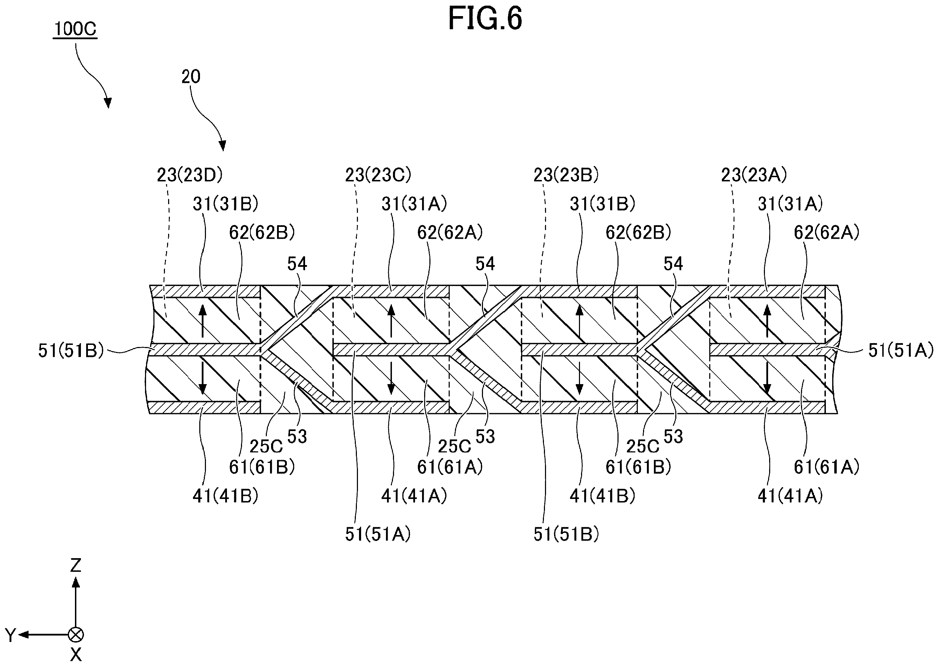

Next, an acoustic transducer 100C according to the third embodiment of the first aspect will be described. FIG. 6 is a cross-sectional view illustrating the acoustic transducer 100C according to the third embodiment of the first aspect, a cross section of the acoustic transducer 100C along the YZ plane. The acoustic transducer 100C illustrated in FIG. 6 differs from the acoustic transducer 100 according to the first embodiment of the first aspect illustrated in FIG. 3 in that non-detection regions 25C are formed instead of the non-detection regions 25, and lower connecting electrodes 53 and upper connecting electrodes 54 are formed. In the description of the acoustic transducer 100C according to the third embodiment of the first aspect, the same description as that of the acoustic transducers 100 and 100B according to the embodiments of the first aspect may be omitted.

### [Non-Detection Regions 25A and 25B]

The cantilever 20 of the acoustic transducer 100C includes a plurality of detection regions 23A, 23B, 23C, and 23D. The plurality of detection regions 23A, 23B, 23C, and 23D are arranged along the Y-axis direction.

The non-detection region 25C is formed between the detection region 23A and the detection region 23B. Similarly, the non-detection region 25C is formed between the detection region 23B and the detection region 23C. The non-detection region 25C is formed between the detection region 23C and the detection region 23D. The detection regions 23A and 23C are examples of the first detection region, and the detection regions 23B and 23D are examples of the second detection region.

The lower connecting electrode 53 and the upper connecting electrode 54 are formed in the non-detection region 25C between the detection region 23A and the detection region 23B. The lower connecting electrode 53 electrically connects the lower electrode 41 (first lower electrode 41A) of the detection region 23A to the intermediate electrode 51 (second intermediate electrode 51B) of the detection region 23B. The upper connecting electrode 54 electrically connects the upper electrode 31 (first upper electrode 31A) of the detection region 23A to the intermediate electrode 51 of the detection region 23B. The lower connecting electrode 53 and the upper connecting electrode 54 are formed to be branched from the intermediate electrode 51 of the detection region 23B. The intermediate electrode 51 (first intermediate electrode 51A) of the detection region 23A is not connected to the upper electrode 31 (second upper electrode 31B), the lower electrode 41 (second lower electrode 41B), and the intermediate electrode 51 (second intermediate electrode 51B) of the detection region 23B.

The lower connecting electrode 53 and the upper connecting electrode 54 are formed in the non-detection region 25C between the detection region 23B and the detection region 23C. The lower connecting electrode 53 electrically connects the lower electrode 41 of the detection region 23B to the intermediate electrode 51 of the detection region 23C. The upper connecting electrode 54 electrically connects the upper electrode 31 of the detection region 23B to the intermediate electrode 51 of the detection region 23C. The lower connecting electrode 53 and the upper connecting electrode 54 are formed to be branched from the intermediate electrode 51 of the detection region 23C. The intermediate electrode 51 of the detection region 23B is not connected to the upper electrode 31, the lower electrode 41, and the intermediate electrode 51 of the detection region 23C.

The lower connecting electrode 53 and the upper connecting electrode 54 are formed in the non-detection region 25C between the detection region 23C and the detection region 23D. The lower connecting electrode 53 electrically connects the lower electrode 41 of the detection region 23C to the intermediate electrode 51 of the detection region 23D. The upper connecting electrode 54 electrically connects the upper electrode 31 of the detection region 23C to the intermediate electrode 51 of the detection region 23D. The lower connecting electrode 53 and the upper connecting electrode 54 are formed to be branched from the intermediate electrode 51 of the detection region 23D. The intermediate electrode 51 of the detection region 23C is not connected to the upper electrode 31, the lower electrode 41, and the intermediate electrode 51 of the detection region 23D.

### [Polarization Direction of Piezoelectric Film of Cantilever 20]

Next, the polarization direction of the piezoelectric film of the cantilever 20 will be described. In FIG. 6, the polarization directions in the lower piezoelectric layer 61 and the upper piezoelectric layer 62 are shown by arrows. The polarization directions in the detection regions 23A, 23B, 23C, and 23D are from the intermediate electrode 51 toward the upper electrode 31 and the lower electrode 41. The detection region 23A includes the lower piezoelectric layer 61A and the upper piezoelectric layer 62B. The detection region 23B includes a lower piezoelectric layer 61B and an upper piezoelectric layer 62B. The lower piezoelectric layer 61A is an example of the first lower piezoelectric layer, and the upper piezoelectric layer 62A is an example of the first upper piezoelectric layer. The lower piezoelectric layer 61B is an example of the second lower piezoelectric layer, and the upper piezoelectric layer 62B is an example of the second upper piezoelectric layer.

### [Operations and Effects of Acoustic Transducer 100C according to Third Embodiment of First Aspect]

The acoustic transducer 100C according to the third embodiment of the first aspect exhibits operations and effects similar to those exhibited by the acoustic transducers 100 and 100B according to the above embodiments. The acoustic transducer 100C according to the third embodiment of the first aspect may include the lower connecting electrode 53 and the upper connecting electrode 54 that are branched from the intermediate electrode 51. The intermediate electrode 51 and the lower electrode 41 in each pair of adjacent detection regions of the detection regions 23A to 23D may be connected via the lower connecting electrode 53, and the intermediate electrode 51 and the upper electrode 31 in each pair of adjacent detection regions of the detection regions 23A to 23D may be connected via the upper connecting electrode 54.

### [Acoustic Transducer 100D according to Fourth Embodiment of First Aspect]

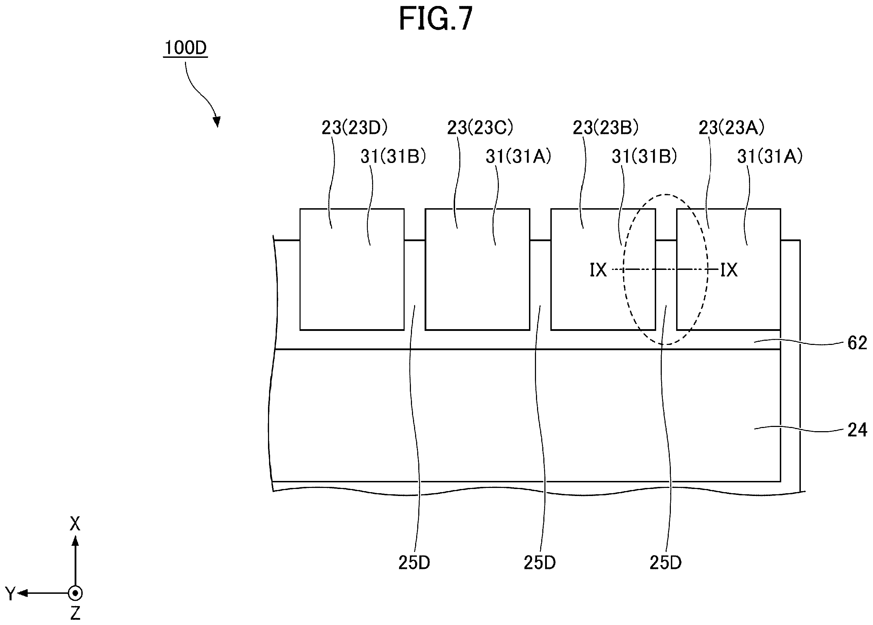

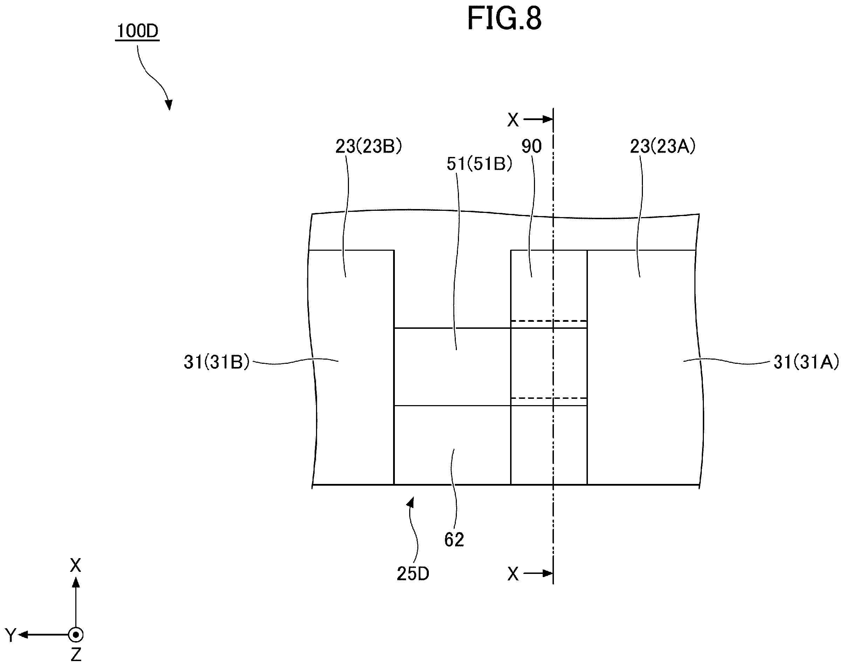

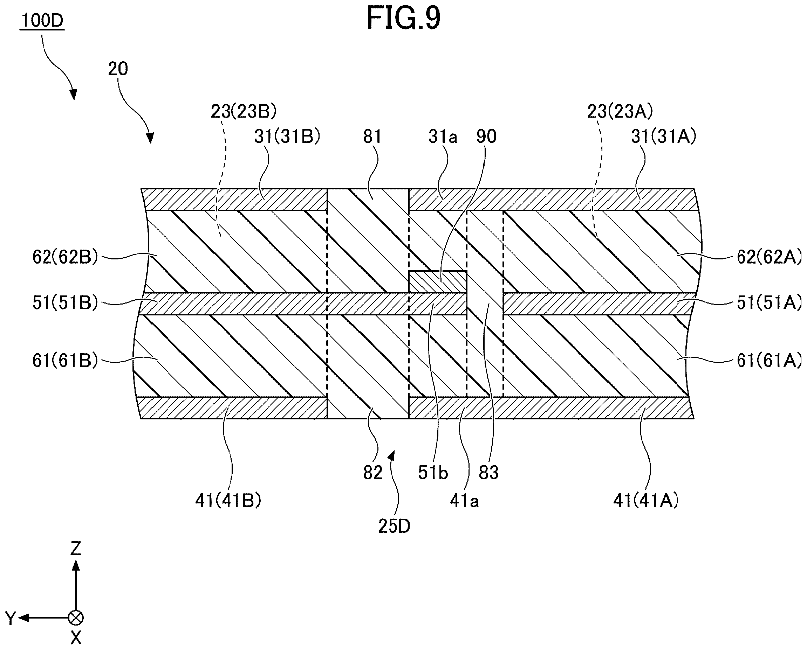

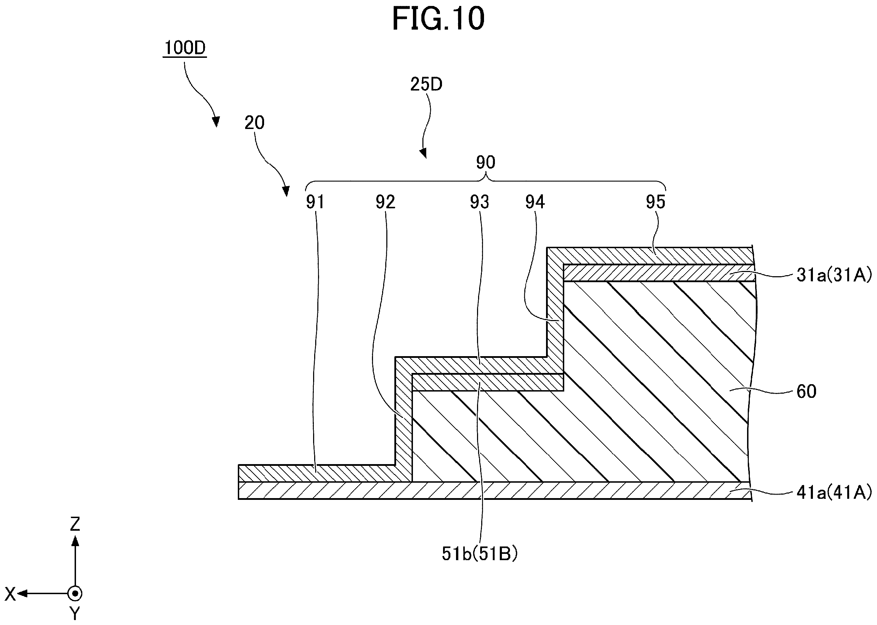

Next, an acoustic transducer 100D according to the fourth embodiment of the first aspect will be described. FIG. 7 is a partial plan view illustrating a part of the acoustic transducer 100D according to the fourth embodiment of the first aspect. FIG. 8 is a partial enlarged plan view illustrating a part of the acoustic transducer 100D according to the fourth embodiment of the first aspect. FIG. 9 is a cross-sectional view illustrating a cut plane along line IX-IX in FIG. 7 in the first aspect. FIG. 10 is a cross-sectional view illustrating a cut plane along line X-X in FIG. 8 in the first aspect.

The acoustic transducer 100D illustrated in FIGS. 7 to 10 differs from the acoustic transducer 100 according to the first embodiment of the first aspect illustrated in FIG. 3 in that non-detection regions 25D are formed instead of the non-detection regions 25, and an interconnect 90 is provided. In the description of the acoustic transducer 100D according to the fourth embodiment of the first aspect, the same description as that of the acoustic transducers 100, 100B, and 100C according to the embodiments of the first aspect may be omitted.

### [Non-Detection Regions 25A and 25B]

As illustrated in FIGS. 7 and 8, the cantilever 20 of the acoustic transducer 100D includes the plurality of detection regions 23A, 23B, 23C, and 23D. The plurality of detection regions 23A, 23B, 23C, and 23D are arranged along the Y-axis direction. The non-detection region 25D is formed between each pair of adjacent detection regions of the plurality of detection regions 23A to 23D.

As illustrated in FIG. 9, a projecting part 31a of the upper electrode 31, a projecting part 41a of the lower electrode 41, and a projecting part 51b of the intermediate electrode 51 are formed in the non-detection region 25D between the detection region 23A and the detection region 23B.

The projecting part 31a projects, in the Y-axis direction, from the upper electrode 31 of the detection region 23A toward the upper electrode 31B of the detection region 23B. The projecting part 41a projects, in the Y-axis direction, from the lower electrode 41A of the detection region 23A toward the lower electrode 41B of the detection region 23B. The projecting part 51b projects, in the Y-axis direction, from the intermediate electrode 51B of the detection region 23B toward the intermediate electrode 51A of the detection region 23A.

### [Interconnect 90]

The acoustic transducer 100D includes the interconnect 90 formed in the non-detection region 25D. In the non-detection region 25D, the interconnect 90 electrically connects the projecting part 41a of the lower electrode 41A, the projecting part 51b of the intermediate electrode 51B, and the projecting part 31a of the upper electrode 31A. The interconnect 90 includes a first joining part 91, a first rising part 92, a second joining part 93, a second rising part 94, and a third joining part 95.

The first joining part 91 is formed over the projecting part 41a of the lower electrode 41A, and is joined to the lower electrode 41A. The first rising part 92 is connected to the first joining part 91, and extends in the thickness direction of the piezoelectric film. The second joining part 93 is connected to the first rising part 92, formed over the projecting part 51b of the intermediate electrode 51B, and joined to the intermediate electrode 51B. The second rising part 94 is connected to the second joining part 93, and extends in the thickness direction of the piezoelectric film. The third joining part 95 is connected to the second rising part 94, formed over the projecting part 31a of the upper electrode 31A, and joined to the upper electrode 31A.

### [Operations and Effects of Acoustic Transducer 100D according to Fourth Embodiment of First Aspect]

The acoustic transducer 100D according to the fourth embodiment of the first aspect exhibits operations and effects similar to those exhibited by the acoustic transducers 100 and 100B according to the above embodiments. The acoustic transducer 100D according to the fourth embodiment of the first aspect may include the interconnect 90 electrically connecting the lower electrode 41A, the intermediate electrode 51B, and the upper electrode 31A.

### [Acoustic Transducer 200 according to Fifth Embodiment of First Aspect]

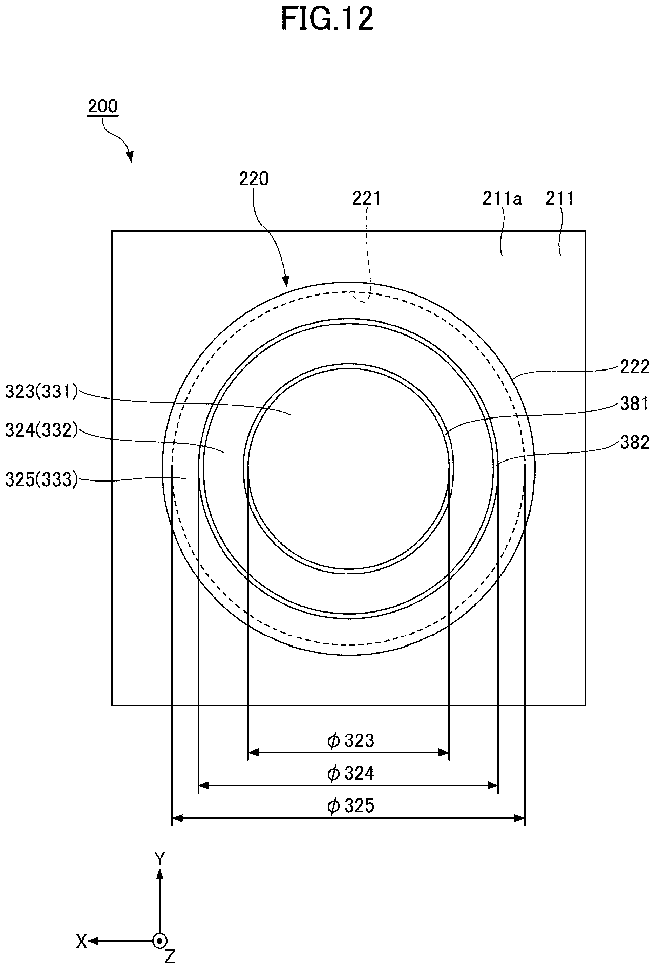

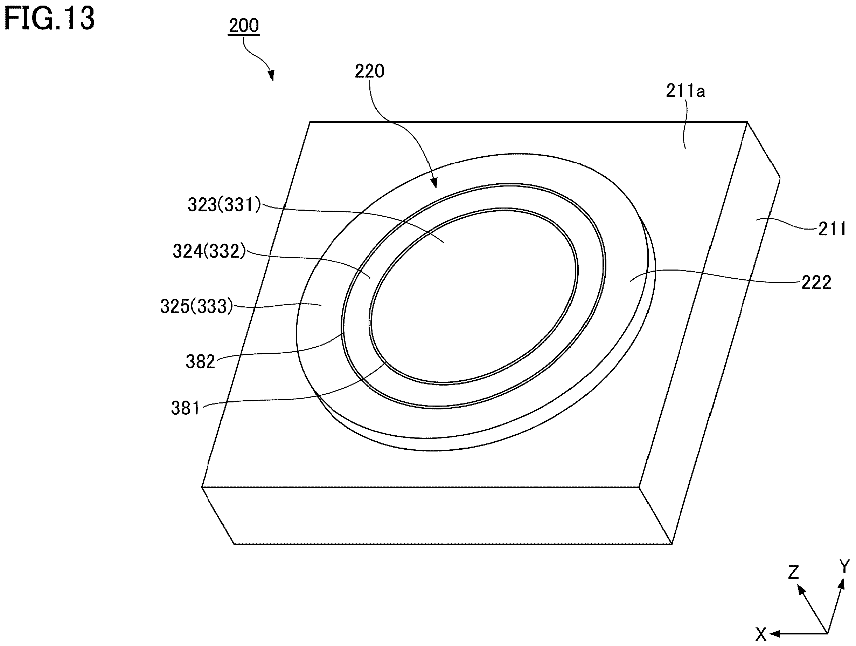

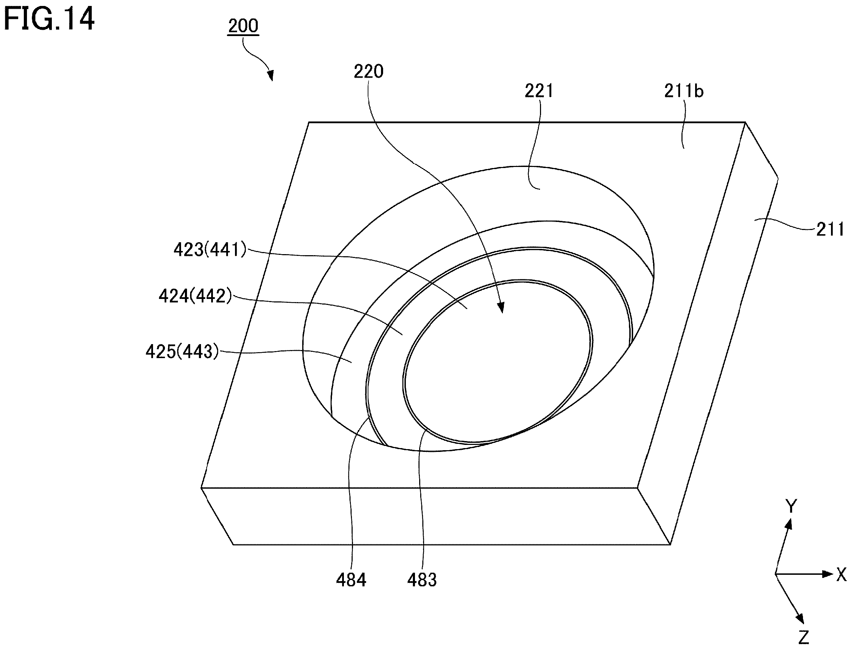

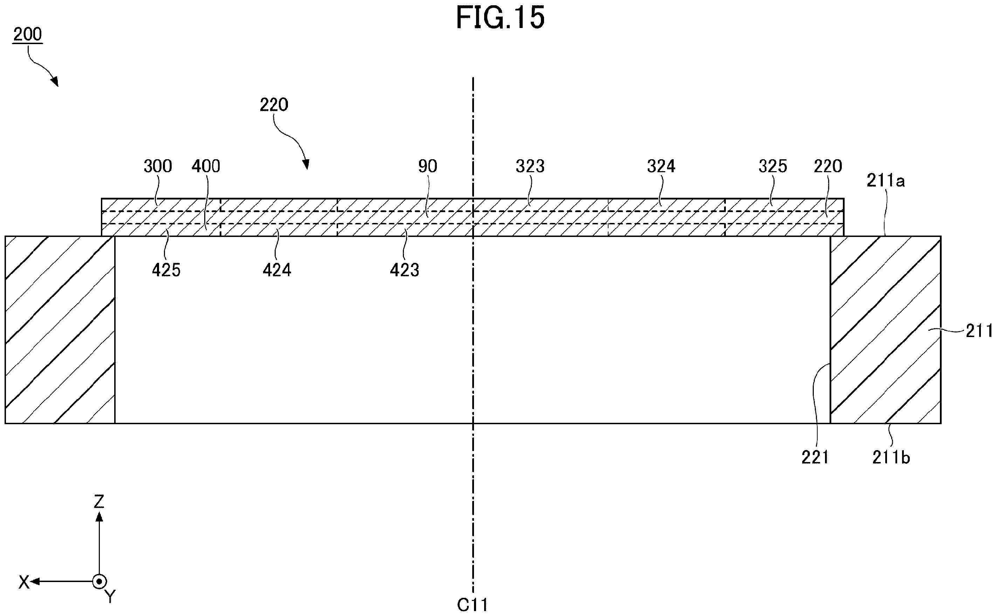

Next, an acoustic transducer 200 according to the fifth embodiment of the first aspect will be described. FIG. 12 is a plan view illustrating the acoustic transducer 200 according to the fifth embodiment of the first aspect. FIG. 13 is a perspective view illustrating the acoustic transducer 200 according to the fifth embodiment of the first aspect. FIG. 14 is a perspective view illustrating, from the bottom, the acoustic transducer 200 according to the fifth embodiment of the first aspect. FIG. 15 is a cross-sectional view illustrating the acoustic transducer 200 according to the fifth embodiment of the first aspect. In the drawings, an X-axis direction, a Y-axis direction, and a Z-axis direction that are orthogonal to each other may be illustrated. The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a direction crossing the first direction. In the description of the acoustic transducer 200 according to the fifth embodiment of the first aspect, the same description as that of the acoustic transducer 100 according to the embodiment of the first aspect may be omitted.

### [Support Substrate 211]

The acoustic transducer 200 includes a support substrate (fixed frame) 211 and a vibration plate (piezoelectric element) 220. The support substrate 211 may be rectangular as viewed in the Z-axis direction. The plate thickness direction of the support substrate 211 is along the Z-axis direction. The support substrate 211 includes an upper surface 211a and a lower surface 211b facing each other in the Z-axis direction. An opening 221 is formed in the support substrate 211. The opening 221 is formed to penetrate through the support substrate 211 in the Z-axis direction. The support substrate 211 is formed, for example, of a silicon wafer. The opening 221 is formed to have a circular shape as viewed in the Z-axis direction.

### [Vibration Plate 220]

The vibration plate 220 includes a piezoelectric film. The vibration plate 220 is formed to cover an opening 221. The vibration plate 220 is formed to have a circular shape as viewed in the Z-axis direction. An outer circumference 222 of the vibration plate 220 is a fixed end of the vibration plate 220, and is fixed to an upper surface 211a of the support substrate 211. The vibration plate 220 includes a first detection region 323, a non-detection region 324, and a second detection region 325, as described below. The vibration plate 220 is also referred to as a "diaphragm". The shape of the opening 221 is not limited to a circular shape, but may be an elliptical shape or any other shape.

### [Piezoelectric Film]

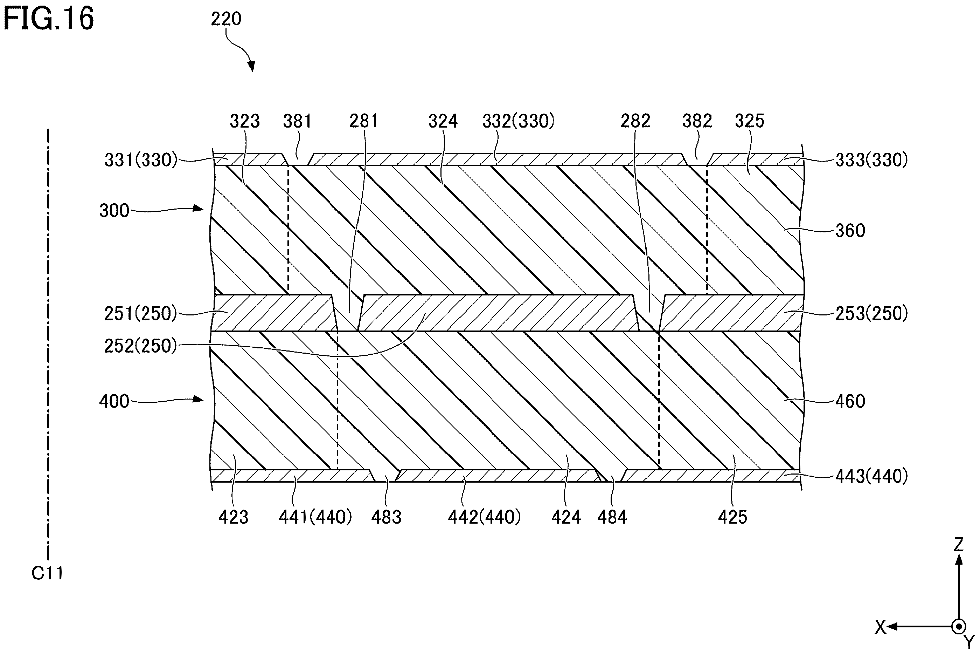

The piezoelectric film, which is the vibration plate 220, deforms in response to a sound pressure, thereby generating charges. FIG. 16 is an enlarged cross-sectional view illustrating the piezoelectric film. The piezoelectric film includes a lower electrode layer 440, a lower piezoelectric layer (first piezoelectric layer) 460, an intermediate electrode layer 250, an upper piezoelectric layer (second piezoelectric layer) 360, and an upper electrode layer 330. The lower electrode layer 440, the lower piezoelectric layer 460, the intermediate electrode layer 250, the upper piezoelectric layer 360, and the upper electrode layer 330 are stacked in this order.

### [Lower Electrode Layer 440]

The lower electrode layer 440 includes lower electrodes 441 to 443, which are thin electrode films. The lower electrode layer 440 is disposed closer to the opening 221 in the Z-axis direction. The lower electrodes 441 to 443 are disposed apart from each other in the X-axis direction. The lower electrode 441 is formed to have a circular shape. The lower electrode 441 is disposed closer to a center C11 of the vibration plate 220 as viewed in the Z-axis direction. The lower electrode 442 is formed to have a ring shape as viewed in the Z-axis direction. The lower electrode 442 is disposed outward of the lower electrode 441 in the radial direction. The lower electrode 443 is formed to have a ring shape as viewed in the Z-axis direction. The lower electrode 443 is disposed outward of the lower electrode 442 in the radial direction.

### [Electrode-Free Regions 483 and 484]

In the radial direction of the vibration plate 220, there is an electrode-free region 483, in which no electrode is formed, between the lower electrode 441 and the lower electrode 442. In the radial direction of the vibration plate 220, there is an electrode-free region 484, in which no electrode is formed, between the lower electrode 442 and the lower electrode 443.

### [Lower Piezoelectric Layer 460]

The lower piezoelectric layer 460 is a piezoelectric thin film, and is formed over the lower electrode layer 440. The lower piezoelectric layer 460 is formed to be continuous in the radial direction of the vibration plate 220.

### [Intermediate Electrode Layer 250]

The intermediate electrode layer 250 includes intermediate electrodes 251 to 253, which are thin electrode films. The intermediate electrode layer 250 is formed over the lower piezoelectric layer 460. The intermediate electrodes 251 to 253 are disposed apart from each other in the X-axis direction. The intermediate electrode 251 is formed to have a circular shape. The intermediate electrode 251 is disposed closer to the center C11 of the vibration plate 220 as viewed in the Z-axis direction. The intermediate electrode 252 is formed to have a ring shape as viewed in the Z-axis direction. The intermediate electrode 252 is disposed outward of the intermediate electrode 251 in the radial direction. The intermediate electrode 253 is formed to have a ring shape as viewed in the Z-axis direction. The intermediate electrode 253 is disposed outward of the intermediate electrode 252 in the radial direction.

### [Electrode-Free Regions 281 and 282]

In the radial direction of the vibration plate 220, there is an electrode-free region 281, in which no electrode is formed, between the intermediate electrode 251 and the intermediate electrode 252. In the radial direction of the vibration plate 220, there is an electrode-free region 282, in which no electrode is formed, between the intermediate electrode 252 and the intermediate electrode 253.

### [Upper Piezoelectric Layer 360]

The upper piezoelectric layer 360 is a piezoelectric thin film, and is formed over the intermediate electrode layer 250. The upper piezoelectric layer 360 is formed to be continuous in the radial direction of the vibration plate 220.

### [Upper Electrode Layer 330]

The upper electrode layer 330 includes upper electrodes 331 to 333, which are thin electrode films. The upper electrode layer 330 is formed over the upper piezoelectric layer 360. The upper electrodes 331 to 333 are disposed apart from each other in the X-axis direction. The upper electrode 331 is formed to have a circular shape. The upper electrode 331 is disposed closer to the center C11 of the vibration plate 220 as viewed in the Z-axis direction. The upper electrode 332 is formed to have a ring shape as viewed in the Z-axis direction. The upper electrode 332 is disposed outward of the upper electrode 331 in the radial direction. The upper electrode 333 is formed to have a ring shape as viewed in the Z-axis direction. The upper electrode 333 is disposed outward of the upper electrode 332 in the radial direction.

### [Material and Thickness of Piezoelectric Thin Film]

A piezoelectric material used for the lower piezoelectric layer 460 and the upper piezoelectric layer 360 may be, for example, aluminum nitride (AlN) or scandium aluminum nitride (ScAlN (Sc: 1 at % to 60 at%)), or may be a piezoelectric material having a fluorite structure (hafnium oxide, zirconium oxide, or cesium oxide) or a piezoelectric material having a wurtzite structure (zinc oxide or gallium nitride).

The thickness of the lower piezoelectric layer 460 may be, for example, 100 nm or more and 1 µm or less. The material of the lower piezoelectric layer 460 is, for example, ScAlN (Sc: 40 at%), and the thickness of the lower piezoelectric layer 460 may be, for example, 500 nm.

The thickness of the upper piezoelectric layer 360 may be, for example, 100 nm or more and 1 µm or less. The material of the upper piezoelectric layer 360 is, for example, ScAlN (Sc: 40 at%), and the thickness of the upper piezoelectric layer 360 may be, for example, 500 nm.

[Material and Thickness of Thin Electrode Film] The thicknesses of the thin electrode films of the upper electrode layer 330, the intermediate electrode layer 250, and the lower electrode layer 440 may be, for example, 5 nm or more and 100 nm or less. The thicknesses of the thin electrode films may be, for example, 20 nm. The thin electrode films of the upper electrode layer 330, the intermediate electrode layer 250, and the lower electrode layer 440 may be formed to have different thicknesses.

The materials of the thin electrode films of the upper electrode layer 330, the intermediate electrode layer 250, and the lower electrode layer 440 may be, for example, at least one of gold, platinum, tungsten, aluminum, copper, molybdenum, ruthenium, titanium, chromium, or nickel, or an alloy containing one of these. The thin electrode films of the upper electrode layer 330, the intermediate electrode layer 250, and the lower electrode layer 440 may be formed of the same material or different materials.

### [First Detection Regions, Non-Detection Regions, and Second Detection Regions]

As illustrated in FIGS. 15 and 16, the vibration plate 220, which is a diaphragm, includes the first detection regions 323 and 423, the non-detection regions 324 and 424, and the second detection regions 325 and 425. The first detection regions 323 and 423 and the second detection regions 325 and 425 are regions configured to detect a physical quantity. The non-detection regions 324 and 424 are regions configured not to detect the physical quantity. The physical quantity is, for example, a sound pressure.

The first detection region 323 is a region in which the intermediate electrode 251, the upper piezoelectric layer 360, and the upper electrode 331 are stacked in the Z-axis direction. The first detection region 423 is a region in which the lower electrode 441, the lower piezoelectric layer 460, and the intermediate electrode 251 are stacked in the Z-axis direction. The acoustic transducer 200 can detect piezoelectric output charges between the lower electrode 441 and the intermediate electrode 251. The acoustic transducer 200 can detect piezoelectric output charges between the intermediate electrode 251 and the upper electrode 331.

The non-detection region 324 includes a region in which the intermediate electrode 252, the upper piezoelectric layer 360, and the upper electrode 332 are stacked in the Z-axis direction. The non-detection region 424 includes a region in which the lower electrode 442, the lower piezoelectric layer 460, and the intermediate electrode 252 are stacked in the Z-axis direction. The acoustic transducer 200 cannot detect piezoelectric output charges between the lower electrode 442 and the intermediate electrode 252. The acoustic transducer 200 cannot detect piezoelectric output charges between the intermediate electrode 252 and the upper electrode 332.

The second detection region 325 is a region in which the intermediate electrode 253, the upper piezoelectric layer 360, and the upper electrode 333 are stacked in the Z-axis direction. The second detection region 425 is a region in which the lower electrode 443, the lower piezoelectric layer 460, and the intermediate electrode 253 are stacked in the Z-axis direction. The acoustic transducer 200 can detect piezoelectric output charges between the lower electrode 443 and the intermediate electrode 253. The acoustic transducer 200 can detect piezoelectric output charges between the intermediate electrode 253 and the upper electrode 333.

The first detection regions 323 and 423 are formed closer to the center of the vibration plate 220. The non-detection regions 324 and 424 are formed outward of the first detection regions 323 and 423 in the radial direction of the vibration plate 220. The second detection regions 325 and 425 are formed outward of the non-detection regions 324 and 424 in the radial direction of the vibration plate 220.

[Outer Diameters of First Detection Region 323, Non-Detection Region 324, and Second Detection Region 325]
As illustrated in FIG. 12, an outer diameter Φ323 of the first detection region 323 is, for example, 0.59 millimeters (mm). An outer diameter Φ324 of the non-detection region 324 is, for example, 0.81 mm. An outer diameter Φ325 of the second detection region 325 is 1 mm.

### [Divided Positions]

As illustrated in FIG. 16, the electrode-free regions 483 and 484 are formed in the lower electrode layer 440. The electrode-free regions 281 and 282 are formed in the intermediate electrode layer 250. The electrode-free regions 381 and 382 are formed in the upper electrode layer 330.

The electrode-free regions 281, 282, 381, 382, 483, and 484 may be referred to as "divided positions". These electrode-free regions 281, 282, 381, 382, 483, and 484 are disposed at different positions in the radial direction of the vibration plate 220.

The electrode-free region 381 is disposed inward of the electrode-free region 281 in the radial direction of the vibration plate 220. The electrode-free region 281 is disposed inward of the electrode-free region 483 in the radial direction of the vibration plate 220.

The electrode-free region 382 is disposed outward of the electrode-free region 282 in the radial direction of the vibration plate 220. The electrode-free region 282 is disposed outward of the electrode-free region 484 in the radial direction of the vibration plate 220.

In the vibration plate 220, the electrode-free regions 281, 282, 381, 382, 483, and 484 are formed at positions not overlapping with each other as viewed in the Z-axis direction. This can suppress a reduction in strength of the vibration plate 220. A piezoelectric thin film is formed in the electrode-free regions 281, 282, 483, and 484.

The crystallinity of the piezoelectric thin film above the boundary between the end of the lower electrode 441 and the electrode-free region 483 is lower than that of the piezoelectric thin film above the lower electrode 441. Similarly, the crystallinity of the piezoelectric thin film above the boundary between the electrode and the electrode-free region is lower than that of the piezoelectric thin film above the electrode.

The divided position of the electrode-free region 483 is disposed outward of the first detection region 423 in the radial direction of the vibration plate 220. The divided position of the electrode-free region 484 is disposed inward of the second detection region 425 in the radial direction of the vibration plate 220. This does not inhibit crystal growth of the piezoelectric thin film configured to generate charges. In the acoustic transducer 200, the crystallinities of the piezoelectric thin films in the first detection region 423 and the second detection region 425, which generate charges, are high.

The divided position of the electrode-free region 281 is disposed outward of the first detection region 323 in the radial direction of the vibration plate 220. The divided position of the electrode-free region 282 is disposed inward of the second detection region 325 in the radial direction of the vibration plate 220. This does not inhibit crystal growth of the piezoelectric thin film configured to generate charges. In the acoustic transducer 200, the crystallinities of the piezoelectric thin films in the first detection region 323 and the second detection region 325, which generate charges, are high.

### [Connection in Piezoelectric Film]

In the vibration plate 220, which is the piezoelectric film (piezoelectric element), the electrodes of the first detection regions 323 and 423 are electrically connected in parallel. The electrodes of the first detection region 323 include the upper electrode 331 and the intermediate electrode 251. The electrodes of the first detection region 423 include the lower electrode 441 and the intermediate electrode 251. The electrodes of the second detection regions 325 and 425 are electrically connected in parallel. The electrodes of the second detection region 325 include the upper electrode 333 and the intermediate electrode 253. The electrodes of the second detection region 425 include the lower electrode 443 and the intermediate electrode 253.

The electrodes of the first detection region and the second detection region are electrically connected in series. Specifically, the upper electrode 331 and the upper electrode 333 are connected in series, and the lower electrode 441 and the lower electrode 443 are connected in series. Alternatively, the intermediate electrode 251 and the intermediate electrode 253 are connected in series.

### [Operations and Effects of Acoustic Transducer 200 according to Fifth Embodiment of First Aspect]

The acoustic transducer 200 according to the fifth embodiment of the first aspect includes the support substrate (fixed frame) 211 and the vibration plate 220, which is a piezoelectric element fixed to the support substrate 211. The vibration plate 220 includes the first detection regions 323 and 423 and the second detection regions 325 and 425. The first detection regions 323 and 423 are a plurality of detection regions configured to detect a physical quantity, and the second detection regions 325 and 425 are configured not to detect the physical quantity. The electrodes of the plurality of detection regions are electrically connected in series.

In the acoustic transducer 200 according to the embodiments of the first aspect, in response to deformation of the vibration plate 220, the physical quantity can be detected by detecting this deformation of the vibration plate 220. In the acoustic transducer 200, the first detection regions 323 and 423 and the second detection regions 325 and 425 are formed, and the electrodes of the plurality of detection regions are electrically connected in series, and thus the sensitivity of the vibration plate 220 can be increased.

In the acoustic transducer 200, the piezoelectric element is the vibration plate (diaphragm) 220, and the outer circumference (outer circumference of the diaphragm) 222 of the vibration plate 220 is a fixed end that is fixed to the support substrate 211.

In the acoustic transducer 200, the plurality of detection regions include the first detection regions 323 and 423, and the second detection regions 325 and 425. The first detection regions 323 and 423 are inner detection regions disposed closer to the center C11 of the vibration plate 220 in the radial direction of the vibration plate 220. The second detection regions 325 and 425 are outer detection regions disposed farther from the center C11 of the vibration plate 220 in the radial direction of the vibration plate 220. The non-detection regions 324 and 424 are formed between the inner detection regions and the outer detection regions in the circumferential direction of the vibration plate 220.

In the acoustic transducer 200 according to the embodiments of the first aspect, charges are generated in response to deformation of the vibration plate 220, and the charges generated in the first detection regions 323 and 423 and the second detection regions 325 and 425 are detected. In the acoustic transducer 200, the first detection regions 323 and 423, the non-detection regions 324 and 424, and the second detection regions 325 and 425 are formed by dividing the respective electrodes in the radial direction of the vibration plate 220. In this acoustic transducer 200, the sensitivity for detecting charges in response to a sound pressure can be increased.

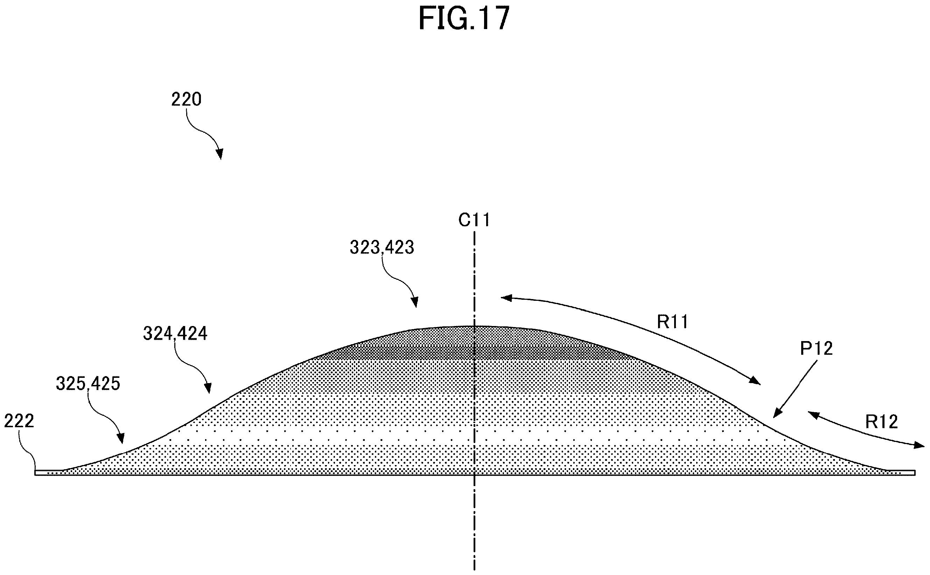

FIG. 17 is a side view illustrating a distribution of charges generated in the vibration plate 220 configured to deform in response to receiving a sound pressure. In the vibration plate 220, which is a diaphragm, the outer circumference 222 in the radial direction is fixed to the support substrate 211. As illustrated in FIG. 17, a region near an inflection point P12 does not readily deform, and the amount of charges generated is small. The inflection point P12 and a region near the inflection point P12, which generate a small amount of charges, are included in the non-detection regions 324 and 424.

On the other hand, a region near the center C11 of the vibration plate 220 and a region near the outer circumference 222 of the vibration plate 220 deform greatly, and thus the amount of charges generated in these regions is large. The center C11 of the vibration plate 220 and a region near the center C11 are included in the first detection regions 323 and 423. The region near the outer circumference 222 of the vibration plate 220 is included in the second detection regions 325 and 425. In the acoustic transducer 200, a region including the inflection point P12, at which the amount of charges generated is small, is not included in the first detection regions 323 and 423 and the second detection regions 325 and 425. This can increase the S/N ratio in the acoustic transducer 200, and increase the detection sensitivity of charges.

### [Shapes of Ends of Electrodes]

Next, the shapes of the ends of the electrode will be described. As illustrated in FIG. 16, the ends of the upper electrodes 331 to 333, the ends of the lower electrodes 441 to 443, and the ends of the intermediate electrodes 251 to 253 may be formed to have tapered shapes. The ends of the electrodes are ends facing each other in the radial direction of the vibration plate 220. The ends of the electrodes having the tapered shapes are formed such that the lower side projects beyond the upper side.

In this manner, when the ends of the lower electrodes 441 to 443 have tapered shapes, it is possible to soften the angle of steps at the boundaries between the lower electrodes 441 to 443 and the electrode-free regions 483 and 484. Therefore, a reduction in crystallinity in the piezoelectric layer 460 can be suppressed. The same applies to the boundaries between the other electrodes and the other electrode-free regions.

### [Acoustic Transducer 200B according to Sixth Embodiment of First Aspect]

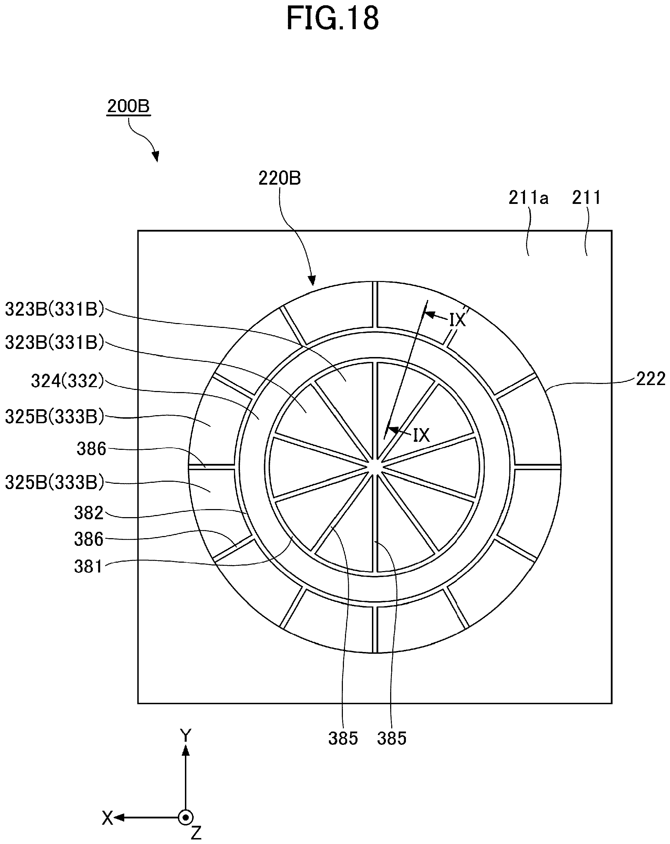

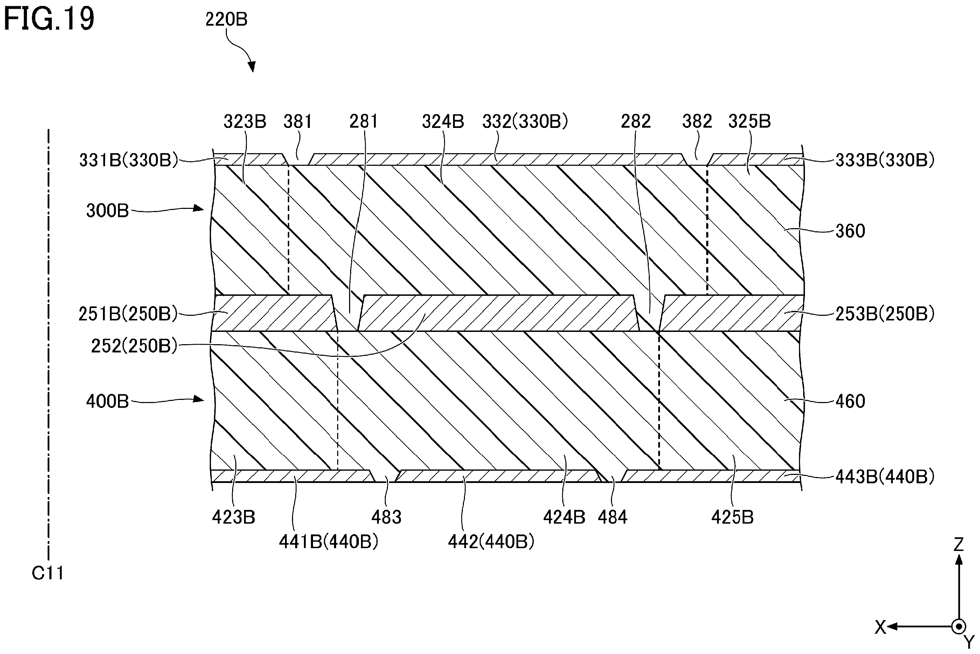

Next, an acoustic transducer 200B according to the sixth embodiment of the first aspect will be described. FIG. 18 is a plan view illustrating the acoustic transducer 200B according to the sixth embodiment of the first aspect. FIG. 19 is a cross-sectional view illustrating the acoustic transducer 200B according to the sixth embodiment of the first aspect, a cross-sectional view of the acoustic transducer 200B taken along line IX-IX in FIG. 18. The acoustic transducer 200B according to the sixth embodiment of the first aspect illustrated in FIGS. 18 and 19 differs from the acoustic transducer 200 according to the fifth embodiment illustrated in FIG. 12 in that the acoustic transducer 200B includes a plurality of upper electrodes 331B and 333B divided in the circumferential direction, a plurality of lower electrodes 441B and 443B divided in the circumferential direction, a plurality of intermediate electrodes 251B and 253B divided in the circumferential direction, and electrode-free regions 385 and 386 extending in the radial direction. In the description of the acoustic transducer 200B according to the sixth embodiment of the first aspect, the same description as that of the acoustic transducer 200 according to the fifth embodiment of the first aspect may be omitted.

### [Stack 300B]

As illustrated in FIG. 19, the acoustic transducer 200B includes stacks 300B and 400B. The stack 300B includes an upper electrode layer 330B, a piezoelectric layer 360, and an intermediate electrode layer 250B. The upper electrode layer 330B includes a plurality of upper electrodes 331B divided in the circumferential direction, the upper electrode 332 continuous in the circumferential direction, and a plurality of upper electrodes 333B divided in the circumferential direction. The intermediate electrode layer 250B includes a plurality of intermediate electrodes 251B divided in the circumferential direction, the intermediate electrode 252 continuous in the circumferential direction, and a plurality of intermediate electrodes 253B divided in the circumferential direction.

### [First Detection Region 323B]

The stack 300B includes a first detection region 323B, a non-detection region 324B, and a second detection region 325B. The first detection region 323B includes a plurality of upper electrodes 331B, the piezoelectric layer 360, and a plurality of intermediate electrodes 251B. The first detection region 323B includes a plurality of piezoelectric elements. In the first detection region 323B, the piezoelectric element includes the upper electrode 331B, the piezoelectric layer 360, and the intermediate electrode 251B.

### [Second Detection Region 325B]

The second detection region 325B includes a plurality of upper electrodes 333B, the piezoelectric layer 360, and a plurality of intermediate electrodes 253B. The second detection region 325B includes a plurality of piezoelectric elements. In the second detection region 325B, the piezoelectric element includes the upper electrode 333B, the piezoelectric layer 360, and the intermediate electrode 253B.

As illustrated in FIG. 18, the electrode-free regions 381 and 382 and the electrode-free regions 385 and 386 are formed in the upper electrode layer 330B.

### [Electrode-Free Region 385]

The electrode-free regions 385 divide the upper electrode into a plurality of upper electrodes in the first detection region 323B. The electrode-free regions 385 extend in the radial direction from the center of a vibration plate 220B. The plurality of electrode-free regions 385 are disposed at equal intervals in the circumferential direction. The areas of the plurality of upper electrodes 331B are substantially equal. The acoustic transducer 200B includes, for example, ten upper electrodes 331B.

### [Electrode-Free Region 386]

The electrode-free regions 386 divide the upper electrode into a plurality of upper electrodes in the second detection region 325B. The electrode-free regions 386 extend in the radial direction from the electrode-free region 382 toward the outer circumference 222 of the vibration plate 220. The plurality of electrode-free regions 386 are disposed at equal intervals in the circumferential direction.

### [Stack 400B]

As illustrated in FIG. 19, the stack 400B includes the intermediate electrode layer 250B, the piezoelectric layer 460, and the lower electrode layer 440B. The intermediate electrode layer 250B is included in both the stack 300B and the stack 400B. The lower electrode layer 440B includes the plurality of lower electrodes 441B divided in the circumferential direction, the lower electrode 442 continuous in the circumferential direction, and the plurality of lower electrodes 443B divided in the circumferential direction.

### [First Detection Region 423B]

The stack 400B includes a first detection region 423B, a non-detection region 424B, and a second detection region 425B. The first detection region 423B includes the plurality of intermediate electrodes 251B, the piezoelectric layer 460, and the plurality of lower electrodes 441B. The first detection region 423B includes a plurality of piezoelectric elements. In the first detection region 423B, the piezoelectric element includes the intermediate electrode 251B, the piezoelectric layer 460, and the lower electrode 441B.

In the first detection region 423B, the areas of the plurality of lower electrodes 441B are substantially equal.

### [Second Detection Region 425B]

The second detection region 425B includes the plurality of intermediate electrodes 253B, the piezoelectric layer 460, and the plurality of lower electrodes 443B. The second detection region 425B includes a plurality of piezoelectric elements. In the second detection region 425B, the piezoelectric element includes the intermediate electrode 253B, the piezoelectric layer 460, and the lower electrode 443B. In the second detection region 425B, the areas of the plurality of lower electrodes 443B are substantially equal.

Similar to the upper electrode layer 330B of the stack 300B, the lower electrode layer 440B and the intermediate electrode layer 250B of the stack 400B include electrode-free regions extending in the radial direction.

### [Capacitances of Piezoelectric Elements]

In the stack 300B, the capacitances of the plurality of piezoelectric elements arranged along the circumferential direction of the vibration plate 220B are equal to each other. In the stack 400B, the capacitances of the plurality of piezoelectric elements arranged along the circumferential direction of the vibration plate 220B are substantially equal.

### [Connection in Series of Piezoelectric Elements]

In the vibration plate 220B, the plurality of piezoelectric elements arranged along the circumferential direction and the radial direction are electrically connected in series.

### [Operations and Effects of Acoustic Transducer 200B according to Sixth Embodiment of First Aspect]

The acoustic transducer 200B according to the sixth embodiment of the first aspect exhibits operations and effects similar to those exhibited by the acoustic transducer 200 according to the fifth embodiment of the first aspect.

In the acoustic transducer 200B, the plurality of detection regions include first detection regions 323B and 423B and second detection regions 325B and 425B. The first detection regions 323B and 423B are inner detection regions disposed closer to the center C11 of the vibration plate 220B in the radial direction of the vibration plate 220B. The second detection regions 325B and 425B are outer detection regions disposed farther from the center C11 of the vibration plate 220B in the radial direction of the vibration plate 220B. The non-detection regions 324 and 424 include: the electrode-free regions 381 and 382 formed between the inner detection regions and the outer detection regions in the circumferential direction of the vibration plate 220B; and the plurality of electrode-free regions 385 and 386 extending in the radial direction of the diaphragm and formed at intervals in the circumferential direction of the diaphragm.

According to the above acoustic transducer 200B, the electrode-free regions 385 and 386 extending in the radial direction can divide the electrode in the detection regions into a plurality of electrodes.

### [Modified Example of Acoustic Transducer 200B according to Sixth Embodiment of First Aspect]

In the acoustic transducer 200B, the vibration plate (piezoelectric element) 220B includes a piezoelectric film, and the piezoelectric film includes the lower electrode layer 440B, the lower piezoelectric layer 460 formed over the lower electrode layer 440B, the intermediate electrode layer 250B formed over the lower piezoelectric layer 460, the upper piezoelectric layer 360 formed over the intermediate electrode layer 250B, and the upper electrode layer 330B formed over the upper piezoelectric layer 360. Between the plurality of detection regions (the first detection regions 323B and 423B and the second detection regions 325B and 425B), there is an electrode-free region (first electrode-free region) in which the upper electrode and the lower electrode are not formed, or there is an electrode-free region (second electrode-free region) in which the intermediate electrode is not formed.

In the acoustic transducer 200B, when the electrode-free regions (first electrode-free regions) are formed in the upper electrode and the lower electrode, the electrode-free regions (second electrode-free regions) do not necessarily need to be formed in the intermediate electrode. In the acoustic transducer 200B, when the electrode-free regions (second electrode-free regions) are formed in the intermediate electrode, the electrode-free regions (first electrode-free regions) 381, 382, 483, and 484 do not necessarily need to be formed in the upper electrode and the lower electrode.

In the detection region, the upper electrode, the intermediate electrode, and the lower electrode may be divided in the circumferential direction. In the circumferential direction, the divided positions (electrode-free regions) in the upper electrodes may differ from the divided positions in the intermediate electrodes. Similarly, in the circumferential direction, the divided positions in the lower electrodes may differ from the divided positions in the intermediate electrodes.

### [Circuit Diagram of Acoustic Transducer 200B according to Sixth Embodiment of First Aspect]

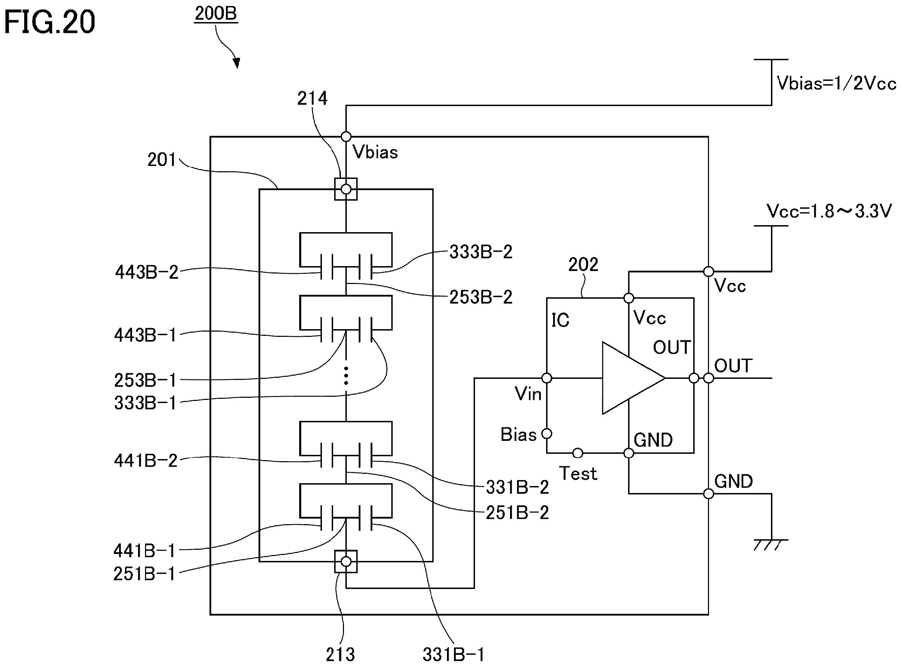

Next, a circuit diagram of the acoustic transducer 200B according to the sixth embodiment of the first aspect will be described. FIG. 20 is a circuit diagram of the acoustic transducer 200B according to the sixth embodiment of the first aspect.

As illustrated in FIG. 20, the acoustic transducer 200B includes an MEMS microphone chip 201. The MEMS microphone chip 201 includes a vibration plate 220B. The vibration plate 220B includes the plurality of first detection regions 323B and 423B and the plurality of second detection regions 325B and 425B.

The plurality of first detection regions 323B and 423B include the upper electrodes 331B, the intermediate electrodes 251B, and the lower electrodes 441B. The plurality of second detection regions 325B and 425B include the upper electrodes 333B, the intermediate electrodes 253B, and the lower electrodes 443B. The upper electrodes 331B include upper electrodes 331B-1, 331B-2, ..., 331B-n, divided into the number of n, in the circumferential direction. n is a natural number. The same applies to the other upper electrodes, intermediate electrodes, and lower electrodes.

In the first detection regions 323B and 423B of the acoustic transducer 200B, it is possible to detect piezoelectric output charges between the upper electrode 331B and the intermediate electrode 251B and piezoelectric output charges between the intermediate electrode 251B and the lower electrode 441B. The plurality of piezoelectric elements arranged along the circumferential direction are connected in series.

In the second detection regions 325B and 425B of the acoustic transducer 200B, it is possible to detect piezoelectric output charges between the upper electrode 333B and the intermediate electrode 253B and piezoelectric output charges between the intermediate electrode 253B and the lower electrode 443B. The plurality of piezoelectric elements arranged along the circumferential direction are connected in series.

The MEMS microphone chip 201 includes pads 213 and 214. Electrodes of the plurality of piezoelectric elements are connected to the pads 213 and 214. The acoustic transducer 200B includes an IC 202 connected to the pad 213. The IC 202 is an amplifier configured to amplify an output signal of the piezoelectric element of the vibration plate 220B. The IC 202 may be provided with a function of performing analog-to-digital (AD) conversion after amplifying the output signal of the piezoelectric element of the vibration plate 220B.

The polarity of charges generated in the second detection regions 325B and 425B is opposite to the polarity of charges generated in the first detection regions 323B and 423B. Therefore, connection in series is achieved by reversing the interconnects between the second detection regions 325B and 425B and the first detection regions 323B and 423B.

### [Connection of Electrodes]

In the acoustic transducer 200B, the upper electrodes 331B and the intermediate electrodes 251B of the plurality of first detection regions 323B may be electrically connected in series. Similarly, the upper electrodes 333B and the intermediate electrodes 253B of the plurality of second detection regions 325B may be electrically connected in series.

In the acoustic transducer 200B, the lower electrodes 441B and the intermediate electrodes 251B of the plurality of first detection regions 423B may be electrically connected in series. Similarly, the lower electrodes 433B and the intermediate electrodes 253B of the plurality of second detection regions 425B may be electrically connected in series.

In the acoustic transducer 200B, the upper electrode and the lower electrode in each of the plurality of detection regions may be electrically connected in parallel.

### [Relationship between Sensing Area Radius Ratio and Normalized SNR]

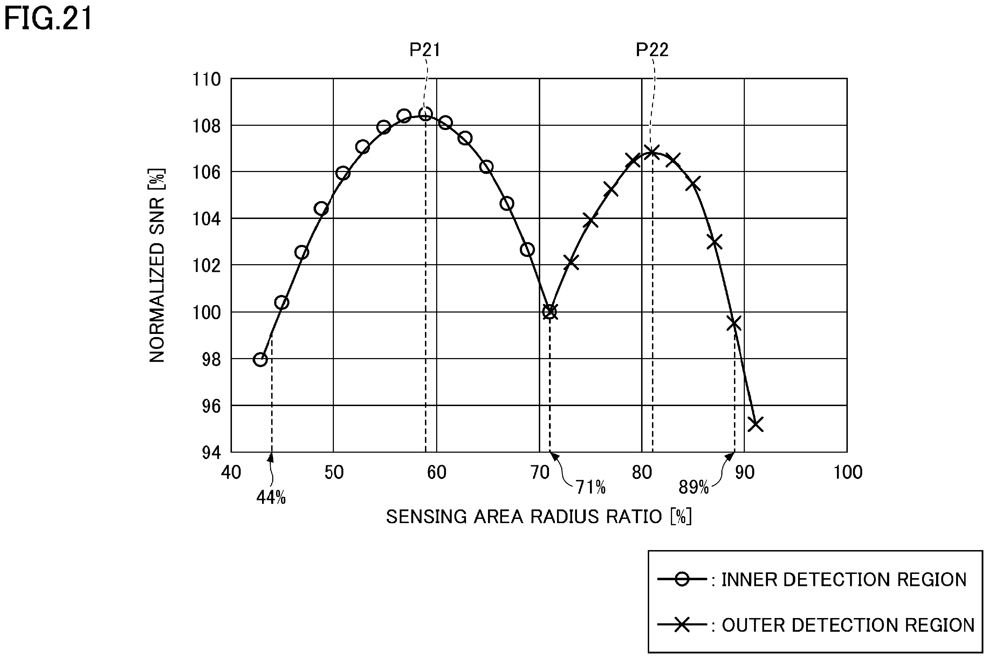

Next, a relationship between the sensing area radius ratio and the normalized SNR will be described. FIG. 21 is a graph illustrating the relationship between the sensing area radius ratio and the normalized SNR in the first aspect. In FIG. 21, the horizontal axis indicates the sensing area radius ratio [%] and the vertical axis indicates the normalized SNR [%]. The graph illustrated in FIG. 21 is a graph illustrating the relationship between the sensing area radius ratio and the normalized SNR in the acoustic transducer 200 according to the fifth embodiment of the first aspect illustrated in FIG. 12.

The "sensing area radius ratio" can be expressed according to the following formula (1). Sensing area radius ratio = (Electrode-divided part radius/Diaphragm radius) × 100 The "electrode-divided part radius" may be the radius of the inner detection region 323. The "diaphragm radius" may be the radius of the vibration plate 220. In FIG. 12, the diameter Φ323 of the inner detection region 323 and the diameter Φ325 of the vibration plate 220 are illustrated.

The inner diameter of the opening 221 covered by the vibration plate 220 is defined as the sensing area radius ratio of 100%. When the electrode-free region formed is 71%, the normalized SNR is defined as 100%. In FIG. 21, "O" indicates the position of the boundary between the inner detection region 323 and the non-detection region 324. In FIG. 21, "X" indicates the position of the boundary between the outer detection region 325 and the non-detection region 324.

The normalized SNR value of the inner detection region 323 is the value obtained when the boundary between the outer detection region 325 and the non-detection region 324 is 71%, and the outer diameter Φ323 of the inner detection region 323 is changed.

The normalized SNR value of the outer detection region 325 is the value obtained when the boundary between the inner detection region 323 and the non-detection region 324 is 71%, and the inner diameter Φ324 of the outer detection region 325 is changed.

In the example illustrated in FIG. 21, the normalized SNR value of the inner detection region 323 becomes the maximum at a point P21. The sensing area radius ratio at the point P21 is 59%.

In the example illustrated in FIG. 21, the normalized SNR value of the outer detection region 325 becomes the maximum at a point P22. The sensing area radius ratio at the point P22 is 81%.

When the sensing area radius ratio of the inner detection region 323 is 44% or more and 71% or less, the normalized SNR value is 100% or more. When the sensing area radius ratio of the inner detection region 323 is 49% or more and 67% or less, the normalized SNR value is 104% or more. When the sensing area radius ratio of the inner detection region 323 is 51% or more and 65% or less, the normalized SNR value is 106% or more.

The sensing area radius ratio of the inner detection region 323 is preferably 44% or more and 71% or less, more preferably 49% or more and 67% or less, and further preferably 51% or more and 65% or less.

When the sensing area radius ratio of the outer detection region 325 is 71% or more and 89% or less, the normalized SNR value is 100% or more. When the sensing area radius ratio of the outer detection region 325 is 75% or more and 87% or less, the normalized SNR value is 104% or more. When the sensing area radius ratio of the outer detection region 325 is 78% or more and 84% or less, the normalized SNR value is 106% or more.

The sensing area radius ratio of the outer detection region 325 is preferably 71% or more and 89% or less, more preferably 75% or more and 87% or less, and further preferably 78% or more and 84% or less.

When the sensing area radius ratio of the inner detection region 323 is 71% and the sensing area radius ratio of the outer detection region 325 is 71%, the divided position of the electrode may be at a position of 71%.

In the acoustic transducer 200, when the sensing area radius ratio of the outer detection region 325 is 71% or more and 89% or less, the sensing area radius ratio of the inner detection region 323 may be a value outside the range of 44% or more and 71% or less. In such a case, the normalized SNR value may be high.

In the acoustic transducer 200, when the sensing area radius ratio of the inner detection region 323 is 44% or more and 71% or less, the sensing area radius ratio of the outer detection region 325 may be a value outside the range of 71% or more and 89% or less. In such a case, the normalized SNR value may be high.

### [Acoustic Transducer 100 according to First Embodiment of Second Aspect]

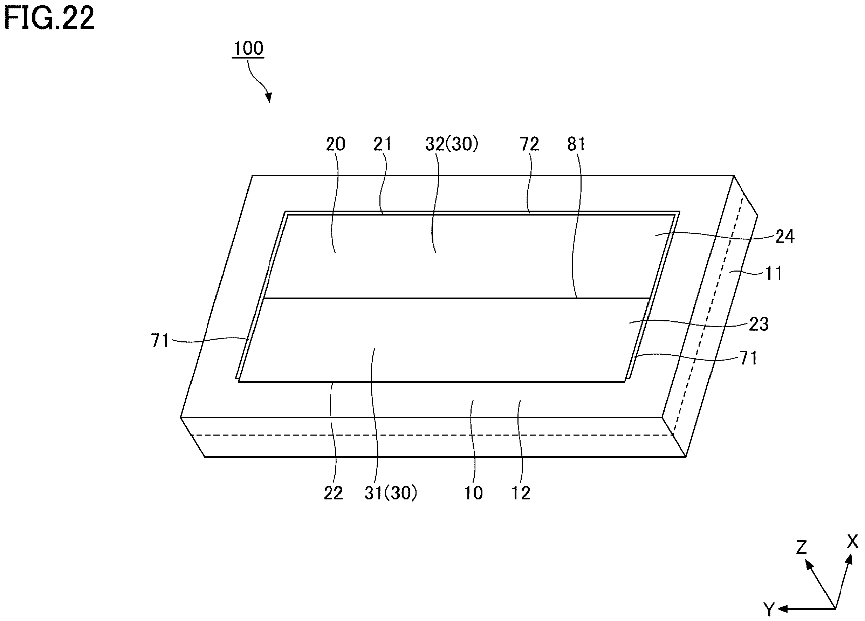

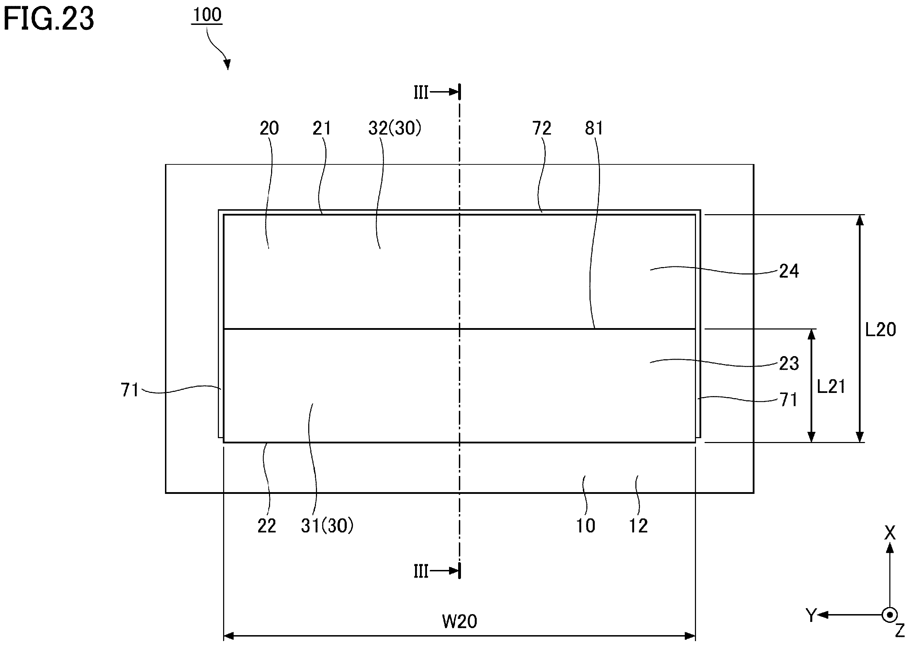

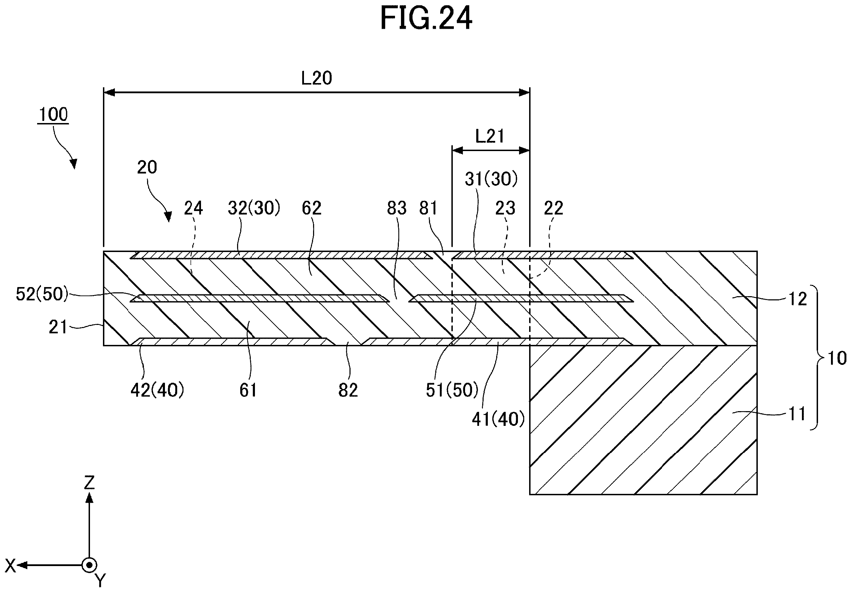

FIG. 22 is a perspective view illustrating an acoustic transducer 100 according to the first embodiment of the second aspect. FIG. 23 is a plan view illustrating the acoustic transducer 100 according to the first embodiment of the second aspect. FIG. 24 is a cross-sectional view illustrating the acoustic transducer 100 according to the first embodiment of the second aspect. In the drawings, an X-axis direction, a Y-axis direction, and a Z-axis direction that are orthogonal to each other may be illustrated. The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a direction crossing the first direction.

The acoustic transducer 100 illustrated in FIGS. 22 to 24 is a piezoelectric acoustic transducer including a piezoelectric element (piezoelectric film). The acoustic transducer 100 may be, for example, a microphone (MEMS microphone). The acoustic transducer 100 may be used for noise cancellation. The acoustic transducer 100 may be a true wireless stereo (TWS) or may be an in-vehicle device mounted on an automobile. The acoustic transducer 100 may be used, for example, as a hearing aid. As long as the acoustic transducer 100 is configured to detect a physical quantity, no particular limitation is imposed on the use of the acoustic transducer 100. The physical quantity may be, for example, a sound pressure.

### [Fixed Frame 10]

The acoustic transducer 100 includes a fixed frame 10 and a cantilever 20. The fixed frame 10 is a frame having a rectangular shape as viewed in the Z-axis direction. The length of the fixed frame 10 in the X-axis direction is shorter than the length of the fixed frame 10 in the Y-axis direction. The fixed frame 10 includes a first base 11 and a second base 12. The first base 11 may be a substrate. The second base 12 is formed over the first base 11.

### [Cantilever 20]

The cantilever 20 includes a piezoelectric film. The cantilever 20 projects from the fixed frame 10 inward of the fixed frame 10 in the X-axis direction. One end of the cantilever 20 is a fixed end 22, and the other end is a free end 21. As illustrated in FIGS. 22 and 23, a pair of slits 71 and a slit 72 are formed around the cantilever 20. The slits 71 and 72 are gaps formed between the fixed frame 10 and the cantilever 20, and penetrate through the substrate in the Z-axis direction. The pair of slits 71 extend in the X-axis direction, and are formed apart from each other in the Y-axis direction. The slit 72 is a gap formed between the free end 21 and the fixed frame 10. The fixed end 22 of the cantilever 20 is connected to the fixed frame 10. The widths of the slits 71 and 72 may be, for example, 100 nanometers (nm) or more and 5 micrometers (µm) or less. The widths of the slits 71 and 72 may be, for example, 0.5 µm.

FIG. 24 illustrates a cross section taken along line III-III in FIG. 23. As illustrated in FIG. 24, the piezoelectric film of the cantilever 20 includes the lower electrode 40, a first piezoelectric layer 61, an intermediate electrode 50, a second piezoelectric layer 62, and an upper electrode 30.

### [Lower Electrode 40]

The lower electrode 40 is a thin electrode film, and includes a first lower electrode 41 and a second lower electrode 42. The first lower electrode 41 and the second lower electrode 42 are disposed apart from each other in the X-axis direction. Between the first lower electrode 41 and the second lower electrode 42, there is an electrode-free region 82 in which no electrode is formed. After the lower electrode 40 is formed, the electrode is removed through etching, thereby forming the electrode-free region 82. The electrode-free region 82 may be formed by the lift-off method.

The first lower electrode 41 is formed closer to the fixed end 22 in the X-axis direction. The second lower electrode 42 is formed closer to the free end 21 in the X-axis direction.

### [First Piezoelectric Layer 61]

The first piezoelectric layer 61 is a piezoelectric thin film, and is formed over the lower electrode 40. The first piezoelectric layer 61 is formed to be continuous in the X-axis direction.

### [Intermediate Electrode 50]

The intermediate electrode 50 is a thin electrode film, and includes a first intermediate electrode 51 and a second intermediate electrode 52. The first intermediate electrode 51 and the second intermediate electrode 52 are disposed apart from each other in the X-axis direction. Between the first intermediate electrode 51 and the second intermediate electrode 52, there is an electrode-free region 83 in which no electrode is formed. After the intermediate electrode 50 is formed, the electrode is removed through etching, thereby forming the electrode-free region 83. The electrode-free region 83 may be formed by the lift-off method.

The first intermediate electrode 51 is formed closer to the fixed end 22 in the X-axis direction. The second intermediate electrode 52 is formed closer to the free end 21 in the X-axis direction.

### [Second Piezoelectric Layer 62]

The second piezoelectric layer 62 is a piezoelectric thin film, and is formed over the intermediate electrode 50. The first piezoelectric layer 61 is formed to be continuous in the X-axis direction.

### [Upper Electrode 30]

The upper electrode 30 is a thin electrode film, and includes a first upper electrode 31 and a second upper electrode 32. The first upper electrode 31 and the second upper electrode 32 are disposed apart from each other in the X-axis direction. Between the first upper electrode 31 and the second upper electrode 32, there is an electrode-free region 81 in which no electrode is formed. After the upper electrode 30 is formed, the electrode is removed through etching, thereby forming the electrode-free region 81. The electrode-free region 81 may be formed by the lift-off method.

The first upper electrode 31 is formed closer to the fixed end 22 in the X-axis direction. The second upper electrode 32 is formed closer to the free end 21 in the X-axis direction.

### [Material and Thickness of Piezoelectric Thin Film]

The materials of the first piezoelectric layer 61 and the second piezoelectric layer 62 may be, for example, ScAlN. The material of the first piezoelectric layer 61 may be AlN. The Sc may be 0 atomic % (at%) or more and 50 atomic % (at%) or less. The thicknesses of the first piezoelectric layer 61 and the second piezoelectric layer 62 may be, for example, 100 nm or more and 1 µm or less. The thicknesses of the first piezoelectric layer 61 and the second piezoelectric layer 62 may be, for example, 500 nm.

The first piezoelectric layer 61 and the second piezoelectric layer 62 may be a fluorite structure (hafnium oxide, zirconium oxide, or cesium oxide) or may be a wurtzite structure (zinc oxide).

[Material and Thickness of Thin Electrode Film] The materials of the upper electrode 30, the lower electrode 40, and the intermediate electrode 50 may be Al, Mo, Pt, Ti, or the like. The thicknesses of the upper electrode 30, the lower electrode 40, and the intermediate electrode 50 may be, for example, 5 nm or more and 100 nm or less. The thicknesses of the upper electrode 30, the lower electrode 40, and the intermediate electrode 50 may be, for example, 50 nm.

### [Detection Region 23 and Non-Detection Region 24]

The cantilever 20 includes a detection region 23 configured to detect a physical quantity, and a non-detection region 24 configured not to detect the physical quantity. The physical quantity is, for example, a sound pressure. The detection region 23 may be a region in which the first upper electrode 31, the first intermediate electrode 51, and the first lower electrode 41 are stacked in the Z-axis direction. The first upper electrode 31, the first intermediate electrode 51, and the first lower electrode 41 are electrically connected. The acoustic transducer 100 can detect piezoelectric output charges between the first upper electrode 31 and the first intermediate electrode 51. The acoustic transducer 100 can detect piezoelectric output charges between the first lower electrode 41 and the first intermediate electrode 51.

The detection region 23 is disposed closer to the fixed end 22 than is the non-detection region 24. In other words, the non-detection region 24 is disposed closer to the free end 21 than is the detection region 23.

The non-detection region 24 is a region of the cantilever 20, the region excluding the detection region 23. The second upper electrode 32, the second intermediate electrode 52, and the second lower electrode 42 are not electrically connected.

### [Length L21 of Detection Region 23]

A length L21 of the detection region 23 is the length of the detection region 23 in the X-axis direction. The length L21 of the detection region 23 may be the length of the first upper electrode 31 that is the shortest among the length of the first upper electrode 31, the length of the first intermediate electrode 51, and the length of the first lower electrode 41.

The length L21 of the detection region 23 may be a length 20% or more and 75% or less of an overall length L20 of the cantilever 20. The overall length L20 of the cantilever 20 is the length of the cantilever 20 in the X-axis direction from the fixed end 22 to the free end 21. The length L21 of the detection region 23 may be a length 30% or more and 60% or less of the overall length L20 of the cantilever 20. The length L21 of the detection region 23 may be a length 40% or more and 45% or less of the overall length L20 of the cantilever 20. The length of the non-detection region 24 is the remaining length obtained by subtracting the length L21 of the detection region 23 from the overall length L20 of the cantilever 20.

The first upper electrode 31 is shorter, in the X-axis direction, than the first intermediate electrode 51 and the first lower electrode 41. The first lower electrode 41 is longer, in the X-axis direction, than the first upper electrode 31 and the first intermediate electrode 51.

The second upper electrode 32 is longer, in the X-axis direction, than the second intermediate electrode 52 and the first piezoelectric layer 61. The second lower electrode 42 is shorter, in the X-axis direction, than the second upper electrode 32 and the second intermediate electrode 52.

### [Divided Position]

As described above, the electrode-free region 81 is formed between the first upper electrode 31 and the second upper electrode 32. The electrode-free region 81 may be referred to as a divided position. The divided position of the electrode-free region 81 may be formed in a range of 20% or more and 75% or less of the overall length L20 of the cantilever 20 from the fixed end 22. The divided position of the electrode-free region 81 may be formed in a range of 30% or more and 60% or less of the overall length L20 of the cantilever 20 from the fixed end 22. The divided position of the electrode-free region 81 may be formed in a range of 40% or more and 45% or less of the overall length L20 of the cantilever 20 from the fixed end 22.

In the X-axis direction, the end of the detection region 23 closer to the free end 21 may be at a position in a range of 20% or more and 75% or less of the overall length L20 of the cantilever 20 from the fixed end 22. The end of the detection region 23 closer to the free end 21 is the end of the detection region 23 farther from the fixed end 22. In the X-axis direction, the end of the detection region 23 closer to the free end 21 may be at a position in a range of 30% or more and 60% or less of the overall length L20 of the cantilever 20 from the fixed end 22. In the X-axis direction, the end of the detection region 23 closer to the free end 21 may be at a position in a range of 40% or more and 45% or less of the overall length L20 of the cantilever 20 from the fixed end 22.

The divided position of the upper electrode 30 (electrode-free region 81) in the X-axis direction, the divided position of the intermediate electrode 50 (electrode-free region 83) in the X-axis direction, and the divided position of the lower electrode 40 (electrode-free region 82) in the X-axis direction do not overlap with each other. The first intermediate electrode 51 and the first lower electrode 41 are formed below the electrode-free region 81. The second intermediate electrode 52 and the second upper electrode 32 are formed above the electrode-free region 82. The second upper electrode 32 is formed above the electrode-free region 83, and the first lower electrode 41 is formed below the electrode-free region 83. This can suppress a reduction in mechanical strength of the cantilever 20. A piezoelectric thin film is formed in the electrode-free regions 81 to 83.

The electrode-free region 81 is disposed closer to the fixed end 22 than are the electrode-free regions 82 and 83. The electrode-free region 82 is disposed farther from the fixed end 22 than are the electrode-free regions 81 and 83. The crystallinity of the piezoelectric thin film above the boundary between the electrode-free region 82 and the end of the first lower electrode 41 is lower than that of the piezoelectric thin film above the lower electrode 40. Similarly, the crystallinity of the piezoelectric thin film at the boundary between the electrode-free region 82 and the end of the second lower electrode 42 is lower than that of the piezoelectric thin film above the lower electrode 40. In the cantilever 20, the electrode-free region 82 is formed farther from the fixed end 22 than are the electrode-free regions 81 and 83, and thus the boundary between the electrode-free region 82 and the end of the first lower electrode 41 or the end of the second lower electrode 42 is formed farther from the fixed end 22. This does not inhibit crystal growth of the piezoelectric thin film configured to generate charges. The piezoelectric thin film configured to generate charges includes the first piezoelectric layer 61 between the first lower electrode 41 and the first intermediate electrode 51, and the second piezoelectric layer 62 between the first upper electrode 31 and the first intermediate electrode 51. In the cantilever 20, the crystallinity of the piezoelectric thin film in the detection region 23 configured to generate charges is high.

### [Shape of Cantilever 20]

As described above, the shape of the cantilever 20 is rectangular as viewed in the Z-axis direction. When the cantilever 20 is rectangular, the area of the cantilever 20 in the chip can be increased, and thus the cantilever 20 can be increased in sensitivity. In other words, the acoustic transducer 100 can be reduced in size compared to an existing acoustic transducer having a size the same as that of the acoustic transducer 100. The acoustic transducer 100 can be reduced in size and thus can be reduced in cost.

### [Overall Length L20 of Cantilever 20]

In the acoustic transducer 100, the resonance frequency of the cantilever 20 can be readily changed by changing the overall length L20 of the cantilever 20. The resonance frequency can be lowered by increasing the overall length L20 of the cantilever 20 at the time of design. The resonance frequency when the overall length L20 of the cantilever 20 is long is lower than the resonance frequency when the overall length L20 of the cantilever 20 is short.

### [Width W20 of Cantilever 20]

FIG. 23 illustrates a width W20 of the cantilever 20. The width W20 of the cantilever 20 is the width of the cantilever 20 along the Y-axis direction, i.e., the width of the detection region 23. In the acoustic transducer 100, by changing the width W20 of the cantilever 20, the cantilever 20 can be changed in sensitivity regardless of the resonance frequency. The sensitivity of the cantilever 20 is the sensitivity achieved by the detection region 23. The sensitivity can be increased by increasing the width W20 of the cantilever 20 at the time of design. The sensitivity when the width W20 is large is higher than the sensitivity when the width W20 is small.

### [Shapes of Ends of Electrodes]

The ends of the electrodes in the X-axis direction may be formed to have tapered shapes. The electrodes include the upper electrode 30, the lower electrode 40, and the intermediate electrode 50. The thickness of the end of each electrode in the X-axis direction may be smaller than the thickness of the center of the electrode in the X-axis direction. The end of the electrode may be formed to have an acute angle. The tapered shape may be tilted such that the lower end is disposed outward of the upper end in the X-axis direction.

The ends of the electrodes may be disposed inward of the free end 21 in the X-axis direction. The first piezoelectric layer 61 and the second piezoelectric layer 62 may be formed outward of the ends of the electrodes in the X-axis direction. The first piezoelectric layer 61 and the second piezoelectric layer 62 may be connected in the Z-axis direction in a region outward of the ends of the electrodes. As described above, the tapered ends of the electrodes can suppress a reduction in crystallinity of the first piezoelectric layer 61 and the second piezoelectric layer 62. Therefore, charges can be stably generated in the first piezoelectric layer 61 and the second piezoelectric layer 62.

### [Operations and Effects of Acoustic Transducer 100 according to First Embodiment of Second Aspect]

The acoustic transducer 100 according to the first embodiment of the second aspect includes a fixed frame 10 and a cantilever 20. The cantilever 20 includes a fixed end 22 and a free end 21, and projects from the fixed frame 10 inward of the fixed frame 10. The fixed end 22 is one end of the cantilever 20 fixed to the fixed frame 10, and the free end 21 is the other end of the cantilever 20. The cantilever 20 includes a detection region 23 configured to detect a physical quantity, and a non-detection region 24 configured not to detect the physical quantity.

The acoustic transducer 100 according to the embodiments of the second aspect can detect, in response to deformation of the cantilever 20, the physical quantity by detecting the deformation of the cantilever 20. In the acoustic transducer 100, the electrodes are divided in the lengthwise direction (X-axis direction) of the cantilever 20, thereby forming the detection region 23 and the non-detection region 24 and enabling increasing the sensitivity.

In the cantilever 20, stress is concentrated in the root portion near the first base 11 on the fixed end 22 side, and thus a large amount of charges are generated. On the other hand, little stress is generated on the free end 21 side of the cantilever 20, and thus a small amount of charges are generated. Therefore, the charges generated per unit area can be increased by electrically separating the root portion of the first base 11 on the fixed end 22 side from the tip on the free end 21 side, and using the root portion alone for the detection regions 23. This can increase a signal level, and thus increase sensitivity.

Also, in the acoustic transducer 100, the cantilever 20 includes a piezoelectric film, and the piezoelectric film includes the lower electrode 40, the first piezoelectric layer 61 formed over the lower electrode 40, the intermediate electrode 50 formed over the first piezoelectric layer 61, the second piezoelectric layer 62 formed over the intermediate electrode 50, and the upper electrode 30 formed over the second piezoelectric layer 62. The electrode-free regions 82, 83, and 81, in which at least one electrode of the lower electrode 40, the intermediate electrode 50, or the upper electrode 30 is not formed, are included between the detection region 23 and the non-detection region 24.

In the acoustic transducer 100 with this configuration, in response to deformation of the cantilever 20, which is a piezoelectric film, piezoelectric output charges generated between the first upper electrode 31 and the first intermediate electrode 51 in the detection region 23 and piezoelectric output charges generated between the first lower electrode 41 and the first intermediate electrode 51 in the detection region 23 are connected to the intermediate electrode 51. In the acoustic transducer 100, by forming the electrode-free region 82, 83, or 81, in which no electrode is formed, in at least one electrode of the lower electrode 40, the intermediate electrode 50, or the upper electrode 30, it is possible to divide the detection region 23 and the non-detection region 24.

In the acoustic transducer 100, the electrode-free region 82, in which the lower electrode 40 is not formed, is formed at a position farther from the fixed end 22 than is the electrode-free region 81, in which the upper electrode 30 is not formed. Thus, it is possible to avoid a reduction in crystallinity of the first piezoelectric layer 61 between the first lower electrode 41 and the intermediate electrode 50 and a reduction in crystallinity of the second piezoelectric layer 62 between the intermediate electrode 50 and the first upper electrode 31. Therefore, charges can be stably generated in the first piezoelectric layer 61 and the second piezoelectric layer 62.

Also, the acoustic transducer 100 is a piezoelectric acoustic transducer, and is more resistant to dust and water droplets than existing electrostatic acoustic transducers.

Also, the acoustic transducer 100 has a rectangular shape, and thus the area of the cantilever 20 in a chip can be increased, and the sensitivity can be increased. The acoustic transducer 100 is configured to be increased in sensitivity, and thus the acoustic transducer 100 can be reduced in size. In the acoustic transducer 100, the resonance frequency can be readily changed by changing the overall length L20 of the cantilever 20. In the acoustic transducer 100, by changing a width W20 of the detection region 23, the sensitivity can be changed regardless of the resonance frequency.

### [Acoustic Transducer 100B according to Second Embodiment of Second Aspect]

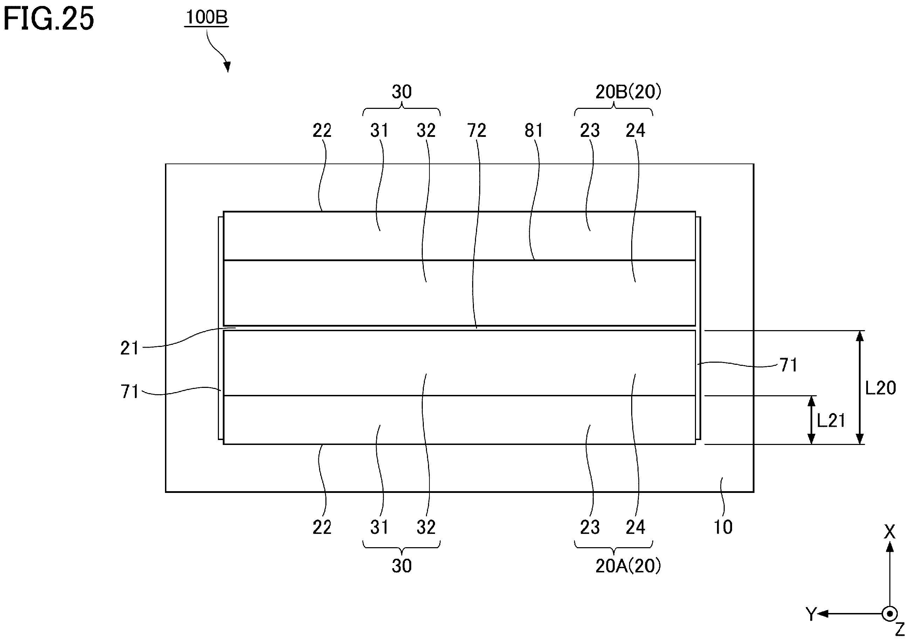

Next, an acoustic transducer 100B according to the second embodiment of the second aspect will be described. FIG. 25 is a plan view illustrating the acoustic transducer 100B according to the second embodiment of the second aspect. The acoustic transducer 100B according to the second embodiment of the second aspect illustrated in FIG. 25 differs from the acoustic transducer 100 according to the first embodiment of the second aspect illustrated in FIG. 23 in that the acoustic transducer 100B includes a pair of cantilevers 20. In the description of the acoustic transducer 100B according to the second embodiment of the second aspect, the same description as that of the acoustic transducer 100 according to the first embodiment of the second aspect may be omitted.

The acoustic transducer 100B includes the pair of cantilevers 20. The pair of cantilevers 20 include cantilevers 20A and 20B disposed to face each other in the X-axis direction. The cantilever 20A is an example of a first cantilever, and the cantilever 20B is an example of a second cantilever. The free ends 21 of the pair of cantilevers 20 face each other. The cantilevers 20A and 20B each have a structure the same as that of the above-described cantilever 20. A capacitive element of the cantilever 20A and a capacitive element of the cantilever 20B are connected in series.

### [Operations and Effects of Acoustic Transducer 100B according to Second Embodiment of Second Aspect]

The acoustic transducer 100B according to the second embodiment of the second aspect exhibits operations and effects similar to those exhibited by the acoustic transducer 100 according to the first embodiment of the second aspect. The acoustic transducer 100B according to the second embodiment of the second aspect includes the pair of cantilevers 20 facing each other in the X-axis direction, thereby enabling increasing the sensitivity.

### [Relationship between Ratio of Detection Region 23 and Signal Level]

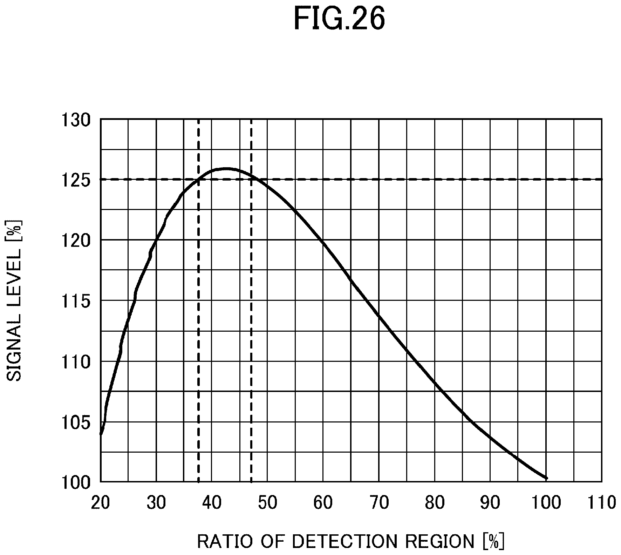

Next, a relationship between a ratio of the detection region 23 and a signal level will be described with reference to FIG. 26. FIG. 26 is a graph illustrating the relationship between the ratio of the detection region 23 with respect to the overall length L20 of the cantilever 20, and the signal level. In FIG. 26, the horizontal axis indicates the ratio [%] of the detection region 23, and the vertical axis indicates the signal level [%]. The ratio of the detection region 23 is a ratio of the length L21 of the detection region 23 to the overall length L20 of the cantilever 20. In a range in which the ratio of the detection region 23 is 40% or more and 45% or less, the signal level is 125% or more. When the ratio of the detection region 23 is 40% or more and 45% or less, the signal-to-noise ratio (S/N ratio) can be improved by about 1.5 dB. The graph illustrated in FIG. 26 may be, for example, a result of calculation performed on the acoustic transducer 100B.

### [Acoustic Transducer 100C according to Third Embodiment of Second Aspect]

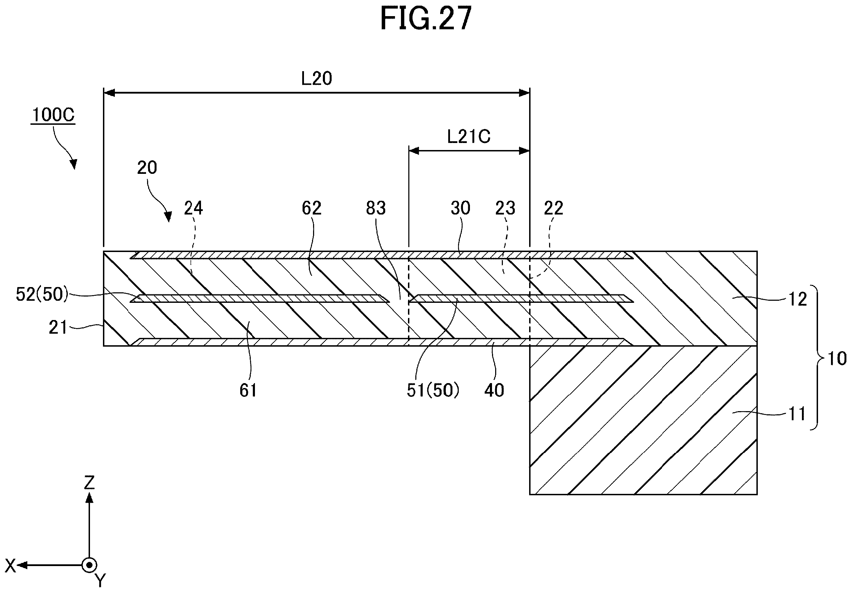

Next, an acoustic transducer 100C according to the third embodiment of the second aspect will be described. FIG. 27 is a cross-sectional view illustrating the acoustic transducer 100C according to the third embodiment of the second aspect. The acoustic transducer 100C illustrated in FIG. 27 differs from the acoustic transducer 100 according to the first embodiment of the second aspect illustrated in FIG. 24 in that the upper electrode 30 and the lower electrode 40 are not divided. In the description of the acoustic transducer 100C according to the third embodiment of the second aspect, the same description as that of the acoustic transducer 100 according to the first embodiment of the second aspect may be omitted.

The cantilever 20 of the acoustic transducer 100C includes the upper electrode 30, the intermediate electrode 50, and the lower electrode 40. The upper electrode 30 is formed to be continuous from the fixed end 22 to the free end 21. The lower electrode 40 is formed to be continuous from the fixed end 22 to the free end 21. The intermediate electrode 50 includes the first intermediate electrode 51 and the second intermediate electrode 52. The electrode-free region 83 is formed between the first intermediate electrode 51 and the second intermediate electrode 52.

The cantilever 20 includes the detection region 23 and the non-detection region 24. The detection region 23 is a region in which the lower electrode 40, the first intermediate electrode 51, and the upper electrode 30 are stacked in the Z-axis direction. The acoustic transducer 100C can detect the capacitance between the upper electrode 30 and the first intermediate electrode 51. The acoustic transducer 100C can detect the capacitance between the lower electrode 40 and the first intermediate electrode 51. A length L21C of the detection region 23 is the length of the first intermediate electrode 51 in the X-axis direction.

[Operations and Effects of Acoustic Transducer 100C according to Third Embodiment of Second Aspect] The acoustic transducer 100C according to the third embodiment of the second aspect exhibits operations and effects similar to those exhibited by the acoustic transducer 100 according to the first embodiment of the second aspect. In the acoustic transducer 100C, the intermediate electrode 50 may be divided, and the upper electrode 30 and the lower electrode 40 may need not to be divided.

### [Acoustic Transducer 100D according to Fourth Embodiment of Second Aspect]

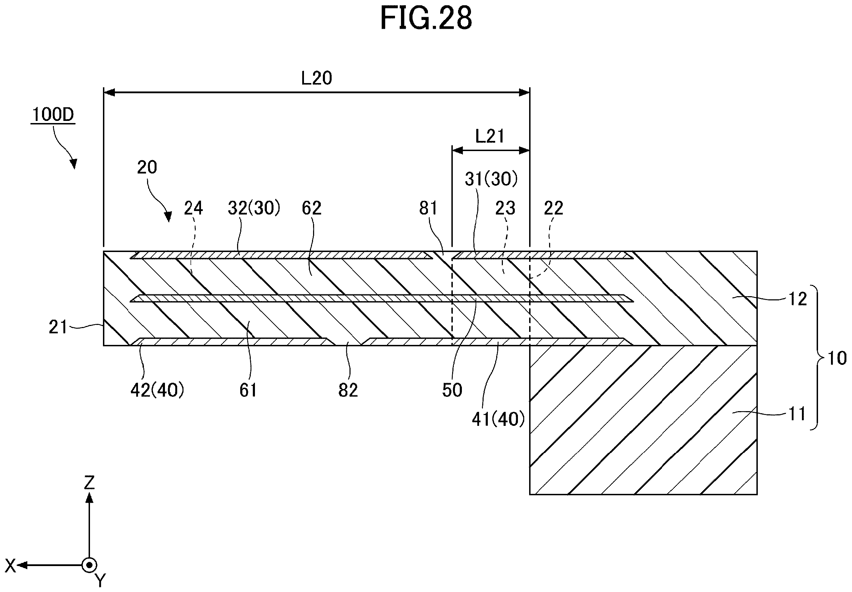

Next, an acoustic transducer 100D according to the fourth embodiment of the second aspect will be described. FIG. 28 is a cross-sectional view illustrating the acoustic transducer 100D according to the fourth embodiment of the second aspect. The acoustic transducer 100D illustrated in FIG. 28 differs from the acoustic transducer 100 according to the first embodiment of the second aspect illustrated in FIG. 24 in that the intermediate electrode 50 is not divided. In the description of the acoustic transducer 100D according to the fourth embodiment of the second aspect, the same description as that of the acoustic transducer 100 according to the first embodiment of the second aspect may be omitted.

The cantilever 20 of the acoustic transducer 100D includes the upper electrode 30, the intermediate electrode 50, and the lower electrode 40. The upper electrode 30 includes the first upper electrode 31 and the second upper electrode 32. The electrode-free region 81 is formed between the first upper electrode 31 and the second upper electrode 32. The lower electrode 40 includes the first lower electrode 41 and the second lower electrode 42. The electrode-free region 82 is formed between the first lower electrode 41 and the second lower electrode 42. The intermediate electrode 50 is formed to be continuous from the fixed end 22 to the free end 21.

The cantilever 20 includes the detection region 23 and the non-detection region 24. The detection region 23 is a region in which the first lower electrode 41, the intermediate electrode 50, and the first upper electrode 31 are stacked in the Z-axis direction. In the acoustic transducer 100D, piezoelectric output charges are generated between the first upper electrode 31 and the intermediate electrode 50. In the acoustic transducer 100D, piezoelectric output charges are generated between the first lower electrode 41 and the intermediate electrode 50. The length L21 of the detection region 23 is the length of the first upper electrode 31 in the X-axis direction.

### [Operations and Effects of Acoustic Transducer 100D according to Fourth Embodiment of Second Aspect]

The acoustic transducer 100D according to the fourth embodiment of the second aspect exhibits operations and effects similar to those exhibited by the acoustic transducer 100 according to the first embodiment of the second aspect. In the acoustic transducer 100D, the upper electrode 30 and the lower electrode 40 may be divided, and the intermediate electrode 50 may need not to be divided.

In the acoustic transducer 100, at least one of the upper electrode 30, the lower electrode 40, or the intermediate electrode 50 may be divided. In the acoustic transducer 100, the upper electrode 30 may be divided, and the lower electrode 40 and the intermediate electrode 50 may need not to be divided. In the acoustic transducer 100, the lower electrode 40 may be divided, and the upper electrode 30 and the intermediate electrode 50 may need not to be divided.

### [Acoustic Transducer 100E according to Fifth Embodiment of Second Aspect]

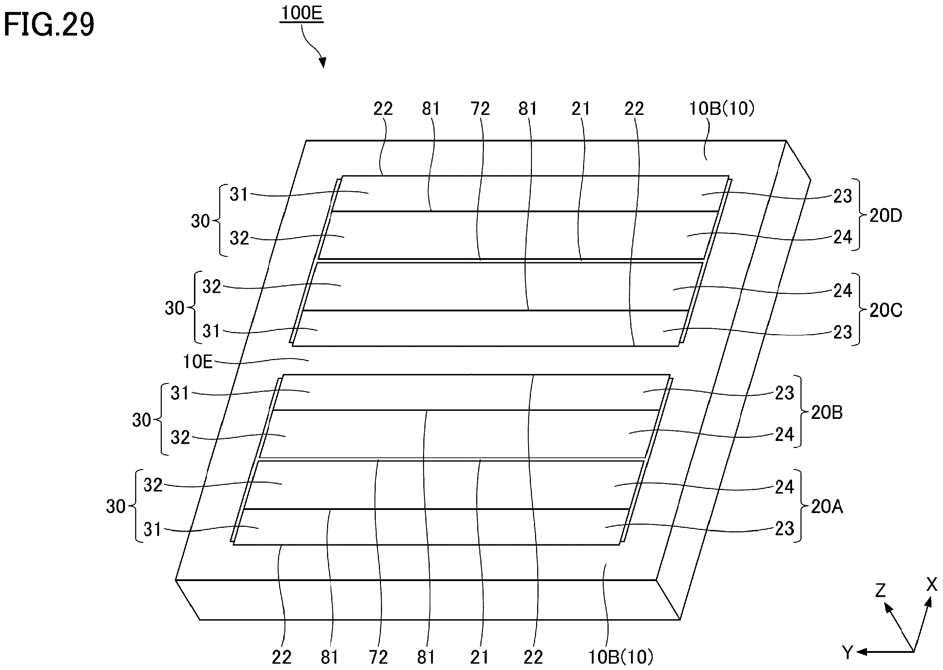

Next, an acoustic transducer 100E according to the fifth embodiment of the second aspect will be described. FIG. 29 is a perspective view illustrating the acoustic transducer 100E according to the fifth embodiment of the second aspect. The acoustic transducer 100E according to the fifth embodiment of the second aspect illustrated in FIG. 29 differs from the acoustic transducer 100B according to the second embodiment of the second aspect illustrated in FIG. 25 in that the acoustic transducer 100E includes four cantilevers 20 and the shape of the fixed frame 10 is different. In the description of the acoustic transducer 100E according to the fifth embodiment of the second aspect, the same description as that of the acoustic transducers 100 and 100B according to the above embodiments of the second aspect may be omitted.

The acoustic transducer 100E includes the fixed frame 10. The fixed frame 10 includes a plurality of frames 10B. The plurality of frames 10B are arranged in the X-axis direction. The plurality of frames 10B include a common part 10E. The common part 10E extends in the Y-axis direction at the center of the fixed frame 10. A pair of cantilevers 20 are formed in each of the plurality of frames 10B. The free ends 21 of the pair of cantilevers 20 are disposed to face each other. The cantilevers 20 project from the common part 10E toward opposite sides.

### [Operations and Effects of Acoustic Transducer 100E according to Fifth Embodiment of Second Aspect]

The acoustic transducer 100E according to the fifth embodiment of the second aspect exhibits operations and effects similar to those exhibited by the acoustic transducer 100 according to the first embodiment of the second aspect. The acoustic transducer 100E according to the fifth embodiment of the second aspect includes four cantilevers 20, thereby enabling increasing the sensitivity. The acoustic transducer 100E may include a plurality of pairs of cantilevers 20. The acoustic transducer 100E may include four or more cantilevers 20.

### [Circuit Diagram of Acoustic Transducer 100E according to Embodiments of Second Aspect]

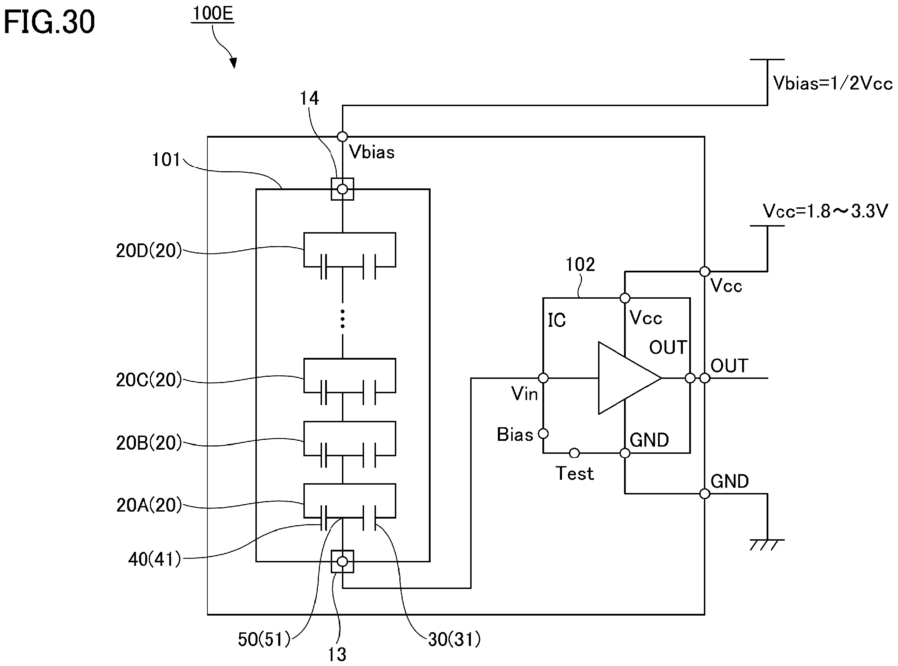

Next, a circuit diagram of the acoustic transducer 100E according to the embodiments of the second aspect will be described. FIG. 30 is the circuit diagram of the acoustic transducer 100E according to the embodiments of the second aspect. In the description of the acoustic transducer 100E, the same description as that of the acoustic transducers 100 and 100B to 100D according to the above embodiments of the second aspect may be omitted.

As illustrated in FIG. 30, the acoustic transducer 100E includes an MEMS microphone chip 101. The MEMS microphone chip 101 includes a plurality of cantilevers 20A, 20B, 20C, and 20D. The MEMS microphone chip 101 may include four or more cantilevers 20. The cantilevers 20A, 20B, 20C, and 20D each include the upper electrode 30, the lower electrode 40, and the intermediate electrode 50. The acoustic transducer 100 can detect piezoelectric output charges between the upper electrode 30 and the intermediate electrode 50, and piezoelectric output charges between the lower electrode 40 and the intermediate electrode 50. The cantilevers 20A, 20B, 20C, and 20D are connected in series.

The MEMS microphone chip 101 includes the pads 13 and 14. The cantilever 20A is connected to the pad 13, and the cantilever 20D is connected to the pad 14. The acoustic transducer 100E includes an IC 102 connected to the pad 13. The IC 102 is an amplifier configured to amplify an output signal of the cantilever 20. The IC 102 may be provided with a function of performing analog-to-digital (AD) conversion after amplifying the output signal of the cantilever 20. Also, the IC 102 may fix the output level of the amplified signal.

### [Acoustic Transducer 100F according to Sixth Embodiment of Second Aspect]

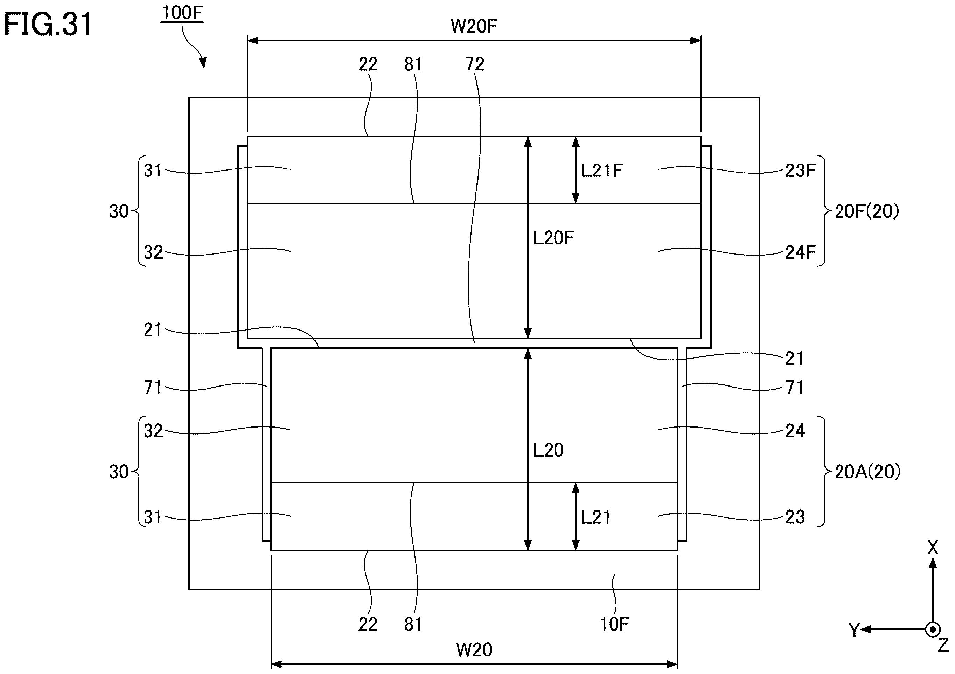

Next, an acoustic transducer 100F according to the sixth embodiment of the second aspect will be described. FIG. 31 is a plan view illustrating the acoustic transducer 100F according to the sixth embodiment of the second aspect. The acoustic transducer 100F according to the sixth embodiment of the second aspect illustrated in FIG. 31 differs from the acoustic transducer 100B according to the second embodiment of the second aspect illustrated in FIG. 25 in that the acoustic transducer 100F includes a pair of cantilevers 20 having different widths W20 and W20F (cantilevers 20A and 20F) and the shape of a fixed frame 10F is different. In the description of the acoustic transducer 100F according to the sixth embodiment of the second aspect, the same description as that of the acoustic transducers 100 and 100B according to the above embodiments of the second aspect may be omitted.

The acoustic transducer 100F includes the cantilevers 20A and 20F as the pair of cantilevers 20. A stacked structure of each of the cantilevers 20A and 20F is the same as that of the cantilever 20 as described above, and includes the upper electrode 30, the lower electrode 40, the intermediate electrode 50, the first piezoelectric layer 61, and the second piezoelectric layer 62. The cantilever 20A includes the detection region 23 and the non-detection region 24. The cantilever 20F includes the detection region 23F and the non-detection region 24F.

The width W20F of the cantilever 20F is larger than the width W20 of the cantilever 20A (W20F>W20). The width W20F is the width of the first upper electrode 31 of the detection region 23F. The width W20 is the width of the first upper electrode 31 of the detection region 23. A capacitive element of the cantilever 20A and a capacitive element of the cantilever 20F are connected in series.

The length L20 of the cantilever 20A may be equal to the length L20F of the cantilever 20F (L20=L20F). The length L21 of the detection region 23 of the cantilever 20A may be substantially equal to the length L21F of the detection region 23F of the cantilever 20F (L21 is nearly equal to L21F).

The shape of the fixed frame 10F corresponds to the shape of the cantilevers 20A and 20F. The slits 71 formed on both sides of the cantilever 20A, and the slits 71 formed on both sides of the cantilever 20F are disposed at different positions in the Y-axis direction.

### [Operations and Effects of Acoustic Transducer 100F according to Sixth Embodiment of Second Aspect]

The acoustic transducer 100F according to the sixth embodiment of the second aspect exhibits operations and effects similar to those exhibited by the acoustic transducer 100 according to the first embodiment of the second aspect. In the acoustic transducer 100F according to the sixth embodiment of the second aspect, the widths W20 and W20F, along the Y-axis direction, of the pair of cantilevers 20A and 20F facing each other may be different.

### [Acoustic Transducer 100G according to Seventh Embodiment of Second Aspect]

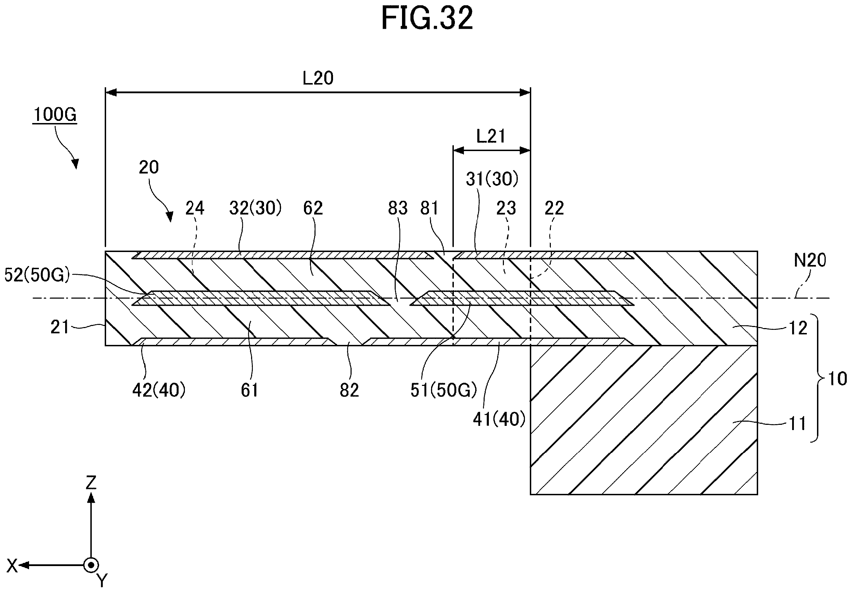

Next, an acoustic transducer 100G according to the seventh embodiment of the second aspect will be described. FIG. 32 is a cross-sectional view illustrating the acoustic transducer 100G according to the seventh embodiment of the second aspect. The acoustic transducer 100G according to the seventh embodiment illustrated in FIG. 32 differs from the acoustic transducer 100 illustrated in FIG. 24 in that the thickness of an intermediate electrode 50G is larger than the thicknesses of the upper electrode 30 and the lower electrode 40. In the description of the acoustic transducer 100G according to the seventh embodiment of the second aspect, the same description as that of the acoustic transducer 100 according to the embodiments of the second aspect may be omitted.

The cantilever 20 of the acoustic transducer 100G includes the upper electrode 30, the lower electrode 40, the intermediate electrode 50G, the first piezoelectric layer 61, and the second piezoelectric layer 62. The intermediate electrode 50G includes the first intermediate electrode 51 and the second intermediate electrode 52. The intermediate electrode 50G is thicker than the upper electrode 30. The intermediate electrode 50G is thicker than the lower electrode 40. The thickness of the intermediate electrode 50G may be the thickness of the first intermediate electrode 51. In the detection region 23, the first intermediate electrode 51 is thicker than the first upper electrode 31 and the first lower electrode 41. The first upper electrode 31 may be the same thickness as that of the first lower electrode 41.

The intermediate electrode 50G is formed to include a neutral plane N20. The neutral plane N20 is an imaginary plane. For example, in a state in which no stress is generated in the cantilever 20, the neutral plane N20 may be disposed at the center position between the upper electrode 30 and the lower electrode 40 in the Z-axis direction, and may be a plane along the XY plane. The neutral plane N20 may be an imaginary plane in a state in which stress is generated in the cantilever 20, and a compressive stress or a tensile stress is not applied.

### [Operations and Effects of Acoustic Transducer

100G according to Seventh Embodiment of Second Aspect] The acoustic transducer 100G according to the seventh embodiment of the second aspect exhibits operations and effects similar to those exhibited by the acoustic transducer 100 according to the first embodiment of the second aspect. In the acoustic transducer 100G according to the seventh embodiment of the second aspect, the intermediate electrode 50 is thicker than the upper electrode 30 and the lower electrode 40. The intermediate electrode 50 is disposed at a position including the neutral plane N20. Thus, the first piezoelectric layer 61 and the second piezoelectric layer 62 are disposed outward in the thickness direction. Therefore, when stress is generated in the cantilever 20, it is possible to increase the amount of deformation of the first piezoelectric layer 61 and the second piezoelectric layer 62. As a result, the acoustic transducer 100G can achieve a high sensitivity, a reduced size, and a high SNR (S/N ratio).

### [Acoustic Transducer 200 according to Eighth Embodiment of Second Aspect]

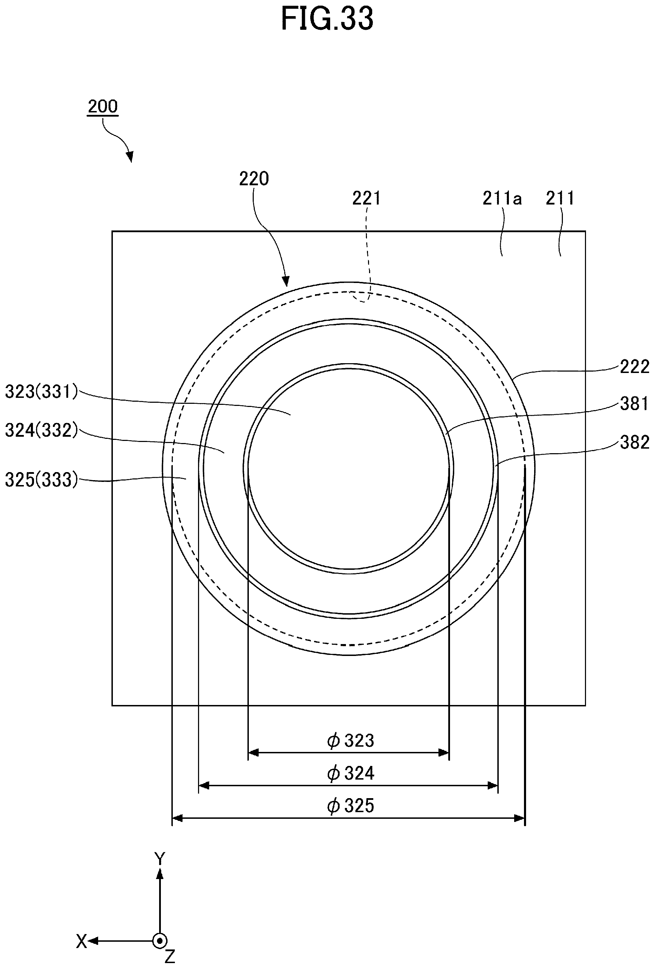

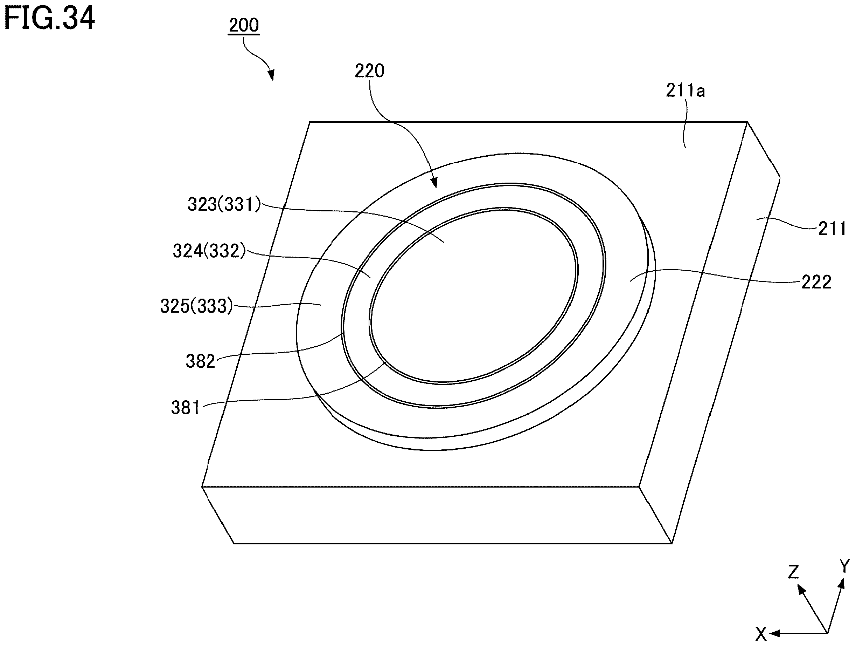

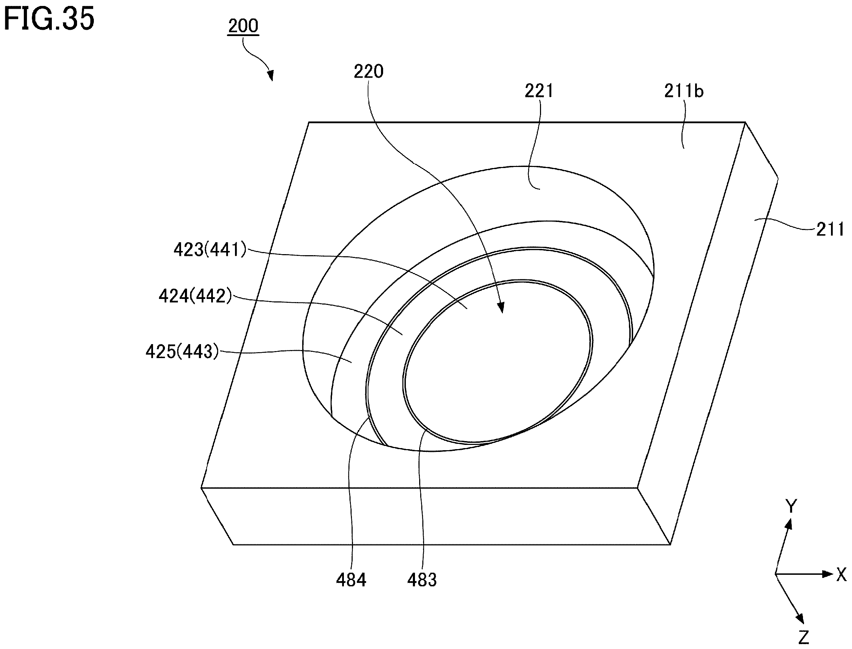

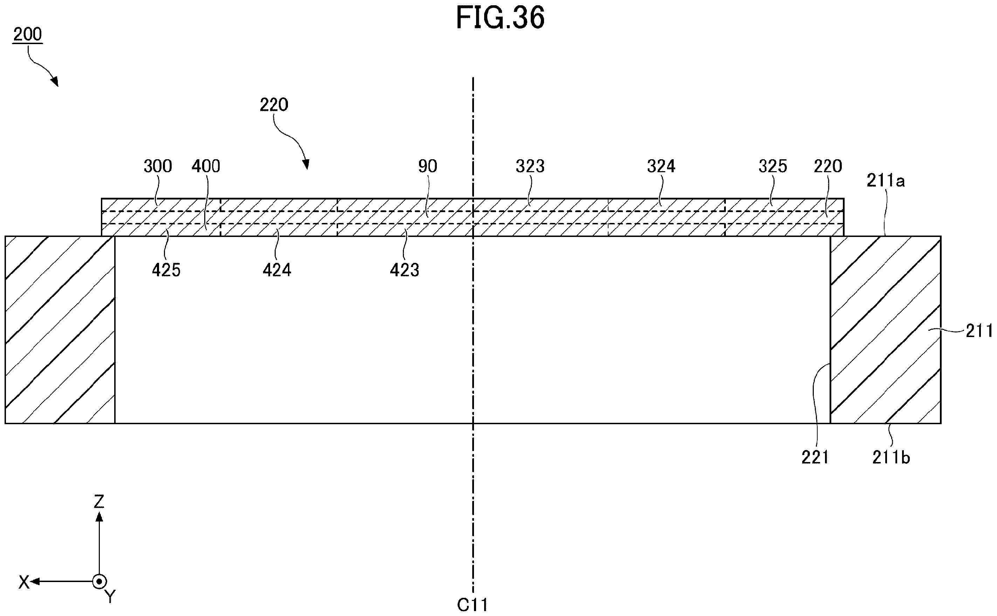

Next, an acoustic transducer 200 according to the eighth embodiment of the second aspect will be described. FIG. 33 is a plan view illustrating the acoustic transducer 200 according to the eighth embodiment of the second aspect. FIG. 34 is a perspective view illustrating the acoustic transducer 200 according to the eighth embodiment of the second aspect. FIG. 35 is a perspective view illustrating, from the bottom, the acoustic transducer 200 according to the eighth embodiment of the second aspect. FIG. 36 is a cross-sectional view illustrating the acoustic transducer 200 according to the eighth embodiment of the second aspect. In the drawings, an X-axis direction, a Y-axis direction, and a Z-axis direction that are orthogonal to each other may be illustrated. The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a direction crossing the first direction. In the description of the acoustic transducer 200 according to the eighth embodiment of the second aspect, the same description as that of the acoustic transducer 100 according to the above embodiments of the second aspect may be omitted.

### [Support Substrate 211]

The acoustic transducer 200 includes a support substrate (fixed frame) 211 and a vibration plate (piezoelectric element) 220. The support substrate 211 may be rectangular as viewed in the Z-axis direction. The plate thickness direction of the support substrate 211 is along the Z-axis direction. The support substrate 211 includes an upper surface 211a and a lower surface 211b facing each other in the Z-axis direction. An opening 221 is formed in the support substrate 211. The opening 221 is formed to penetrate through the support substrate 211 in the Z-axis direction. The support substrate 211 is formed, for example, of a silicon wafer. The opening 221 is formed to have a circular shape as viewed in the Z-axis direction.

### [Vibration Plate 220]

The vibration plate 220 includes a piezoelectric film. The vibration plate 220 is formed to cover an opening 221. The vibration plate 220 is formed to have a circular shape as viewed in the Z-axis direction. An outer circumference 222 of the vibration plate 220 is a fixed end of the vibration plate 220, and is fixed to an upper surface 211a of the support substrate 211. The vibration plate 220 includes a first detection region 324, a non-detection region 325, and a second detection region 326, as described below. The vibration plate 220 is also referred to as a "diaphragm". The shape of the opening 221 is not limited to a circular shape, but may be an elliptical shape or any other shape.

### [Piezoelectric Film]

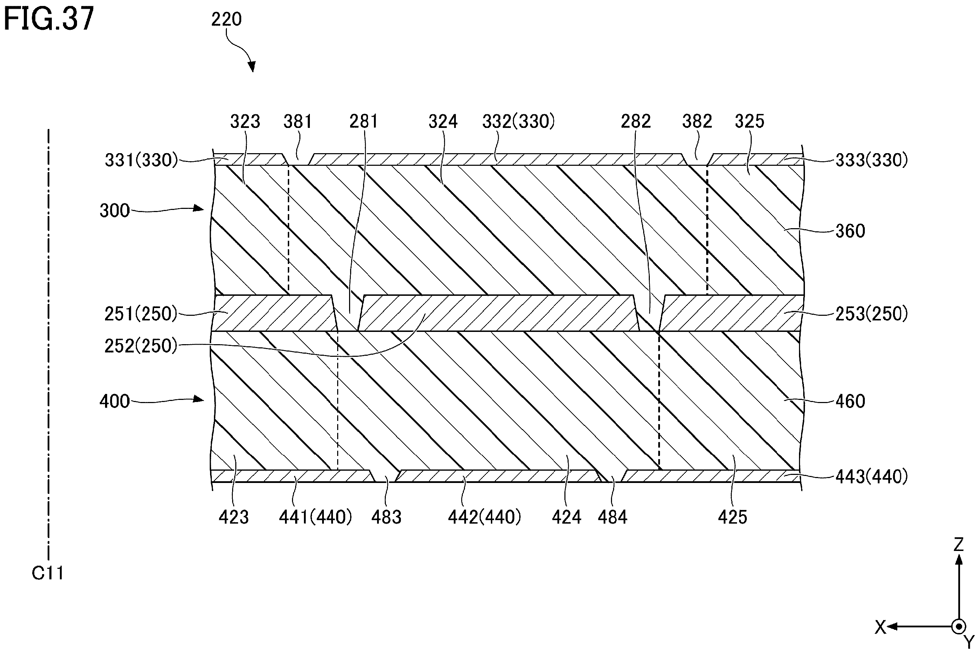

The piezoelectric film, which is the vibration plate 220, deforms in response to a sound pressure, thereby generating charges. FIG. 37 is an enlarged cross-sectional view illustrating the piezoelectric film. The piezoelectric film includes a lower electrode layer 440, a lower piezoelectric layer (first piezoelectric layer) 460, an intermediate electrode layer 250, an upper piezoelectric layer (second piezoelectric layer) 360, and an upper electrode layer 330. The lower electrode layer 440, the lower piezoelectric layer 460, the intermediate electrode layer 250, the upper piezoelectric layer 360, and the upper electrode layer 330 are stacked in this order.

### [Lower Electrode Layer 440]

The lower electrode layer 440 includes lower electrodes 441 to 443, which are thin electrode films. The lower electrode layer 440 is disposed closer to the opening 221 in the Z-axis direction. The lower electrodes 441 to 443 are disposed apart from each other in the X-axis direction. The lower electrode 441 is formed to have a circular shape. The lower electrode 441 is disposed closer to a center C11 of the vibration plate 220 as viewed in the Z-axis direction. The lower electrode 442 is formed to have a ring shape as viewed in the Z-axis direction. The lower electrode 442 is disposed outward of the lower electrode 441 in the radial direction. The lower electrode 443 is formed to have a ring shape as viewed in the Z-axis direction. The lower electrode 443 is disposed outward of the lower electrode 442 in the radial direction.

### [Electrode-Free Regions 483 and 484]

In the radial direction of the vibration plate 220, there is an electrode-free region 483, in which no electrode is formed, between the lower electrode 441 and the lower electrode 442. In the radial direction of the vibration plate 220, there is an electrode-free region 484, in which no electrode is formed, between the lower electrode 442 and the lower electrode 443.

### [Lower Piezoelectric Layer 460]

The lower piezoelectric layer 460 is a piezoelectric thin film, and is formed over the lower electrode layer 440. The lower piezoelectric layer 460 is formed to be continuous in the radial direction of the vibration plate 220.

### [Intermediate Electrode Layer 250]

The intermediate electrode layer 250 includes intermediate electrodes 251 to 253, which are thin electrode films. The intermediate electrode layer 250 is formed over the lower piezoelectric layer 460. The intermediate electrodes 251 to 253 are disposed apart from each other in the X-axis direction. The intermediate electrode 251 is formed to have a circular shape. The intermediate electrode 251 is disposed closer to the center C11 of the vibration plate 220 as viewed in the Z-axis direction. The intermediate electrode 252 is formed to have a ring shape as viewed in the Z-axis direction. The intermediate electrode 252 is disposed outward of the intermediate electrode 251 in the radial direction. The intermediate electrode 253 is formed to have a ring shape as viewed in the Z-axis direction. The intermediate electrode 253 is disposed outward of the intermediate electrode 252 in the radial direction.

### [Electrode-Free Regions 281 and 282]

In the radial direction of the vibration plate 220, there is an electrode-free region 281, in which no electrode is formed, between the intermediate electrode 251 and the intermediate electrode 252. In the radial direction of the vibration plate 220, there is an electrode-free region 282, in which no electrode is formed, between the intermediate electrode 252 and the intermediate electrode 253.

### [Upper Piezoelectric Layer 360]

The upper piezoelectric layer 360 is a piezoelectric thin film, and is formed over the intermediate electrode layer 250. The upper piezoelectric layer 360 is formed to be continuous in the radial direction of the vibration plate 220.

### [Upper Electrode Layer 330]

The upper electrode layer 330 includes upper electrodes 331 to 333, which are thin electrode films. The upper electrode layer 330 is formed over the upper piezoelectric layer 360. The upper electrodes 331 to 333 are disposed apart from each other in the X-axis direction. The upper electrode 331 is formed to have a circular shape. The upper electrode 331 is disposed closer to the center C11 of the vibration plate 220 as viewed in the Z-axis direction. The upper electrode 332 is formed to have a ring shape as viewed in the Z-axis direction. The upper electrode 332 is disposed outward of the upper electrode 331 in the radial direction. The upper electrode 333 is formed to have a ring shape as viewed in the Z-axis direction. The upper electrode 333 is disposed outward of the upper electrode 332 in the radial direction.

### [Material and Thickness of Piezoelectric Thin Film]

A piezoelectric material used for the lower piezoelectric layer 460 and the upper piezoelectric layer 360 may be, for example, aluminum nitride (AlN) or scandium aluminum nitride (ScAlN (Sc: 1 at% to 60 at%)), or may be, for example, a piezoelectric material having a fluorite structure (hafnium oxide, zirconium oxide, or cesium oxide) or a piezoelectric material having a wurtzite structure (zinc oxide or gallium nitride).

The thickness of the lower piezoelectric layer 460 may be, for example, 100 nm or more and 1 µm or less. The material of the lower piezoelectric layer 460 is, for example, ScAlN (Sc: 40 at%), and the thickness of the lower piezoelectric layer 460 may be, for example, 500 nm.

The thickness of the upper piezoelectric layer 360 may be, for example, 100 nm or more and 1 µm or less. The material of the upper piezoelectric layer 360 is, for example, ScAlN (Sc: 40 at%), and the thickness of the upper piezoelectric layer 360 may be, for example, 500 nm.

### [Material and Thickness of Thin Electrode Film]

The thicknesses of the thin electrode films of the upper electrode layer 330, the intermediate electrode layer 250, and the lower electrode layer 440 may be, for example, 5 nm or more and 100 nm or less. The thicknesses of the thin electrode films may be, for example, 20 nm. The thin electrode film of the upper electrode layer 330, the intermediate electrode layer 250, and the lower electrode layer 440 may be formed to have different thicknesses.

The materials of the thin electrode films of the upper electrode layer 330, the intermediate electrode layer 250, and the lower electrode layer 440 may be, for example, at least one of gold, platinum, tungsten, aluminum, copper, molybdenum, ruthenium, titanium, chromium, or nickel, or an alloy containing one of these. The thin electrode films of the upper electrode layer 330, the intermediate electrode layer 250, and the lower electrode layer 440 may be formed of the same material or different materials.

### [First Detection Regions, Non-Detection Regions, and Second Detection Regions]

As illustrated in FIGS. 36 and 37, the vibration plate 220, which is a diaphragm, includes the first detection regions 323 and 423, the non-detection regions 324 and 424, and the second detection regions 325 and 425. The first detection regions 323 and 423 and the second detection regions 325 and 425 are regions configured to detect a physical quantity. The non-detection regions 324 and 424 are regions configured not to detect the physical quantity. The physical quantity is, for example, a sound pressure.

The first detection region 323 is a region in which the intermediate electrode 251, the upper piezoelectric layer 360, and the upper electrode 331 are stacked in the Z-axis direction. The first detection region 423 is a region in which the lower electrode 441, the lower piezoelectric layer 460, and the intermediate electrode 251 are stacked in the Z-axis direction. The acoustic transducer 200 can detect piezoelectric output charges between the lower electrode 441 and the intermediate electrode 251. The acoustic transducer 200 can detect piezoelectric output charges between the intermediate electrode 251 and the upper electrode 331.

The non-detection region 324 includes a region in which the intermediate electrode 252, the upper piezoelectric layer 360, and the upper electrode 332 are stacked in the Z-axis direction. The non-detection region 424 includes a region in which the lower electrode 442, the lower piezoelectric layer 460, and the intermediate electrode 252 are stacked in the Z-axis direction. The acoustic transducer 200 cannot detect piezoelectric output charges between the lower electrode 442 and the intermediate electrode 252. The acoustic transducer 200 cannot detect piezoelectric output charges between the intermediate electrode 252 and the upper electrode 332.

The second detection region 325 is a region in which the intermediate electrode 253, the upper piezoelectric layer 360, and the upper electrode 333 are stacked in the Z-axis direction. The second detection region 425 is a region in which the lower electrode 443, the lower piezoelectric layer 460, and the intermediate electrode 253 are stacked in the Z-axis direction. The acoustic transducer 200 can detect piezoelectric output charges between the lower electrode 443 and the intermediate electrode 253. The acoustic transducer 200 can detect piezoelectric output charges between the intermediate electrode 253 and the upper electrode 333.

The first detection regions 323 and 423 are formed closer to the center of the vibration plate 220. The non-detection regions 324 and 424 are formed outward of the first detection regions 323 and 423 in the radial direction of the vibration plate 220. The second detection regions 325 and 425 are formed outward of the non-detection regions 324 and 424 in the radial direction of the vibration plate 220.

### [Outer Diameters of First Detection Region 323, Non-Detection Region 324, and Second Detection Region 325]

As illustrated in FIG. 33, an outer diameter Φ323 of the first detection region 323 is, for example, 0.59 millimeters (mm). An outer diameter Φ324 of the non-detection region 324 is, for example, 0.81 mm. An outer diameter Φ325 of the second detection region 325 is 1 mm.

### [Divided Positions]

As illustrated in FIG. 37, the electrode-free regions 483 and 484 are formed in the lower electrode layer 440. The electrode-free regions 281 and 282 are formed in the intermediate electrode layer 250. The electrode-free regions 381 and 382 are formed in the upper electrode layer 330.

The electrode-free regions 281, 282, 381, 382, 483, and 484 may be referred to as "divided positions". These electrode-free regions 281, 282, 381, 382, 483, and 484 are disposed at different positions in the radial direction of the vibration plate 220.

The electrode-free region 381 is disposed inward of the electrode-free region 281 in the radial direction of the vibration plate 220. The electrode-free region 281 is disposed inward of the electrode-free region 483 in the radial direction of the vibration plate 220.

The electrode-free region 382 is disposed outward of the electrode-free region 282 in the radial direction of the vibration plate 220. The electrode-free region 282 is disposed outward of the electrode-free region 484 in the radial direction of the vibration plate 220.

In the vibration plate 220, the electrode-free regions 281, 282, 381, 382, 483, and 484 are formed at positions not overlapping with each other as viewed in the Z-axis direction. This can suppress a reduction in strength of the vibration plate 220. A piezoelectric thin film is formed in the electrode-free regions 281, 282, 483, and 484.

The crystallinity of the piezoelectric thin film above the boundary between the end of the lower electrode 441 and the electrode-free region 483 is lower than that of the piezoelectric thin film above the lower electrode 441. Similarly, the crystallinity of the piezoelectric thin film above the boundary between the electrode and the electrode-free region is lower than that of the piezoelectric thin film above the electrode.

The divided position of the electrode-free region 483 is disposed outward of the first detection region 423 in the radial direction of the vibration plate 220. The divided position of the electrode-free region 484 is disposed inward of the second detection region 425 in the radial direction of the vibration plate 220. This does not inhibit crystal growth of the piezoelectric thin film configured to generate charges. In the acoustic transducer 200, the crystallinities of the piezoelectric thin films in the first detection region 423 and the second detection region 425, which generate charges, are high.

The divided position of the electrode-free region 281 is disposed outward of the first detection region 323 in the radial direction of the vibration plate 220. The divided position of the electrode-free region 282 is disposed inward of the second detection region 325 in the radial direction of the vibration plate 220. This does not inhibit crystal growth of the piezoelectric thin film configured to generate charges. In the acoustic transducer 200, the crystallinities of the piezoelectric thin films in the first detection region 323 and the second detection region 325, which generate charges, are high.

### [Connection in Piezoelectric Film]

In the vibration plate 220, which is the piezoelectric film (piezoelectric element), the electrodes of the first detection regions 323 and 423 are electrically connected in parallel. The electrodes of the first detection region 323 include the upper electrode 331 and the intermediate electrode 251. The electrodes of the first detection region 423 include the lower electrode 441 and the intermediate electrode 251. The electrodes of the second detection regions 325 and 425 are electrically connected in parallel. The electrodes of the second detection region 325 include the upper electrode 333 and the intermediate electrode 253. The electrodes of the second detection region 425 include the lower electrode 443 and the intermediate electrode 253.

The electrodes of the first detection region and the second detection region are electrically connected in series. Specifically, the upper electrode 331 and the upper electrode 333 are connected in series, and the lower electrode 441 and the lower electrode 443 are connected in series. Alternatively, the intermediate electrode 251 and the intermediate electrode 253 are connected in series.

### [Operations and Effects of Acoustic Transducer 200 according to Eighth Embodiment of Second Aspect]

The acoustic transducer 200 according to the eighth embodiment of the second aspect includes the support substrate (fixed frame) 211 and the vibration plate 220, which is a piezoelectric element fixed to the support substrate 211. The vibration plate 220 includes the first detection regions 323 and 423 and the second detection regions 325 and 425. The first detection regions 323 and 423 are a plurality of detection regions configured to detect a physical quantity, and the second detection regions 325 and 425 are configured not to detect the physical quantity. The electrodes of the plurality of detection regions are electrically connected in series.

In the acoustic transducer 200 according to the embodiments of the second aspect, in response to deformation of the vibration plate 220, the physical quantity can be detected by detecting this deformation of the vibration plate 220. In the acoustic transducer 200, the first detection regions 323 and 423 and the second detection regions 325 and 425 are formed, and the electrodes of the plurality of detection regions are electrically connected in series, and thus the sensitivity of the vibration plate 220 can be increased.

In the acoustic transducer 200, the piezoelectric element is the vibration plate (diaphragm) 220, and the outer circumference (outer circumference of the diaphragm) 222 of the vibration plate 220 is a fixed end that is fixed to the support substrate 211.

In the acoustic transducer 200, the plurality of detection regions include the first detection regions 323 and 423, and the second detection regions 325 and 425. The first detection regions 323 and 423 are inner detection regions disposed closer to the center C11 of the vibration plate 220 in the radial direction of the vibration plate 220. The second detection regions 325 and 425 are outer detection regions disposed farther from the center C11 of the vibration plate 220 in the radial direction of the vibration plate 220. The non-detection regions 324 and 424 are formed between the inner detection regions and the outer detection regions in the circumferential direction of the vibration plate 220.

In the acoustic transducer 200 according to the embodiments of the second aspect, charges are generated in response to deformation of the vibration plate 220, and the charges generated in the first detection regions 323 and 423 and the second detection regions 325 and 425 are detected. In the acoustic transducer 200, the first detection regions 323 and 423, the non-detection regions 324 and 424, and the second detection regions 325 and 425 are formed by dividing the respective electrodes in the radial direction of the vibration plate 220. In this acoustic transducer 200, the sensitivity for detecting charges in response to a sound pressure can be increased.

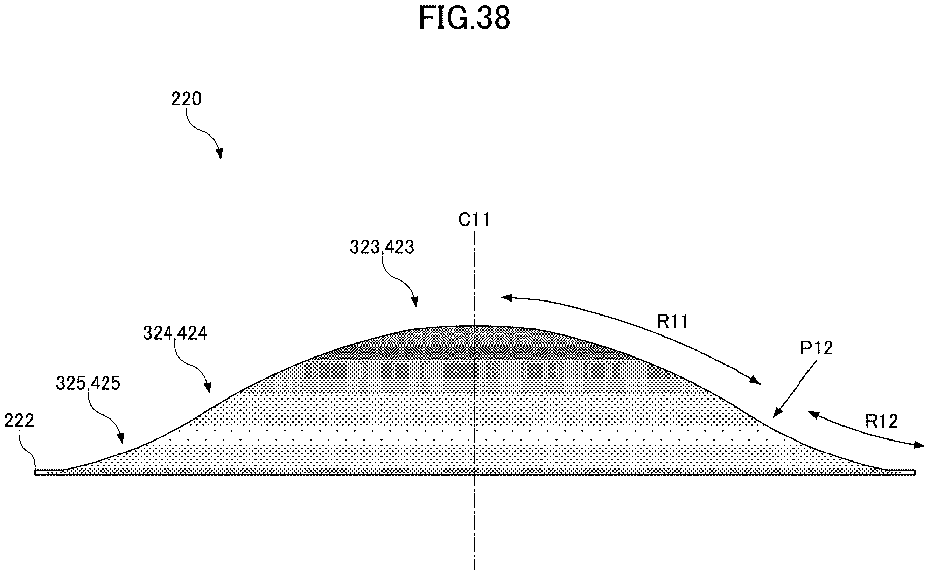

FIG. 38 is a side view illustrating a distribution of charges generated in the vibration plate 220 configured to deform in response to receiving a sound pressure. In the vibration plate 220, which is a diaphragm, the outer circumference 222 in the radial direction is fixed to the support substrate 211. As illustrated in FIG. 38, a region near an inflection point P12 does not readily deform, and the amount of charges generated is small. The inflection point P12 and a region near the inflection point P12, which generate a small amount of charges, are included in the second detection regions 325 and 425.

On the other hand, a region near the center C11 of the vibration plate 220 and a region near the outer circumference 222 of the vibration plate 220 deform greatly, and thus the amount of charges generated in these regions is large. The center C11 of the vibration plate 220 and a region near the center C11 are included in the first detection regions 323 and 423. The region near the outer circumference 222 of the vibration plate 220 is included in the second detection regions 325 and 425. In the acoustic transducer 200, a region including the inflection point P12, at which the amount of charges generated is small, is not included in the first detection regions 323 and 423 and the second detection regions 325 and 425. This can increase the S/N ratio in the acoustic transducer 200, and increase the detection sensitivity of charges.

### [Shapes of Ends of Electrodes]

Next, the shapes of the ends of the electrode will be described. As illustrated in FIG. 37, the ends of the upper electrodes 331 to 333, the ends of the lower electrodes 441 to 443, and the ends of the intermediate electrodes 251 to 253 may be formed to have tapered shapes. The ends of the electrodes are ends facing in the radial direction of the vibration plate 220. The ends of the electrodes having the tapered shapes are formed to project on the lower side beyond on the upper side.

In this manner, when the ends of the lower electrodes 441 to 443 have tapered shapes, it is possible to soften the angle of steps at the boundaries between the lower electrodes 441 to 443 and the electrode-free regions 483 and 484. Therefore, a reduction in crystallinity in the piezoelectric layer 460 can be suppressed. The same applies to the boundaries between the other electrodes and the other electrode-free regions.

### [Acoustic Transducer 200B according to Ninth Embodiment of Second Aspect]

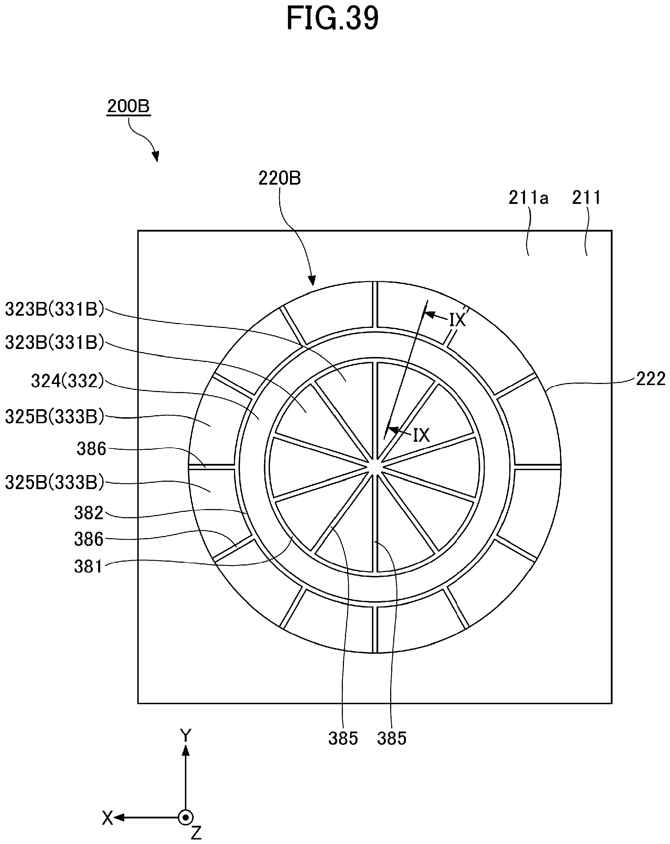

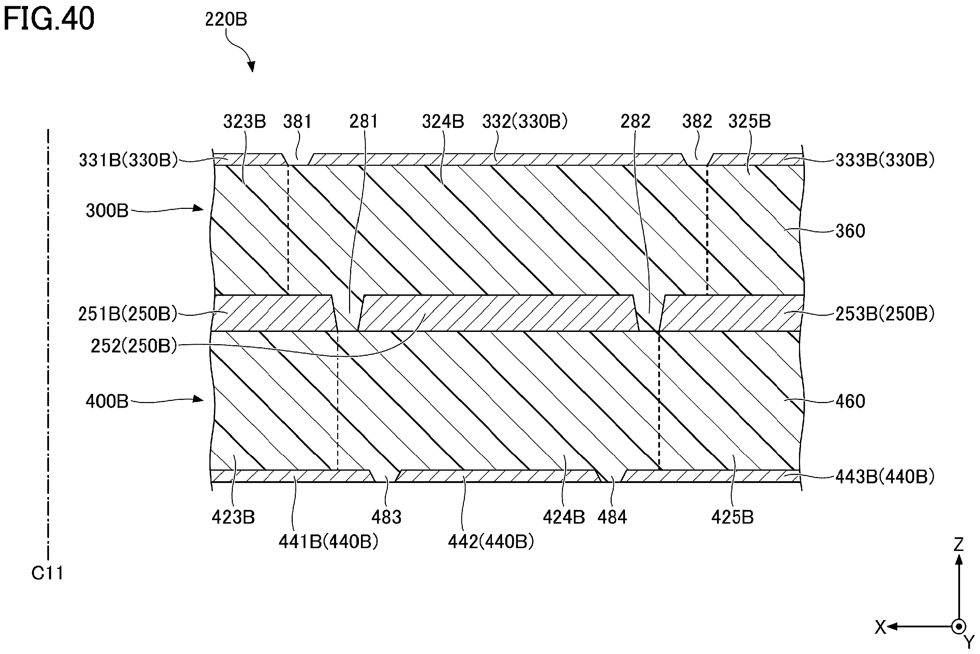

Next, an acoustic transducer 200B according to the ninth embodiment of the second aspect will be described. FIG. 39 is a plan view illustrating the acoustic transducer 200B according to the ninth embodiment of the second aspect. FIG. 40 is a cross-sectional view illustrating the acoustic transducer 200B according to the ninth embodiment of the second aspect, a cross-sectional view of the acoustic transducer taken along line IX-IX in FIG. 39. The acoustic transducer 200B according to the ninth embodiment of the second aspect illustrated in FIGS. 39 and 40 differs from the acoustic transducer 200 according to the eighth embodiment of the second aspect illustrated in FIG. 33 in that the acoustic transducer 200B includes a plurality of upper electrodes 331B and 333B divided in the circumferential direction, a plurality of lower electrodes 441B and 443B divided in the circumferential direction, a plurality of intermediate electrodes 251B and 253B divided in the circumferential direction, and electrode-free regions 385 and 386 extending in the radial direction. In the description of the acoustic transducer 200B according to the ninth embodiment of the second aspect, the same description as that of the acoustic transducer 200 according to the eighth embodiment of the second aspect may be omitted.

### [Stack 300B]

As illustrated in FIG. 40, the acoustic transducer 200B includes stacks 300B and 400B. The stack 300B includes an upper electrode layer 330B, a piezoelectric layer 360, and an intermediate electrode layer 250B. The upper electrode layer 330B includes a plurality of upper electrodes 331B divided in the circumferential direction, the upper electrode 332 continuous in the circumferential direction, and a plurality of upper electrodes 333B divided in the circumferential direction. The intermediate electrode layer 250B includes a plurality of intermediate electrodes 251B divided in the circumferential direction, the intermediate electrode 252 continuous in the circumferential direction, and a plurality of intermediate electrodes 253B divided in the circumferential direction.

### [First Detection Region 323B]

The stack 300B includes a first detection region 323B, a non-detection region 324B, and a second detection region 325B. The first detection region 323B includes a plurality of upper electrodes 331B, the piezoelectric layer 360, and a plurality of intermediate electrodes 251B. The first detection region 323B includes a plurality of piezoelectric elements. In the first detection region 323B, the piezoelectric element includes the upper electrode 331B, the piezoelectric layer 360, and the intermediate electrode 251B.

### [Second Detection Region 325B]

The second detection region 325B includes a plurality of upper electrodes 333B, the piezoelectric layer 360, and a plurality of intermediate electrodes 253B. The second detection region 325B includes a plurality of piezoelectric elements. In the second detection region 325B, the piezoelectric element includes the upper electrode 333B, the piezoelectric layer 360, and the intermediate electrode 253B.

As illustrated in FIG. 39, the electrode-free regions 381 and 383 and the electrode-free regions 385 and 386 are formed in the upper electrode layer 330B.

### [Electrode-Free Region 385]

The electrode-free regions 385 divide the upper electrode into a plurality of upper electrodes in the first detection region 323B. The electrode-free regions 385 extend in the radial direction from the center of a vibration plate 220B. The plurality of electrode-free regions 385 are disposed at equal intervals in the circumferential direction. The areas of the plurality of upper electrodes 331B are substantially equal. The acoustic transducer 200B includes, for example, ten upper electrodes 331B.

### [Electrode-Free Region 386]

The electrode-free regions 386 divide the upper electrode into a plurality of upper electrodes in the second detection region 325B. The electrode-free regions 386 extend in the radial direction from the electrode-free region 382 toward the outer circumference 222 of the vibration plate 220. The plurality of electrode-free regions 386 are disposed at equal intervals in the circumferential direction.

### [Stack 400B]

As illustrated in FIG. 40, the stack 400B includes the intermediate electrode layer 250B, the piezoelectric layer 460, and the lower electrode layer 440B. The intermediate electrode layer 250B is included in both the stack 300B and the stack 400B. The lower electrode layer 440B includes the plurality of lower electrodes 441B divided in the circumferential direction, the lower electrodes 442 continuous in the circumferential direction, and the plurality of lower electrodes 443B divided in the circumferential direction.

### [First Detection Region 423B]

The stack 400B includes a first detection region 423B, a non-detection region 424B, and a second detection region 425B. The first detection region 423B includes the plurality of intermediate electrodes 251B, the piezoelectric layer 460, and the plurality of lower electrodes 441B. The first detection region 423B includes a plurality of piezoelectric elements. In the first detection region 423B, the piezoelectric element includes the intermediate electrode 251B, the piezoelectric layer 460, and the lower electrode 441B. In the first detection region 423B, the areas of the plurality of lower electrodes 441B are substantially equal.

### [Second Detection Region 425B]

The second detection region 425B includes the intermediate electrode 253B, the piezoelectric layer 460, and the plurality of lower electrodes 443B. The second detection region 425B includes a plurality of piezoelectric elements. In the second detection region 425B, the piezoelectric element includes the intermediate electrode 253B, the piezoelectric layer 460, and the lower electrode 443B. In the second detection region 425B, the areas of the plurality of lower electrodes 443B are substantially equal.

Similar to the upper electrode layer 330B of the stack 300B, the lower electrode layer 440B and the intermediate electrode layer 250B of the stack 400B include electrode-free regions extending in the radial direction.

### [Capacitances of Piezoelectric Elements]

In the stack 300B, the capacitances of the plurality of piezoelectric elements disposed along the circumferential direction of the vibration plate 220 are substantially equal. In the stack 400B, the capacitances of the plurality of piezoelectric elements disposed along the circumferential direction of the vibration plate 220 are substantially equal.

### [Connection in Series of Piezoelectric Elements]

In the vibration plate 220B, the plurality of piezoelectric elements disposed along the circumferential direction and the radial direction are electrically connected in series.

### [Operations and Effects of Acoustic Transducer 200B according to Ninth Embodiment of Second Aspect]

The acoustic transducer 200B according to the ninth embodiment of the second aspect exhibits operations and effects similar to those exhibited by the acoustic transducer 200 according to the eighth embodiment of the second aspect.

In the acoustic transducer 200B, the plurality of detection regions include first detection regions 323B and 423B and second detection regions 325B and 425B. The first detection regions 323B and 423B are inner detection regions disposed closer to the center C11 of the vibration plate 220 in the radial direction of the vibration plate 220. The second detection regions 325B and 425B are outer detection regions disposed farther from the center C11 of the vibration plate 220B in the radial direction of the vibration plate 220B. The non-detection regions 324 and 424 include: the electrode-free regions 381 and 382 formed between the inner detection regions and the outer detection regions in the circumferential direction of the vibration plate 220B; and the plurality of electrode-free regions 385 and 386 extending in the radial direction of the diaphragm and formed at intervals in the circumferential direction of the diaphragm.

According to the above acoustic transducer 200B, the electrode-free regions 385 and 386 extending in the radial direction can divide the electrode in the detection regions into a plurality of electrodes.

### [Modified Example of Acoustic Transducer 200B according to Ninth Embodiment of Second Aspect]

In the acoustic transducer 200B, the vibration plate (piezoelectric element) 220B includes a piezoelectric film, and the piezoelectric film includes the lower electrode layer 440B, the lower piezoelectric layer 460 formed over the lower electrode layer 440B, the intermediate electrode layer 250B formed over the lower piezoelectric layer 460, the upper piezoelectric layer 360 formed over the intermediate electrode layer 250, and the upper electrode layer 330 formed over the upper piezoelectric layer 360. Between the plurality of detection regions (the first detection regions 323B and 423B and the second detection regions 325B and 425B), there is an electrode-free region (first electrode-free region) in which the upper electrode and the lower electrode are not formed, or there is an electrode-free region (second electrode-free region) in which the intermediate electrode is not formed.

In the acoustic transducer 200B, when the electrode-free regions (first electrode-free regions) are formed in the upper electrode and the lower electrode, the electrode-free regions (second electrode-free regions) do not necessarily need to be formed in the intermediate electrode. In the acoustic transducer 200B, when the electrode-free regions (second electrode-free regions) are formed in the intermediate electrode, the electrode-free regions (first electrode-free regions) 381, 382, 483, and 484 do not necessarily need to be formed in the upper electrode and the lower electrode.

In the detection region, the upper electrode, the intermediate electrode, and the lower electrode may be divided in the circumferential direction. In the circumferential direction, the divided positions (electrode-free regions) in the upper electrodes may differ from the divided positions in the intermediate electrodes. Similarly, in the circumferential direction, the divided positions in the lower electrodes may differ from the divided positions in the intermediate electrodes.

### [Circuit Diagram of Acoustic Transducer 200B according to Ninth Embodiment of Second Aspect]

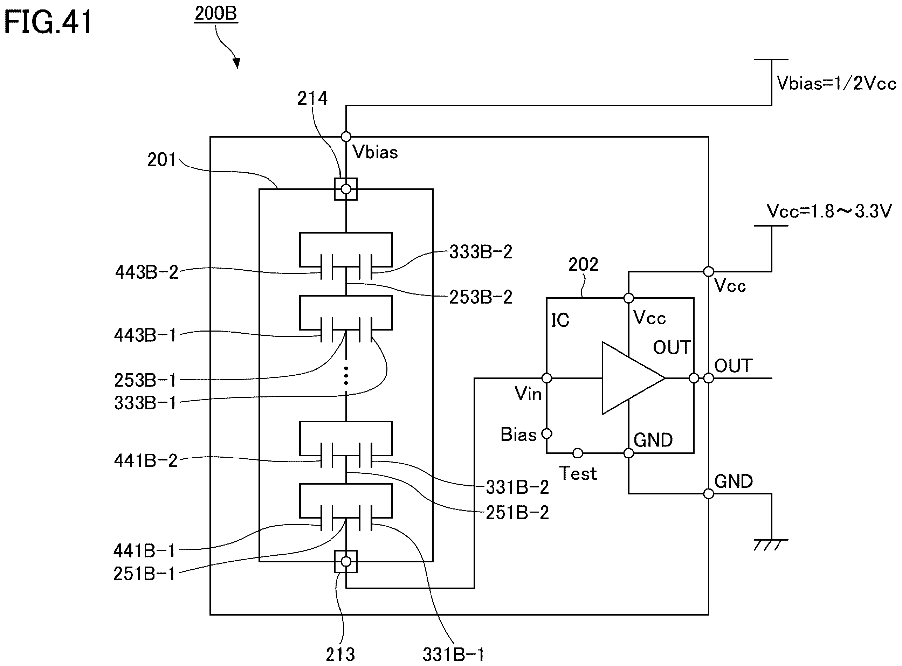

Next, a circuit diagram of the acoustic transducer 200B according to the ninth embodiment of the second aspect will be described. FIG. 41 is a circuit diagram of the acoustic transducer 200B according to the ninth embodiment of the second aspect.

As illustrated in FIG. 41, the acoustic transducer 200B includes an MEMS microphone chip 201. The MEMS microphone chip 201 includes a vibration plate 220B. The vibration plate 220B includes the plurality of first detection regions 323B and 423B and the plurality of second detection regions 325B and 425B.

The plurality of first detection regions 323B and 423B include the upper electrodes 331B, the intermediate electrodes 251B, and the lower electrodes 441B. The plurality of second detection regions 325B and 425B include the upper electrodes 333B, the intermediate electrodes 253B, and the lower electrodes 443B. The upper electrode 331B includes upper electrodes 331B-1, 331B-2, ..., 331B-n divided into the number of n in the circumferential direction. n is a natural number. The same applies to the other upper electrodes, intermediate electrodes, and lower electrodes.

In the first detection regions 323B and 423B of the acoustic transducer 200B, it is possible to detect piezoelectric output charges between the upper electrode 331B and the intermediate electrode 251B and piezoelectric output charges between the intermediate electrode 251B and the lower electrode 441B. The plurality of piezoelectric elements disposed along the circumferential direction are connected in series.

In the second detection regions 325B and 425B of the acoustic transducer 200B, it is possible to detect piezoelectric output charges between the upper electrode 333B and the intermediate electrode 253B and piezoelectric output charges between the intermediate electrode 253B and the lower electrode 443B. The plurality of piezoelectric elements disposed along the circumferential direction are connected in series.

The MEMS microphone chip 201 includes pads 213 and 214. Electrodes of the plurality of piezoelectric elements are connected to the pads 213 and 214. The acoustic transducer 200B includes an IC 202 connected to the pad 213. The IC 202 is an amplifier configured to amplify an output signal of the piezoelectric element of the vibration plate 220B. The IC 202 may be provided with a function of performing analog-to-digital (AD) conversion after amplifying the output signal of the piezoelectric element of the vibration plate 220B.

The polarity of charges generated in the second detection regions 325B and 425B is reversed from the polarity of charges generated in the first detection regions 323B and 423B. Therefore, connection in series is achieved by reversing the interconnects between the second detection regions 325B and 425B and the first detection regions 323B and 423B.

### [Connection of Electrodes]

In the acoustic transducer 200B, the upper electrodes 331B and the intermediate electrodes 251B of the plurality of first detection regions 323B may be electrically connected in series. Similarly, the upper electrodes 333B and the intermediate electrodes 253B of the plurality of second detection regions 325B may be electrically connected in series.

In the acoustic transducer 200B, the lower electrodes 441B and the intermediate electrodes 251B of the plurality of first detection regions 423B may be electrically connected in series. Similarly, the lower electrodes 433B and the intermediate electrodes 253B of the plurality of second detection regions 425B may be electrically connected in series.

In the acoustic transducer 200B, the upper electrode and the lower electrode in each of the plurality of detection regions may be electrically connected in parallel.

### [Relationship between Sensing Area Radius Ratio and Normalized SNR]

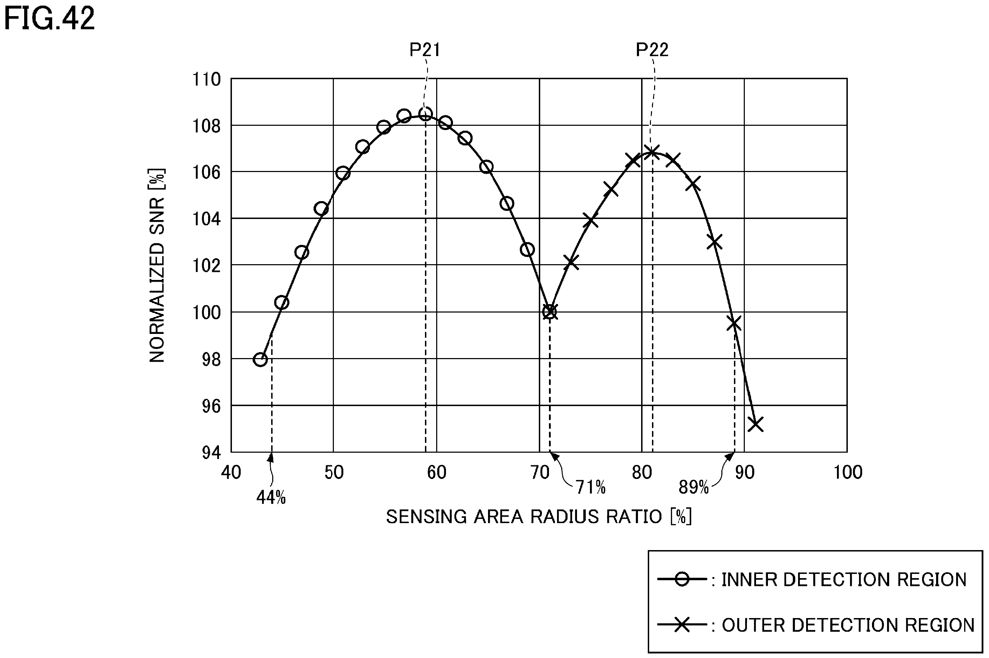

Next, a relationship between the sensing area radius ratio and the normalized SNR will be described. FIG. 42 is a graph illustrating the relationship between the sensing area radius ratio and the normalized SNR in the second aspect. In FIG. 42, the horizontal axis indicates the sensing area radius ratio [%] and the vertical axis indicates the normalized SNR [%]. The graph illustrated in FIG. 42 is a graph illustrating the relationship between the sensing area radius ratio and the normalized SNR in the acoustic transducer 200 according to the eighth embodiment of the second aspect illustrated in FIG. 33.

The "sensing area radius ratio" can be expressed according to the following formula (1). Sensing area radius ratio = (Electrode-divided part radius/Diaphragm radius) × 100 The "electrode-divided part radius" may be the radius of the inner detection region 323. The "diaphragm radius" may be the radius of the vibration plate 220. In FIG. 33, the diameter Φ323 of the inner detection region 323 and the diameter Φ325 of the vibration plate 220 are illustrated.

The inner diameter of the opening 221 covered by the vibration plate 220 is defined as the sensing area radius ratio of 100%. When the electrode-free region formed is 71%, the normalized SNR is defined as 100%. In FIG. 42, "O" indicates the position of the boundary between the inner detection region 323 and the non-detection region 324. In FIG. 42, "X" indicates the position of the boundary between the outer detection region 325 and the non-detection region 324.

The normalized SNR value of the inner detection region 323 is the value obtained when the boundary between the outer detection region 325 and the non-detection region 324 is 71%, and the outer diameter Φ323 of the inner detection region 323 is changed.

The normalized SNR value of the outer detection region 325 is the value obtained when the boundary between the inner detection region 323 and the non-detection region 324 is 71%, and the inner diameter Φ324 of the outer detection region 325 is changed.

In the example illustrated in FIG. 42, the normalized SNR value of the inner detection region 323 becomes the maximum at point P21. The sensing area radius ratio at point P21 is 59%.

In the example illustrated in FIG. 42, the normalized SNR value of the outer detection region 325 becomes the maximum at point P22. The sensing area radius ratio at point P22 is 81%.

When the sensing area radius ratio of the inner detection region 323 is 44% or more and 71% or less, the normalized SNR value is 100% or more. When the sensing area radius ratio of the inner detection region 323 is 49% or more and 67% or less, the normalized SNR value is 104% or more. When the sensing area radius ratio of the inner detection region 323 is 51% or more and 65% or less, the normalized SNR value is 106% or more.

The sensing area radius ratio of the inner detection region 323 is preferably 44% or more and 71% or less, more preferably 49% or more and 67% or less, and further preferably 51% or more and 65% or less.

When the sensing area radius ratio of the outer detection region 325 is 71% or more and 89% or less, the normalized SNR value is 100% or more. When the sensing area radius ratio of the outer detection region 325 is 75% or more and 87% or less, the normalized SNR value is 104% or more. When the sensing area radius ratio of the outer detection region 325 is 78% or more and 84% or less, the normalized SNR value is 106% or more.

The sensing area radius ratio of the outer detection region 325 is preferably 71% or more and 89% or less, more preferably 75% or more and 87% or less, and further preferably 78% or more and 84% or less.

When the sensing area radius ratio of the inner detection region 323 is 71% and the sensing area radius ratio of the outer detection region 325 is 71%, the divided position of the electrode may be at a position of 71%.

In the acoustic transducer 200, when the sensing area radius ratio of the outer detection region 325 is 71% or more and 89% or less, the sensing area radius ratio of the inner detection region 323 may be a value outside the range of 44% or more and 71% or less. In such a case, the normalized SNR value may be high.

In the acoustic transducer 200, when the sensing area radius ratio of the inner detection region 323 is 44% or more and 71% or less, the sensing area radius ratio of the outer detection region 325 may be a value outside the range of 71% or more and 89% or less. In such a case, the normalized SNR value may be high.

### [Acoustic Transducer 100 according to First Embodiment of Third Aspect]

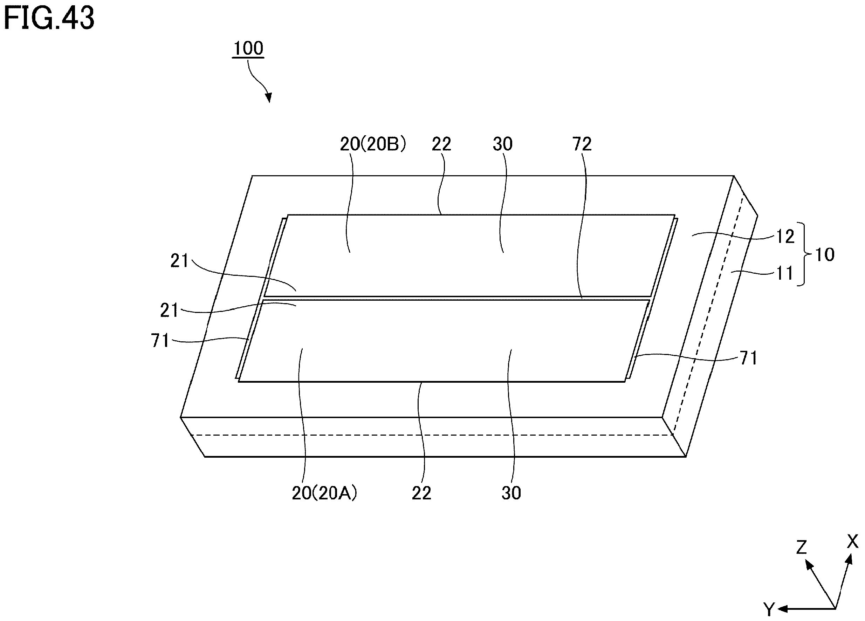

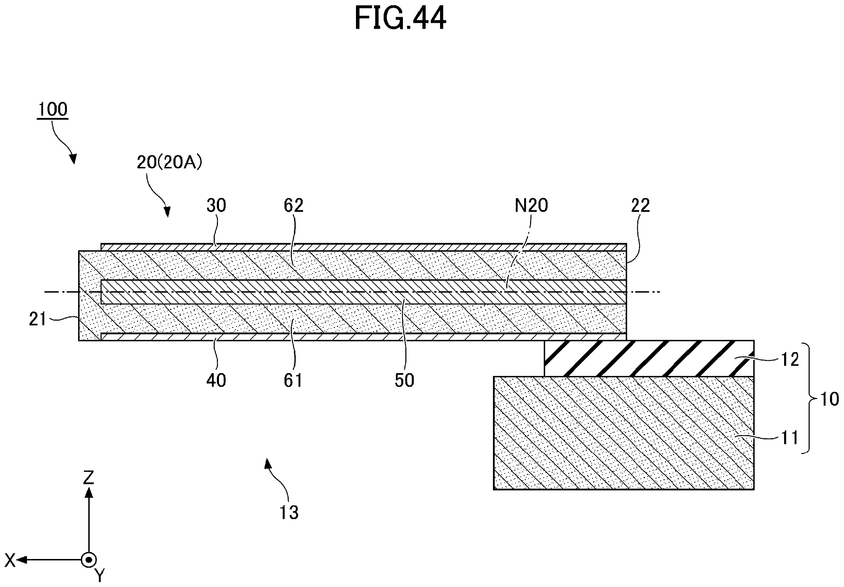

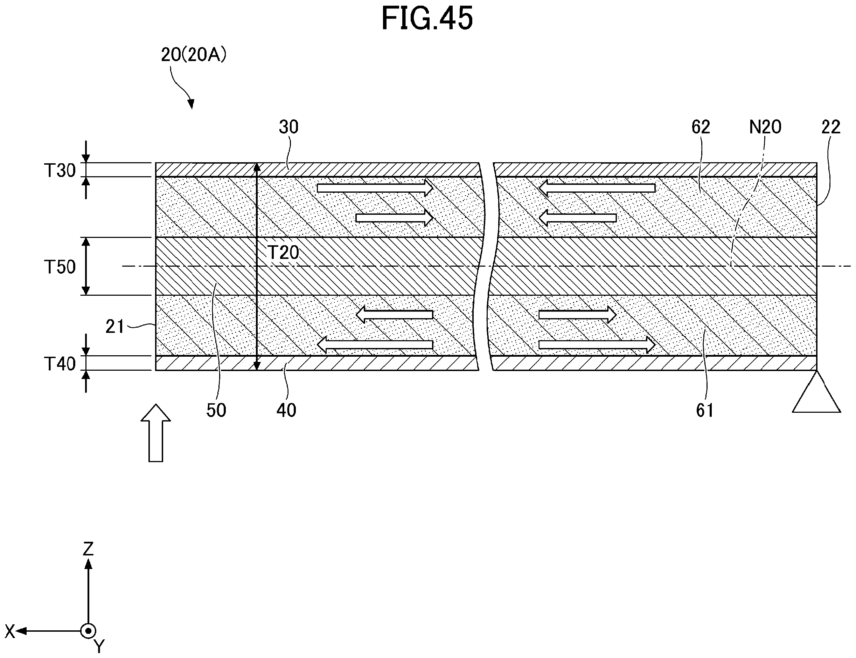

FIG. 43 is a plan view illustrating an acoustic transducer 100 according to the first embodiment of the third aspect. FIG. 44 is a cross-sectional view illustrating the acoustic transducer according to the first embodiment of the third aspect. FIG. 45 is a cross-sectional view illustrating a cantilever 20 (20A) in the third aspect. In the drawings, an X-axis direction, a Y-axis direction, and a Z-axis direction that are orthogonal to each other may be illustrated.

The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a direction crossing the first direction.

The acoustic transducer 100 illustrated in FIGS. 43 and 44 is a piezoelectric acoustic transducer including a piezoelectric element (piezoelectric film). The acoustic transducer 100 may be, for example, a microphone (MEMS microphone). The acoustic transducer 100 may be used for noise cancellation. The acoustic transducer 100 may be a true wireless stereo (TWS) or may be an in-vehicle device mounted on an automobile. The acoustic transducer 100 may be used, for example, as a hearing aid. As long as the acoustic transducer 100 is configured to detect a physical quantity, no particular limitation is imposed on the use of the acoustic transducer 100. The physical quantity may be, for example, a sound pressure.

### [Fixed Frame 10]

The acoustic transducer 100 includes a fixed frame 10 and a pair of cantilevers 20. The fixed frame 10 is a frame having a rectangular shape as viewed in the Z-axis direction. The length of the fixed frame 10 in the X-axis direction is shorter than the length of the fixed frame 10 in the Y-axis direction. The fixed frame 10 includes a substrate 11 and an insulating film 12. The insulating film 12 is formed over the substrate 11. As illustrated in FIG. 44, a cavity (opening) 13 is formed in the substrate 11. The cavity 13 is formed to penetrate through the substrate 11 in the Z-axis direction. The insulating film 12 covers the top of the substrate 11. The insulating film 12 is disposed between the substrate 11 and the cantilever 20 in the Z-axis direction.

### [Cantilevers 20]

The pair of cantilevers 20 each include a piezoelectric film. The cantilevers 20 each project from the fixed frame 10 inward of the fixed frame 10 in the X-axis direction. One end of each of the cantilevers 20 is a fixed end 22, and the other end is a free end 21.

The pair of cantilevers 20 include cantilevers 20A and 20B disposed to face each other in the X-axis direction. The cantilever 20A is an example of a first cantilever, and the cantilever 20B is an example of a second cantilever. The free ends 21 of the pair of cantilevers 20 face each other.

As illustrated in FIG. 43, a pair of slits 71 and a slit 72 are formed around the cantilevers 20A and 20B. The slits 71 are gaps formed between the fixed frame 10 and the cantilevers 20, and penetrate through the substrate in the Z-axis direction. The pair of slits 71 extend in the X-axis direction, and are formed apart from each other in the Y-axis direction. The slit 72 is a gap formed between the free ends 21 facing each other. The fixed end 22 of the cantilever 20 is connected to the fixed frame 10. The widths of the slits 71 and 72 may be, for example, 100 nanometers (nm) or more and 5 micrometers (µm) or less. The widths of the slits 71 and 72 may be, for example, 0.5 µm.

FIG. 44 illustrates a cross section of the cantilever 20 (20A) and the fixed frame 10 along the XZ plane. FIG. 45 illustrates a cross section of the cantilever 20 (20A) along the XZ plane. As illustrated in FIG. 44, the piezoelectric film of the cantilever 20 includes the lower electrode 40, a first piezoelectric layer 61, an intermediate electrode 50, a second piezoelectric layer 62, and an upper electrode 30.

### [Lower Electrode 40]

The lower electrode 40 is a thin electrode film. The lower electrode 40 is formed over the bottom of the cantilever 20. The lower electrode 40 is formed to be continuous in the X-axis direction.

### [First Piezoelectric Layer 61]

The first piezoelectric layer 61 is a piezoelectric thin film, and is formed over the lower electrode 40. The first piezoelectric layer 61 is formed to be continuous in the X-axis direction and the Y-axis direction.

### [Intermediate Electrode 50]

The intermediate electrode 50 is a thin electrode film, and is formed over the first piezoelectric layer 61. The intermediate electrode 50 is formed to be continuous in the X-axis direction and the Y-axis direction. A thickness T50 of the intermediate electrode 50 will be described below.

### [Second Piezoelectric Layer 62]

The second piezoelectric layer 62 is a piezoelectric thin film, and is formed over the intermediate electrode 50. The second piezoelectric layer 62 is formed to be continuous in the X-axis direction and the Y-axis direction.

### [Upper Electrode 30]

The upper electrode 30 is a thin electrode film, and is formed over the second piezoelectric layer 62. The upper electrode 30 is formed to be continuous in the X-axis direction and the Y-axis direction.

The upper electrode 30 and the lower electrode 40 are disposed apart from each other in the Z-axis direction. The intermediate electrode 50 is disposed between the lower electrode 40 and the upper electrode 30 in the Z-axis direction. The first piezoelectric layer 61 is sandwiched between the lower electrode 40 and the intermediate electrode 50 in the Z-axis direction. The second piezoelectric layer 62 is sandwiched between the intermediate electrode 50 and the upper electrode 30 in the Z-axis direction.

### [Material and Thickness of Piezoelectric Thin Film]

The materials of the first piezoelectric layer 61 and the second piezoelectric layer 62 may be, for example, ScAlN. The material of the first piezoelectric layer 61 may be AlN. The Sc may be 0 atomic % (at%) or more and 50 atomic % (at%) or less. The thicknesses of the first piezoelectric layer 61 and the second piezoelectric layer 62 may be, for example, 100 nm or more and 1 µm or less. The thicknesses of the first piezoelectric layer 61 and the second piezoelectric layer 62 may be, for example, 500 nm. The thicknesses of the first piezoelectric layer 61 and the second piezoelectric layer 62 may be equal. The thicknesses of the first piezoelectric layer 61 and the second piezoelectric layer 62 may be different.

The first piezoelectric layer 61 and the second piezoelectric layer 62 may be a fluorite structure (hafnium oxide, zirconium oxide, or cesium oxide) or may be a wurtzite structure (zinc oxide). The materials of the first piezoelectric layer 61 and the second piezoelectric layer 62 may be the same. The materials of the first piezoelectric layer 61 and the second piezoelectric layer 62 may be different.

### [Material of Thin Electrode Film]

The materials of the upper electrode 30, the lower electrode 40, and the intermediate electrode 50 may be Al, Mo, Pt, Ti, or the like. The materials of the upper electrode 30 and the lower electrode 40 may be the same. The materials of the upper electrode 30 and the lower electrode 40 may be different.

### [Thickness of Thin Electrode Film]

The thickness T50 of the intermediate electrode 50 illustrated in FIG. 45 is larger than a thickness T30 of the upper electrode 30 or a thickness T40 of the lower electrode 40. The thickness T50 of the intermediate electrode 50 is larger than the thickness T30 of the upper electrode 30. The thickness T50 of the intermediate electrode 50 is larger than the thickness T40 of the lower electrode 40. The thickness T30 of the upper electrode 30 may be the same as the thickness T40 of the lower electrode 40. The thickness T30 of the upper electrode 30 is the thickness of the upper electrode 30 along the Z-axis direction. The thickness T40 of the lower electrode 40 is the thickness of the lower electrode 40 along the Z-axis direction. The thickness T50 of the intermediate electrode 50 is the thickness of the intermediate electrode 50 along the Z-axis direction. The thickness T30 of the upper electrode 30 and the thickness T40 of the lower electrode 40 may be different.

The thickness T30 of the upper electrode 30 and the thickness T40 of the lower electrode 40 may be, for example, 5 nm or more and 100 nm or less. The thickness T30 of the upper electrode 30 and the thickness T40 of the lower electrode 40 may be, for example, 50 nm. The thickness T50 of the intermediate electrode 50 may be, for example, 10 nm or more and 1,000 nm or less. The thickness T50 of the intermediate electrode 50 may be, for example, 100 nm. The thickness T50 of the intermediate electrode 50 may be larger than the total of the thickness T30 of the upper electrode 30 and the thickness T40 of the lower electrode 40.

### [Ratio of Thickness T50 of Intermediate Electrode 50 to Thickness T20 of Cantilever 20]

The thickness T50 of the intermediate electrode 50 may be 10% or more and 90% or less of the thickness T20 of the cantilever 20. The thickness T20 of the cantilever 20 is the thickness of the cantilever 20 along the Z-axis direction. The thickness T20 of the cantilever 20 is the total thickness of the thickness T40 of the lower electrode 40, the thickness of the first piezoelectric layer 61, the thickness T50 of the intermediate electrode 50, the thickness of the second piezoelectric layer 62, and the thickness T30 of the upper electrode 30. The thickness T50 of the intermediate electrode 50 may be 30% or more and 70% or less of the thickness T20 of the cantilever 20. The thickness T50 of the intermediate electrode 50 may be 40% or more and 60% or less of the thickness T20 of the cantilever 20. The thickness T20 of the intermediate electrode 50 is larger than the thickness T30 of the upper electrode 30 or the thickness T40 of the lower electrode 40, as described above.

### [Neutral Plane N20]

The intermediate electrode 50 is disposed at a position including the neutral plane N20. The cantilever 20 may include the neutral plane N20. The neutral plane N20 may be a plane without generation of a tensile force or a compressive force in the lengthwise direction of the cantilever. These forces are generated in an interior of the cantilever 20, for example, when the cantilever 20 bends. The cantilever 20 bends, for example, in response to receiving a sound pressure. The free end 21 of the cantilever 20 is displaced relative to the fixed end 22 in the Z-axis direction.

For example, when the cantilever 20 receives a sound pressure applied upward in the Z-axis direction, the free end 21 is displaced upward, and the cantilever 20 bends. At this time, a tensile force is generated in the first piezoelectric layer 61 on the lower side of the intermediate electrode 50, and a compressive force is generated in the second piezoelectric layer 62 on the upper side of the intermediate electrode 50. The magnitudes of the tensile force and compressive force differ from position to position in the Z-axis direction. The tensile force at a position near the lower electrode 40 is larger than the tensile force at a position near the intermediate electrode 50. The compressive force at a position near the upper electrode 30 is larger than the compressive force at a position near the intermediate electrode 50.

The neutral plane N20 is located near the center of the cantilever 20 in the thickness direction. The neutral plane N20 is an imaginary plane along the XY plane in a state in which the cantilever 20 does not bend. The intermediate electrode 50 is disposed at a position including the neutral plane N20. The center of the intermediate electrode 50 in the Z-axis direction may be located on the neutral plane N20. When the thickness of the first piezoelectric layer 61 and the thickness of the second piezoelectric layer 62 are the same, the thickness T30 of the upper electrode 30 and the thickness T40 of the lower electrode 40 are the same, the material of the first piezoelectric layer 61 and the material of the second piezoelectric layer 62 are the same, and the material of the upper electrode 30 and the material of the lower electrode 40 are the same, the neutral plane N20 is located at the center of the cantilever 20 in the thickness direction. The neutral plane N20 does not necessarily need to be located at the center of the cantilever 20 in the thickness direction. The neutral plane N20 is located at a position other than the center of the cantilever 20 in the thickness direction, depending on the difference in the thickness between the first piezoelectric layer 61 and the second piezoelectric layer 62, the difference in the material between the first piezoelectric layer 61 and the second piezoelectric layer 62, the difference between the thickness T30 of the upper electrode 30 and the thickness T40 of the lower electrode 40, and the difference in the material between the upper electrode 30 and the lower electrode 40.

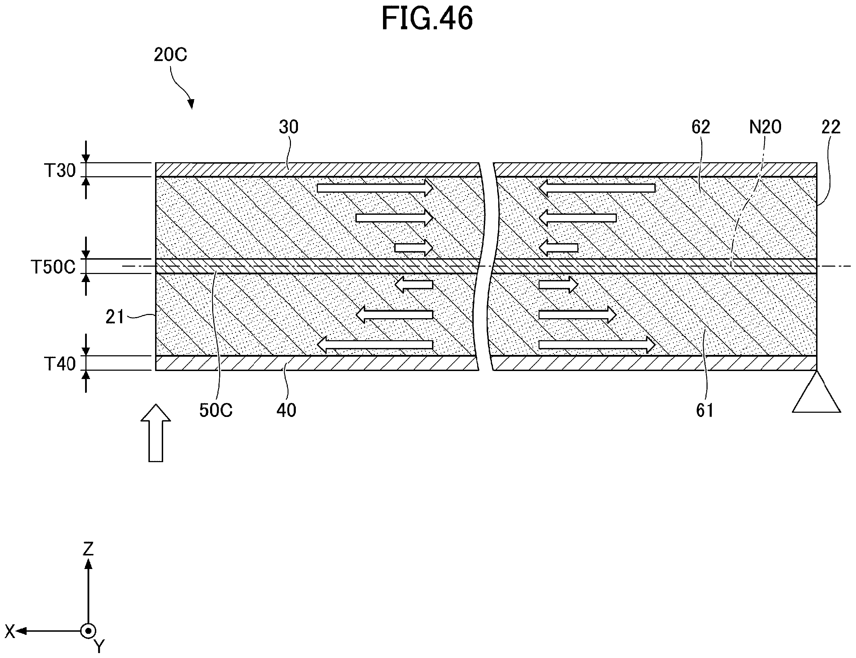

[Cantilever 20C of Acoustic Transducer according to Comparative Example in Third Embodiment] Next, a cantilever 20C of an acoustic transducer according to a Comparative Example will be described with reference to FIG. 46. FIG. 46 is a cross-sectional view illustrating the cantilever 20C according to the Comparative Example in the third aspect. In the cantilever 20C according to the Comparative Example, the thickness T30 of the upper electrode 30, the thickness T40 of the lower electrode 40, and the thickness T50C of the intermediate electrode 50C are the same.

When the cantilever 20C bends by application of a sound pressure to the cantilever 20C, a compressive force and a tensile force are applied to the first piezoelectric layer 61 and the second piezoelectric layer 62. The magnitudes of the tensile force and the compressive force differ from position to position in the Z-axis direction. The tensile force at a position near the lower electrode 40 is larger than the tensile force at a position near the intermediate electrode 50. The compressive force at a position near the upper electrode 30 is larger than the compressive force at a position near the intermediate electrode 50.

### [Relationship between Thickness Ratio of Intermediate Electrode 50 and Voltage]

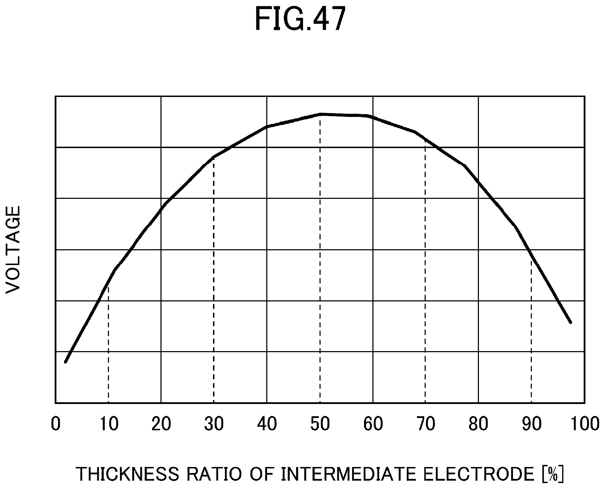

Next, a relationship between a thickness ratio of the intermediate electrode 50 of the acoustic transducer 100 according to the first embodiment of the third aspect, and a voltage will be described with reference to FIG. 47. FIG. 47 is a graph illustrating the relationship between the thickness ratio of the intermediate electrode 50 and the voltage in the third aspect. In FIG. 47, the horizontal axis indicates the thickness ratio [%] of the intermediate electrode 50, and the vertical axis indicates the voltage. The thickness ratio of the intermediate electrode 50 is a ratio of the thickness T50 of the intermediate electrode 50 to the thickness T20 of the cantilever 20. The voltage indicated on the vertical axis is a voltage generated by a piezoelectric effect in the first piezoelectric layer 61 and the second piezoelectric layer 62. The graph illustrated in FIG. 47 may be, for example, a result of calculation performed on the acoustic transducer 100. The shape of the graph varies, for example, with the material, structure, shape, and circuit configuration of the cantilever 20. For example, the voltage generated when the thickness ratio of the intermediate electrode 50 is 40% or more and 60% or less is higher than the voltage generated when the thickness ratio is 20% or less or when the thickness ratio is 80% or more.

### [Shape of Cantilever 20]

As described above, the shape of the cantilever 20 is rectangular as viewed in the Z-axis direction. When the cantilever 20 is rectangular, the area of the cantilever 20 in the chip can be increased compared to when the cantilever 20 is circular, and thus the cantilever 20 can be increased in sensitivity. In other words, the acoustic transducer 100 can be reduced in size compared to an existing acoustic transducer having a size the same as that of the acoustic transducer 100. The acoustic transducer 100 can be reduced in size and thus can be reduced in cost.

### [Overall Length of Cantilever 20]

In the acoustic transducer 100, the resonance frequency of the cantilever 20 can be readily changed by changing the overall length of the cantilever 20. The resonance frequency can be lowered by increasing the overall length of the cantilever 20 at the time of design. The resonance frequency when the overall length of the cantilever 20 is long is lower than the resonance frequency when the overall length of the cantilever 20 is short. The overall length of the cantilever 20 may be the length of a region in which the upper electrode 30, the lower electrode 40, and the intermediate electrode 50 overlap with each other.

### [Width of Cantilever 20]

The width of the cantilever 20 is the width of the cantilever 20 along the Y-axis direction. The width of the cantilever 20 may be the width of a region in which the upper electrode 30, the lower electrode 40, and the intermediate electrode 50 overlap with each other. In the acoustic transducer 100, by changing the width of the cantilever 20, the cantilever 20 can be changed in sensitivity regardless of the resonance frequency. The sensitivity can be increased by increasing the width of the cantilever 20 at the time of design. The sensitivity when the width of the cantilever 20 is large is higher than the sensitivity when the width of the cantilever 20 is small.

### [Operations and Effects of Acoustic Transducer 100 according to First Embodiment of Third Aspect]

The acoustic transducer 100 according to the first embodiment of the third aspect includes the fixed frame 10 and the cantilever 20. The cantilever 20 includes the fixed end 22 and the free end 21, and projects from the fixed frame 10 inward of the fixed frame 10. The fixed end 22 is one end of the cantilever 20 fixed to the fixed frame 10, and the free end 21 is the other end of the cantilever 20. The cantilever 20 includes the lower electrode 40, the first piezoelectric layer 61 formed over the lower electrode 40, the intermediate electrode 50 formed over the first piezoelectric layer 61, the second piezoelectric layer 62 formed over the intermediate electrode 50, and the upper electrode 30 formed over the second piezoelectric layer 62. The thickness T50 of the intermediate electrode 50 is larger than the thickness T30 of the upper electrode 30 or the thickness T40 of the lower electrode 40.

In response to deformation of the cantilever 20 in receipt of a sound pressure, piezoelectric output charges are generated in the first piezoelectric layer 61 and the second piezoelectric layer 62, the acoustic transducer 100 can detect the generated piezoelectric output charges. According to the acoustic transducer 100, it is possible to dispose a part of the first piezoelectric layer 61 and the second piezoelectric layer 62 in a region in which a larger amount of a tensile force or a compressive force is generated when the cantilever 20 bends. In addition, it is possible to dispose the intermediate electrode 50 in a region in which a smaller amount of a tensile force or a compressive force is generated when the cantilever 20 bends.

Also, the acoustic transducer 100 is a piezoelectric acoustic transducer, and is more resistant to dust and water droplets than existing electrostatic acoustic transducers.

Also, the acoustic transducer 100 has a rectangular shape, and thus the area of the cantilever 20 in a chip can be increased, and the sensitivity can be increased. The acoustic transducer 100 is configured to be increased in sensitivity, and thus the acoustic transducer 100 can be reduced in size. In the acoustic transducer 100, the resonance frequency can be readily changed by changing the length of the cantilever 20. In the acoustic transducer 100, by changing a width W20 of a detection region 23, the sensitivity can be changed regardless of the resonance frequency.

### [Acoustic Transducer 100B according to Second Embodiment of Third Aspect]

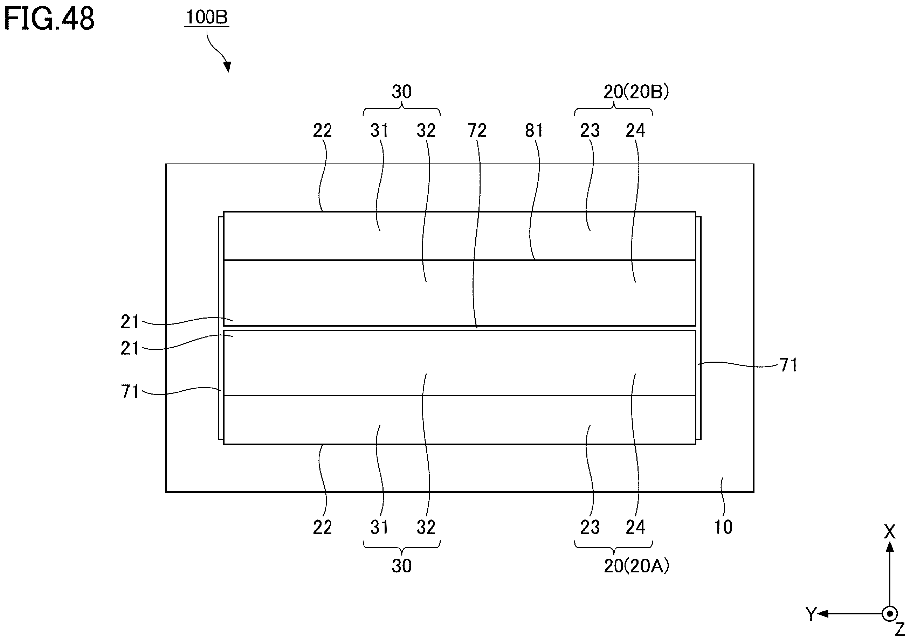

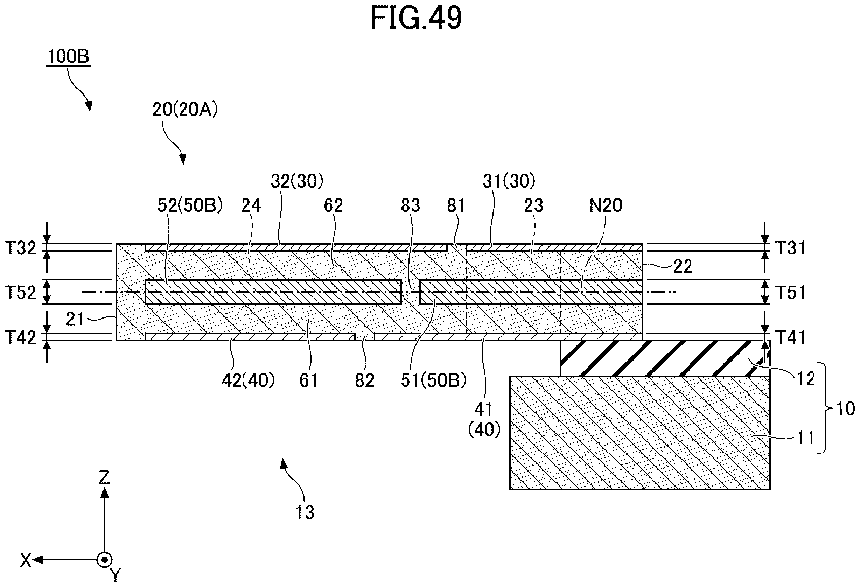

Next, an acoustic transducer 100B according to the second embodiment of the third aspect will be described. FIG. 48 is a plan view illustrating the acoustic transducer 100B according to the second embodiment of the third aspect. FIG. 49 is a cross-sectional view illustrating the acoustic transducer 100B according to the second embodiment of the third aspect. The acoustic transducer 100B according to the second embodiment of the third aspect illustrated in FIGS. 48 and 49 differs from the acoustic transducer 100 according to the first embodiment of the third aspect illustrated in FIGS. 43 and 44 in that the cantilever 20 includes a detection region 23 and a non-detection region 24; specifically, the upper electrode 30, the lower electrode 40, and the intermediate electrode 50 are each divided in the X-axis direction. In the description of the acoustic transducer 100B according to the second embodiment of the third aspect, the same description as that of the acoustic transducer 100 according to the first embodiment of the third aspect may be omitted.

### [Lower Electrode 40]

The lower electrode 40 is a thin electrode film, and includes a first lower electrode 41 and a second lower electrode 42. The first lower electrode 41 and the second lower electrode 42 are disposed apart from each other in the X-axis direction. Between the first lower electrode 41 and the second lower electrode 42, there is an electrode-free region 82 in which no electrode is formed. After the lower electrode 40 is formed, the electrode is removed through etching, thereby forming the electrode-free region 82. The electrode-free region 82 may be formed by the lift-off method.

The first lower electrode 41 is formed closer to the fixed end 22 in the X-axis direction. The second lower electrode 42 is formed closer to the free end 21 in the X-axis direction.

### [Intermediate Electrode 50]

The intermediate electrode 50 is a thin electrode film, and includes a first intermediate electrode 51 and a second intermediate electrode 52. The first intermediate electrode 51 and the second intermediate electrode 52 are disposed apart from each other in the X-axis direction. Between the first intermediate electrode 51 and the second intermediate electrode 52, there is an electrode-free region 83 in which no electrode is formed. After the intermediate electrode 50 is formed, the electrode is removed through etching, thereby forming the electrode-free region 83. The electrode-free region 83 may be formed by the lift-off method.

The first intermediate electrode 51 is formed closer to the fixed end 22 in the X-axis direction. The second intermediate electrode 52 is formed closer to the free end 21 in the X-axis direction.

### [Upper Electrode 30]

The upper electrode 30 is a thin electrode film, and includes a first upper electrode 31 and a second upper electrode 32. The first upper electrode 31 and the second upper electrode 32 are disposed apart from each other in the X-axis direction. Between the first upper electrode 31 and the second upper electrode 32, there is an electrode-free region 81 in which no electrode is formed. After the upper electrode 30 is formed, the electrode is removed through etching, thereby forming the electrode-free region 81. The electrode-free region 81 may be formed by the lift-off method.

The first upper electrode 31 is formed closer to the fixed end 22 in the X-axis direction. The second upper electrode 32 is formed closer to the free end 21 in the X-axis direction.

### [Detection Region 23 and Non-Detection Region 24]

The cantilever 20 includes the detection region 23 configured to detect a physical quantity, and the non-detection region 24 configured not to detect the physical quantity. The physical quantity is, for example, a sound pressure. The detection region 23 may be a region in which the first upper electrode 31, the first intermediate electrode 51, and the first piezoelectric layer 61 are stacked in the Z-axis direction. The first upper electrode 31 and the first lower electrode 41 are electrically connected. The acoustic transducer 100 can detect piezoelectric output charges between the first upper electrode 31 and the first intermediate electrode 51. The acoustic transducer 100 can detect piezoelectric output charges between the first lower electrode 41 and the first intermediate electrode 51.

The detection region 23 is disposed closer to the fixed end 22 than is the non-detection region 24. In other words, the non-detection region 24 is disposed closer to the free end 21 than is the detection region 23.

The non-detection region 24 is a region of the cantilever 20, the region excluding the detection region 23. The second upper electrode 32, the second intermediate electrode 52, and the second lower electrode 42 are not electrically connected.

### [Thickness of Thin Electrode Film]

A thickness T51 of the first intermediate electrode 51 is larger than a thickness T31 of the first upper electrode 31 or a thickness T41 of the first lower electrode 41. The thickness T51 of the first intermediate electrode 51 is larger than the thickness T31 of the first upper electrode 31. The thickness T51 of the first intermediate electrode 51 is larger than the thickness T41 of the first lower electrode 41. The thickness T31 of the first upper electrode 31 may be the same as the thickness T41 of the first lower electrode 41.

A thickness T52 of the second intermediate electrode 52 is larger than a thickness T32 of the second upper electrode 32 or a thickness T42 of the second lower electrode 42. The thickness T52 of the second intermediate electrode 52 is larger than the thickness T32 of the second upper electrode 32. The thickness T52 of the second intermediate electrode 52 is larger than the thickness T42 of the second lower electrode 42. The thickness T32 of the second upper electrode 32 may be the same as the thickness T42 of the second lower electrode 42.

### [Shapes of Ends of Electrodes]

The ends of the electrodes in the X-axis direction may be formed to have tapered shapes. The electrodes include the upper electrode 30, the lower electrode 40, and the intermediate electrode 50. The thickness of the end of each electrode in the X-axis direction may be smaller than the thickness of the center of the electrode in the X-axis direction. The end of the electrode may be formed to have an acute angle. The tapered shape may be tilted such that the lower end is disposed outward of the upper end in the X-axis direction.

The ends of the electrodes may be disposed inward of the free end 21 in the X-axis direction. The first piezoelectric layer 61 and the second piezoelectric layer 62 may be formed outward of the ends of the electrodes in the X-axis direction. The first piezoelectric layer 61 and the second piezoelectric layer 62 may be connected in the Z-axis direction in a region outward of the ends of the electrodes. As described above, the tapered ends of the electrodes can suppress a reduction in crystallinity of the first piezoelectric layer 61 and the second piezoelectric layer 62. Therefore, charges can be stably generated in the first piezoelectric layer 61 and the second piezoelectric layer 62.

### [Operations and Effects of Acoustic Transducer 100B according to Second Embodiment of Third Aspect]

The acoustic transducer 100B according to the second embodiment of the third aspect exhibits operations and effects similar to those exhibited by the acoustic transducer 100 according to the first embodiment of the third aspect. In the acoustic transducer 100B according to the second embodiment of the third aspect, the electrodes are divided in the lengthwise direction (X-axis direction) of the cantilever 20, thereby forming the detection region 23 and the non-detection region 24, and enabling increasing the sensitivity.

Also, in the acoustic transducer 100, the cantilever 20 includes a piezoelectric film, and the piezoelectric film includes the lower electrode 40, the first piezoelectric layer 61 formed over the lower electrode 40, the intermediate electrode 50 formed over the first piezoelectric layer 61, the second piezoelectric layer 62 formed over the intermediate electrode 50, and the upper electrode 30 formed over the second piezoelectric layer 62. The electrode-free regions 82, 83, and 81, in which at least one electrode of the lower electrode 40, the intermediate electrode 50, or the upper electrode 30 is not formed, are included between the detection region 23 and the non-detection region 24.

In the acoustic transducer 100 with this configuration, in response to deformation of the cantilever 20, which is a piezoelectric film, piezoelectric output charges generated between the first upper electrode 31 and the first intermediate electrode 51 in the detection region 23 and piezoelectric output charges generated between the first lower electrode 41 and the first intermediate electrode 51 in the detection region 23 are connected to the first intermediate electrode 51. In the acoustic transducer 100, by forming the electrode-free region 82, 83, or 81, in which no electrode is formed, in at least one electrode of the lower electrode 40, the intermediate electrode 50, or the upper electrode 30, it is possible to divide the detection region 23 and the non-detection region 24.

### [Acoustic Transducer 200 according to Third Embodiment of Third Aspect]

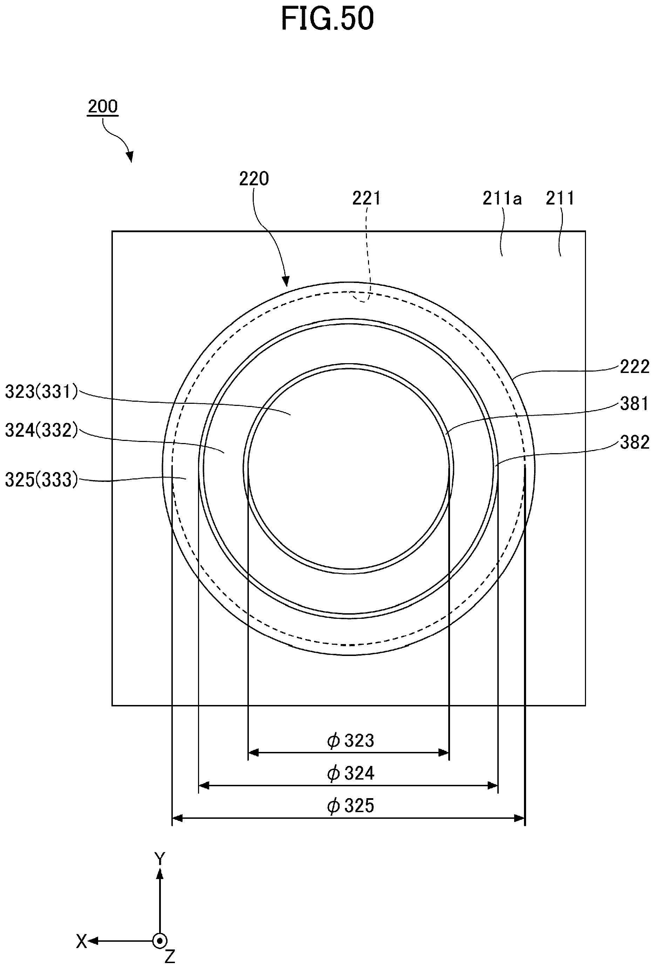

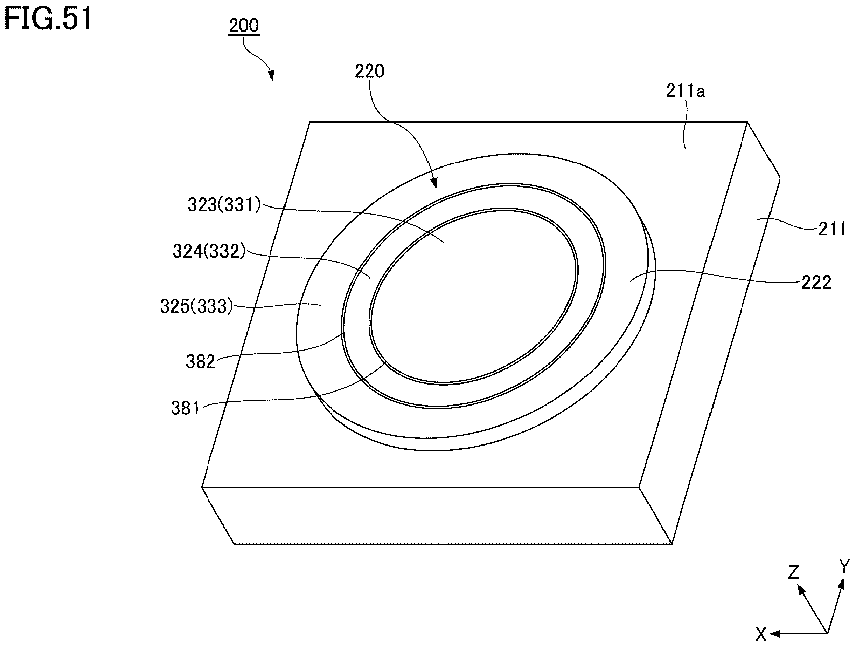

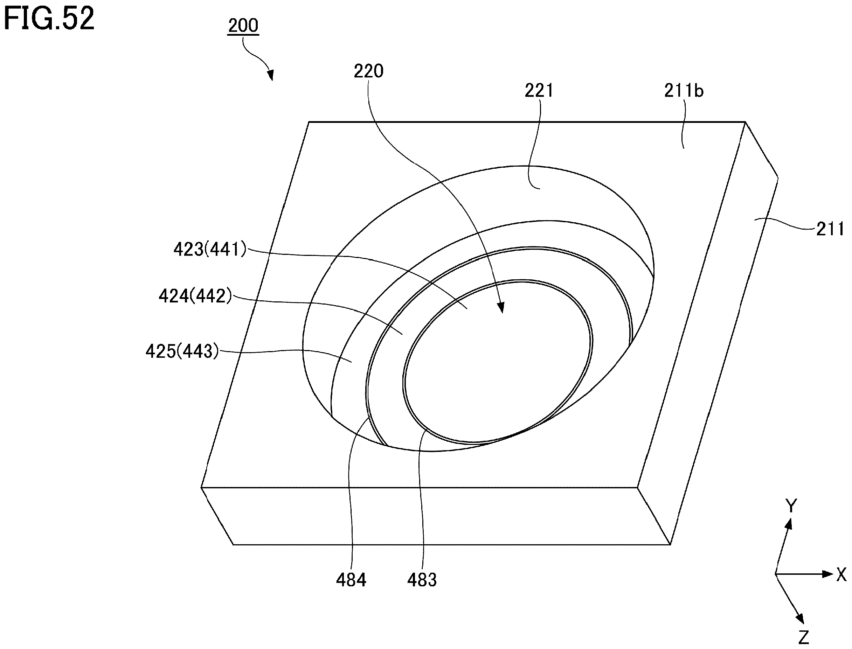

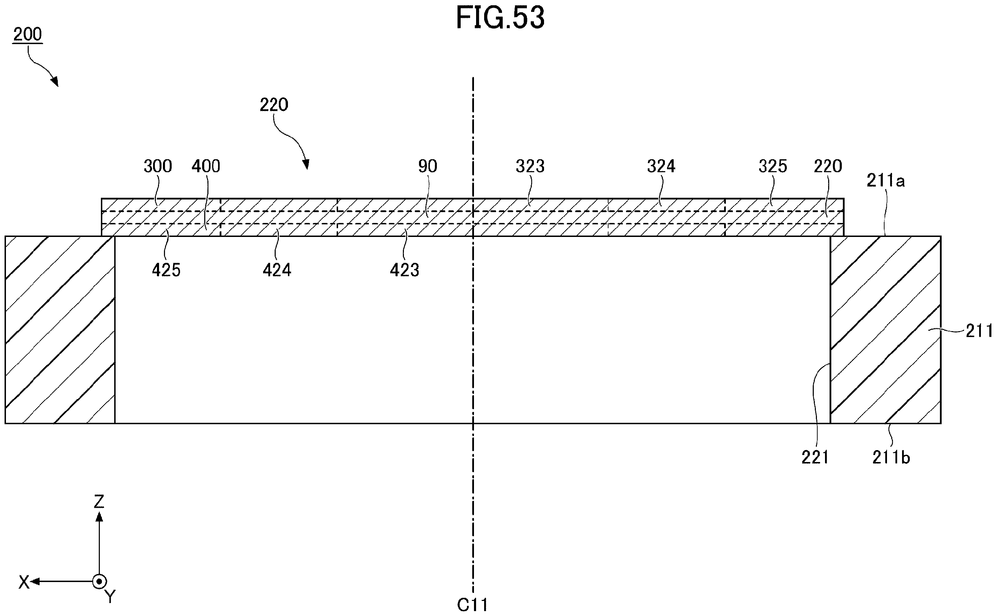

Next, an acoustic transducer 200 according to the third embodiment of the third aspect will be described. FIG. 50 is a plan view illustrating the acoustic transducer 200 according to the third embodiment of the third aspect. FIG. 51 is a perspective view illustrating the acoustic transducer 200 according to the third embodiment of the third aspect. FIG. 52 is a perspective view illustrating, from the bottom, the acoustic transducer 200 according to the third embodiment of the third aspect. FIG. 53 is a cross-sectional view illustrating the acoustic transducer 200 according to the third embodiment of the third aspect. In the drawings, an X-axis direction, a Y-axis direction, and a Z-axis direction that are orthogonal to each other may be illustrated. The X-axis direction, the Y-axis direction, and the Z-axis direction do not necessarily need to be orthogonal to each other. The X-axis direction, the Y-axis direction, and the Z-axis direction may be any directions. The X-axis direction is an example of a first direction. The Y-axis direction is an example of a direction crossing the first direction. In the description of the acoustic transducer 200 according to the third embodiment of the third aspect, the same description as that of the acoustic transducer 100 according to the embodiments of the third aspect may be omitted.

### [Support Substrate 211]

The acoustic transducer 200 includes a support substrate (fixed frame) 211 and a vibration plate (piezoelectric element) 220. The support substrate 211 may be rectangular as viewed in the Z-axis direction. The plate thickness direction of the support substrate 211 is along the Z-axis direction. The support substrate 211 includes an upper surface 211a and a lower surface 211b facing each other in the Z-axis direction. An opening 221 is formed in the support substrate 211. The opening 221 is formed to penetrate through the support substrate 211 in the Z-axis direction. The support substrate 211 is formed, for example, of a silicon wafer. The opening 221 is formed to have a circular shape as viewed in the Z-axis direction.

### [Vibration Plate 220]

The vibration plate 220 includes a piezoelectric film. The vibration plate 220 is formed to cover an opening 221. The vibration plate 220 is formed to have a circular shape as viewed in the Z-axis direction. The vibration plate 220 may include a part that covers the exterior of the opening 221. An outer circumference 222 of the vibration plate 220 is a fixed end of the vibration plate 220, and is fixed to an upper surface 211a of the support substrate 211. The vibration plate 220 includes a first detection region 323, a non-detection region 324, and a second detection region 325, as described below. The vibration plate 220 is also referred to as a "diaphragm". The shape of the opening 221 is not limited to a circular shape, but may be an elliptical shape or any other shape.

### [Piezoelectric Film]

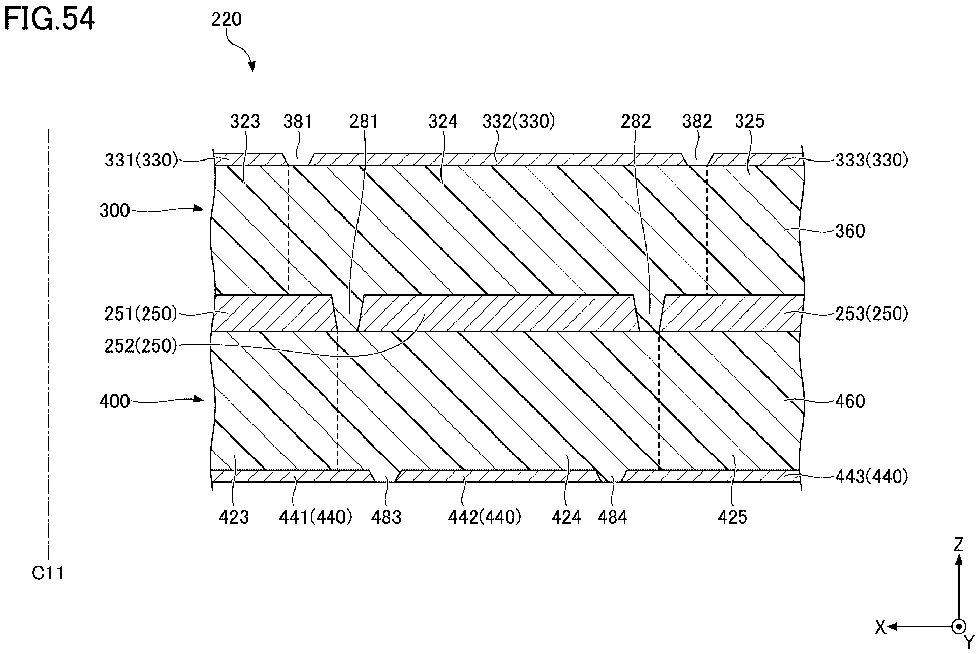

The piezoelectric film, which is the vibration plate 220, deforms in response to a sound pressure, thereby generating charges. FIG. 54 is an enlarged cross-sectional view illustrating the piezoelectric film. The piezoelectric film includes a lower electrode layer 440, a lower piezoelectric layer (first piezoelectric layer) 460, an intermediate electrode layer 250, an upper piezoelectric layer (second piezoelectric layer) 360, and an upper electrode layer 330. The lower electrode layer 440, the lower piezoelectric layer 460, the intermediate electrode layer 250, the upper piezoelectric layer 360, and the upper electrode layer 330 are stacked in this order.

### [Lower Electrode Layer 440]

The lower electrode layer 440 includes lower electrodes 441 to 443, which are thin electrode films. The lower electrode layer 440 is disposed closer to the opening 221 in the Z-axis direction. The lower electrodes 441 to 443 are disposed apart from each other in the X-axis direction. The lower electrode 441 is formed to have a circular shape. The lower electrode 441 is disposed closer to a center C11 of the vibration plate 220 as viewed in the Z-axis direction. The lower electrode 442 is formed to have a ring shape as viewed in the Z-axis direction. The lower electrode 442 is disposed outward of the lower electrode 441 in the radial direction. The lower electrode 443 is formed to have a ring shape as viewed in the Z-axis direction. The lower electrode 443 is disposed outward of the lower electrode 442 in the radial direction.

### [Electrode-Free Regions 483 and 484]

In the radial direction of the vibration plate 220, there is an electrode-free region 483, in which no electrode is formed, between the lower electrode 441 and the lower electrode 442. In the radial direction of the vibration plate 220, there is an electrode-free region 484, in which no electrode is formed, between the lower electrode 442 and the lower electrode 443.

### [Lower Piezoelectric Layer 460]

The lower piezoelectric layer 460 is a piezoelectric thin film, and is formed over the lower electrode layer 440. The lower piezoelectric layer 460 is formed to be continuous in the radial direction of the vibration plate 220.

### [Intermediate Electrode Layer 250]

The intermediate electrode layer 250 includes intermediate electrodes 251 to 253, which are thin electrode films. The intermediate electrode layer 250 is formed over the lower piezoelectric layer 460. The intermediate electrodes 251 to 253 are disposed apart from each other in the X-axis direction. The intermediate electrode 251 is formed to have a circular shape. The intermediate electrode 251 is disposed closer to the center C11 of the vibration plate 220 as viewed in the Z-axis direction. The intermediate electrode 252 is formed to have a ring shape as viewed in the Z-axis direction. The intermediate electrode 252 is disposed outward of the intermediate electrode 251 in the radial direction. The intermediate electrode 253 is formed to have a ring shape as viewed in the Z-axis direction. The intermediate electrode 253 is disposed outward of the intermediate electrode 252 in the radial direction.

### [Electrode-Free Regions 281 and 282]

In the radial direction of the vibration plate 220, there is an electrode-free region 281, in which no electrode is formed, between the intermediate electrode 251 and the intermediate electrode 252. In the radial direction of the vibration plate 220, there is an electrode-free region 282, in which no electrode is formed, between the intermediate electrode 252 and the intermediate electrode 253.

### [Upper Piezoelectric Layer 360]

The upper piezoelectric layer 360 is a piezoelectric thin film, and is formed over the intermediate electrode layer 250. The upper piezoelectric layer 360 is formed to be continuous in the radial direction of the vibration plate 220.

### [Upper Electrode Layer 330]

The upper electrode layer 330 includes upper electrodes 331 to 333, which are thin electrode films. The upper electrode layer 330 is formed over the upper piezoelectric layer 360. The upper electrodes 331 to 333 are disposed apart from each other in the X-axis direction. The upper electrode 331 is formed to have a circular shape. The upper electrode 331 is disposed closer to the center C11 of the vibration plate 220 as viewed in the Z-axis direction. The upper electrode 332 is formed to have a ring shape as viewed in the Z-axis direction. The upper electrode 332 is disposed outward of the upper electrode 331 in the radial direction. The upper electrode 333 is formed to have a ring shape as viewed in the Z-axis direction. The upper electrode 333 is disposed outward of the upper electrode 332 in the radial direction.

### [Material and Thickness of Piezoelectric Thin Film]

A piezoelectric material used for the lower piezoelectric layer 460 and the upper piezoelectric layer 360 may be, for example, aluminum nitride (AlN) or scandium aluminum nitride (ScAlN (Sc: 1 at% to 60 at%)), or may be, for example, a piezoelectric material having a fluorite structure (hafnium oxide, zirconium oxide, or cesium oxide) or a piezoelectric material having a wurtzite structure (zinc oxide or gallium nitride).

The thickness of the lower piezoelectric layer 460 may be, for example, 100 nm or more and 1 µm or less. The material of the lower piezoelectric layer 460 is, for example, ScAlN (Sc: 40 at%), and the thickness of the lower piezoelectric layer 460 may be, for example, 500 nm.

The thickness of the upper piezoelectric layer 360 may be, for example, 100 nm or more and 1 µm or less. The material of the upper piezoelectric layer 360 is, for example, ScAlN (Sc: 40 at%), and the thickness of the upper piezoelectric layer 360 may be, for example, 500 nm.

### [Material and Thickness of Thin Electrode Film]

The thicknesses of the thin electrode films of the upper electrode layer 330, the intermediate electrode layer 250, and the lower electrode layer 440 may be, for example, 5 nm or more and 100 nm or less. The thicknesses of the thin electrode films may be, for example, 20 nm. The thin electrode film of the upper electrode layer 330, the intermediate electrode layer 250, and the lower electrode layer 440 may be formed to have different thicknesses.

The materials of the thin electrode films of the upper electrode layer 330, the intermediate electrode layer 250, and the lower electrode layer 440 may be, for example, at least one of gold, platinum, tungsten, aluminum, copper, molybdenum, ruthenium, titanium, chromium, or nickel, or an alloy containing one of these. The thin electrode films of the upper electrode layer 330, the intermediate electrode layer 250, and the lower electrode layer 440 may be formed of the same material or different materials.

### [First Detection Regions, Non-Detection Regions, and Second Detection Regions]

As illustrated in FIGS. 53 and 54, the vibration plate 220, which is a diaphragm, includes the first detection regions 323 and 423, the non-detection regions 324 and 424, and the second detection regions 325 and 425. The first detection regions 323 and 423 and the second detection regions 325 and 425 are regions configured to detect a physical quantity. The non-detection regions 324 and 424 are regions configured not to detect the physical quantity. The physical quantity is, for example, a sound pressure.

The first detection region 323 is a region in which the intermediate electrode 251, the upper piezoelectric layer 360, and the upper electrode 331 are stacked in the Z-axis direction. The first detection region 423 is a region in which the lower electrode 441, the lower piezoelectric layer 460, and the intermediate electrode 251 are stacked in the Z-axis direction. The acoustic transducer 200 can detect piezoelectric output charges between the lower electrode 441 and the intermediate electrode 251. The acoustic transducer 200 can detect piezoelectric output charges between the intermediate electrode 251 and the upper electrode 331.

The non-detection region 324 includes a region in which the intermediate electrode 252, the upper piezoelectric layer 360, and the upper electrode 332 are stacked in the Z-axis direction. The non-detection region 424 includes a region in which the lower electrode 442, the lower piezoelectric layer 460, and the intermediate electrode 252 are stacked in the Z-axis direction. The acoustic transducer 200 cannot detect piezoelectric output charges between the lower electrode 442 and the intermediate electrode 252. The acoustic transducer 200 cannot detect piezoelectric output charges between the intermediate electrode 252 and the upper electrode 332.

The second detection region 325 is a region in which the intermediate electrode 253, the upper piezoelectric layer 360, and the upper electrode 333 are stacked in the Z-axis direction. The second detection region 425 is a region in which the lower electrode 443, the lower piezoelectric layer 460, and the intermediate electrode 253 are stacked in the Z-axis direction. The acoustic transducer 200 can detect piezoelectric output charges between the lower electrode 443 and the intermediate electrode 253. The acoustic transducer 200 can detect piezoelectric output charges between the intermediate electrode 253 and the upper electrode 333.

The first detection regions 323 and 423 are formed closer to the center of the vibration plate 220. The non-detection regions 324 and 424 are formed outward of the first detection regions 323 and 423 in the radial direction of the vibration plate 220. The second detection regions 325 and 425 are formed outward of the non-detection regions 324 and 424 in the radial direction of the vibration plate 220.

### [Outer Diameters of First Detection Region 323, Non-Detection Region 324, and Second Detection Region 325]

As illustrated in FIG. 50, an outer diameter Φ323 of the first detection region 323 is, for example, 0.59 millimeters (mm). An outer diameter Φ324 of the non-detection region 324 is, for example, 0.81 mm. An outer diameter Φ325 of the second detection region 325 is 1 mm.

### [Divided Positions]

As illustrated in FIG. 54, the electrode-free regions 483 and 484 are formed in the lower electrode layer 440. The electrode-free regions 281 and 282 are formed in the intermediate electrode layer 250. The electrode-free regions 381 and 382 are formed in the upper electrode layer 330.

The electrode-free regions 281, 282, 381, 382, 483, and 484 may be referred to as "divided positions". These electrode-free regions 281, 282, 381, 382, 483, and 484 are disposed at different positions in the radial direction of the vibration plate 220.

The electrode-free region 381 is disposed inward of the electrode-free region 281 in the radial direction of the vibration plate 220. The electrode-free region 281 is disposed inward of the electrode-free region 483 in the radial direction of the vibration plate 220.

The electrode-free region 382 is disposed outward of the electrode-free region 282 in the radial direction of the vibration plate 220. The electrode-free region 282 is disposed outward of the electrode-free region 484 in the radial direction of the vibration plate 220.

In the vibration plate 220, the electrode-free regions 281, 282, 381, 382, 483, and 484 are formed at positions not overlapping with each other as viewed in the Z-axis direction. This can suppress a reduction in strength of the vibration plate 220. A piezoelectric thin film is formed in the electrode-free regions 281, 282, 483, and 484.

The crystallinity of the piezoelectric thin film above the boundary between the end of the lower electrode 441 and the electrode-free region 483 is lower than that of the piezoelectric thin film above the lower electrode 441. Similarly, the crystallinity of the piezoelectric thin film above the boundary between the electrode and the electrode-free region is lower than that of the piezoelectric thin film above the electrode.

The divided position of the electrode-free region 483 is disposed outward of the first detection region 423 in the radial direction of the vibration plate 220. The divided position of the electrode-free region 484 is disposed inward of the second detection region 425 in the radial direction of the vibration plate 220. This does not inhibit crystal growth of the piezoelectric thin film configured to generate charges. In the acoustic transducer 200, the crystallinities of the piezoelectric thin films in the first detection region 423 and the second detection region 425, which generate charges, are high.

The divided position of the electrode-free region 281 is disposed outward of the first detection region 323 in the radial direction of the vibration plate 220. The divided position of the electrode-free region 282 is disposed inward of the second detection region 325 in the radial direction of the vibration plate 220. This does not inhibit crystal growth of the piezoelectric thin film configured to generate charges. In the acoustic transducer 200, the crystallinities of the piezoelectric thin films in the first detection region 323 and the second detection region 325, which generate charges, are high.

### [Connection in Piezoelectric Film]

In the vibration plate 220, which is the piezoelectric film (piezoelectric element), the electrodes of the first detection regions 323 and 423 are electrically connected in parallel. The electrodes of the first detection region 323 include the upper electrode 331 and the intermediate electrode 251. The electrodes of the first detection region 423 include the lower electrode 441 and the intermediate electrode 251. The electrodes of the second detection regions 325 and 425 are electrically connected in parallel. The electrodes of the second detection region 325 include the upper electrode 333 and the intermediate electrode 253. The electrodes of the second detection region 425 include the lower electrode 443 and the intermediate electrode 253.

The electrodes of the first detection region and the second detection region are electrically connected in series. Specifically, the upper electrode 331 and the upper electrode 333 are connected in series, and the lower electrode 441 and the lower electrode 443 are connected in series. Alternatively, the intermediate electrode 251 and the intermediate electrode 253 are connected in series.

### [Operations and Effects of Acoustic Transducer 200 according to Third Embodiment of Third Aspect]

The acoustic transducer 200 according to the third embodiment of the third aspect includes the support substrate (fixed frame) 211 and the vibration plate 220, which is a piezoelectric element fixed to the support substrate 211. The vibration plate 220 includes the first detection regions 323 and 423 and the second detection regions 325 and 425. The first detection regions 323 and 423 are a plurality of detection regions configured to detect a physical quantity, and the second detection regions 325 and 425 are configured not to detect the physical quantity. The electrodes of the plurality of detection regions are electrically connected in series.

In the acoustic transducer 200 according to the embodiments of the third aspect, in response to deformation of the vibration plate 220, the physical quantity can be detected by detecting this deformation of the vibration plate 220. In the acoustic transducer 200, the first detection regions 323 and 423 and the second detection regions 325 and 425 are formed, and the electrodes of the plurality of detection regions are electrically connected in series, and thus the sensitivity of the vibration plate 220 can be increased.

In the acoustic transducer 200, the piezoelectric element is the vibration plate (diaphragm) 220, and the outer circumference (outer circumference of the diaphragm) 222 of the vibration plate 220 is a fixed end that is fixed to the support substrate 211.

In the acoustic transducer 200, the plurality of detection regions include the first detection regions 323 and 423, and the second detection regions 325 and 425. The first detection regions 323 and 423 are inner detection regions disposed closer to the center C11 of the vibration plate 220 in the radial direction of the vibration plate 220. The second detection regions 325 and 425 are outer detection regions disposed farther from the center C11 of the vibration plate 220 in the radial direction of the vibration plate 220. The non-detection regions 324 and 424 are formed between the inner detection regions and the outer detection regions in the circumferential direction of the vibration plate 220.

In the acoustic transducer 200 according to the embodiments of the third aspect, charges are generated in response to deformation of the vibration plate 220, and the charges generated in the first detection regions 323 and 423 and the second detection regions 325 and 425 are detected. In the acoustic transducer 200, the first detection regions 323 and 423, the non-detection regions 324 and 424, and the second detection regions 325 and 425 are formed by dividing the respective electrodes in the radial direction of the vibration plate 220. In this acoustic transducer 200, the sensitivity for detecting charges in response to a sound pressure can be increased.

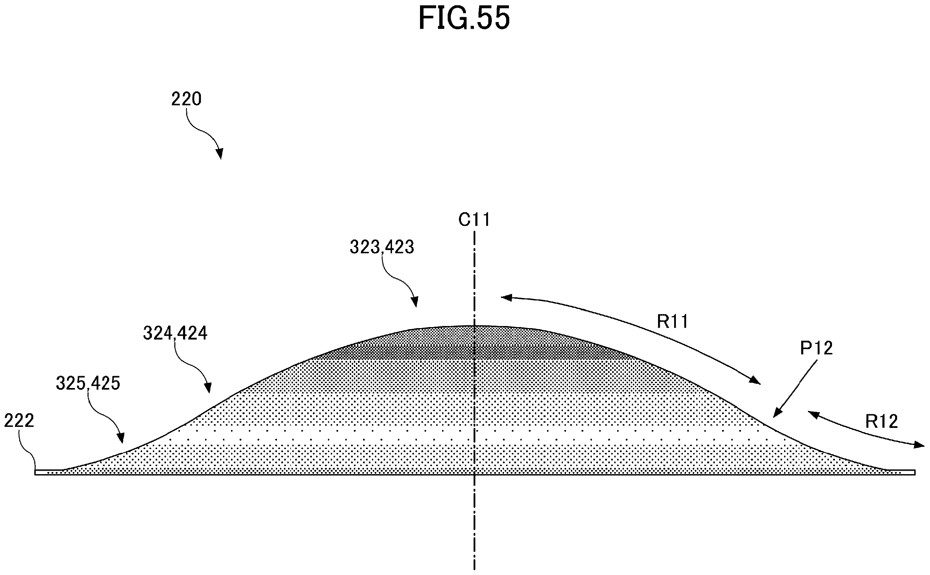

FIG. 55 is a side view illustrating a distribution of charges generated in the vibration plate 220 configured to deform in response to receiving a sound pressure. In the vibration plate 220, which is a diaphragm, the outer circumference 222 in the radial direction is fixed to the support substrate 211. As illustrated in FIG. 55, a region near an inflection point P12 does not readily deform, and the amount of charges generated is small. The inflection point P12 and a region near the inflection point P12, which generate a small amount of charges, are included in the non-detection regions 324 and 424.

On the other hand, a region near the center C11 of the vibration plate 220 and a region near the outer circumference 222 of the vibration plate 220 deform greatly, and thus the amount of charges generated in these regions is large. The center C11 of the vibration plate 220 and a region near the center C11 are included in the first detection regions 323 and 423. The region near the outer circumference 222 of the vibration plate 220 is included in the second detection regions 325 and 425. In the acoustic transducer 200, a region including the inflection point P12, at which the amount of charges generated is small, is not included in the first detection regions 323 and 423 and the second detection regions 325 and 425. This can increase the S/N ratio in the acoustic transducer 200, and increase the detection sensitivity of charges.

### [Shapes of Ends of Electrodes]

Next, the shapes of the ends of the electrode will be described. As illustrated in FIG. 54, the ends of the upper electrodes 331 to 333, the ends of the lower electrodes 441 to 443, and the ends of the intermediate electrodes 251 to 253 may be formed to have tapered shapes. The ends of the electrodes are ends facing in the radial direction of the vibration plate 220. The ends of the electrodes having the tapered shapes are formed to project on the lower side beyond on the upper side.

In this manner, when the ends of the lower electrodes 441 to 443 have tapered shapes, it is possible to soften the angle of steps at the boundaries between the lower electrodes 441 to 443 and the electrode-free regions 483 and 484. Therefore, a reduction in crystallinity in the piezoelectric layer 460 can be suppressed. The same applies to the boundaries between the other electrodes and the other electrode-free regions.

### [Acoustic Transducer 200B according to Fourth Embodiment of Third Aspect]

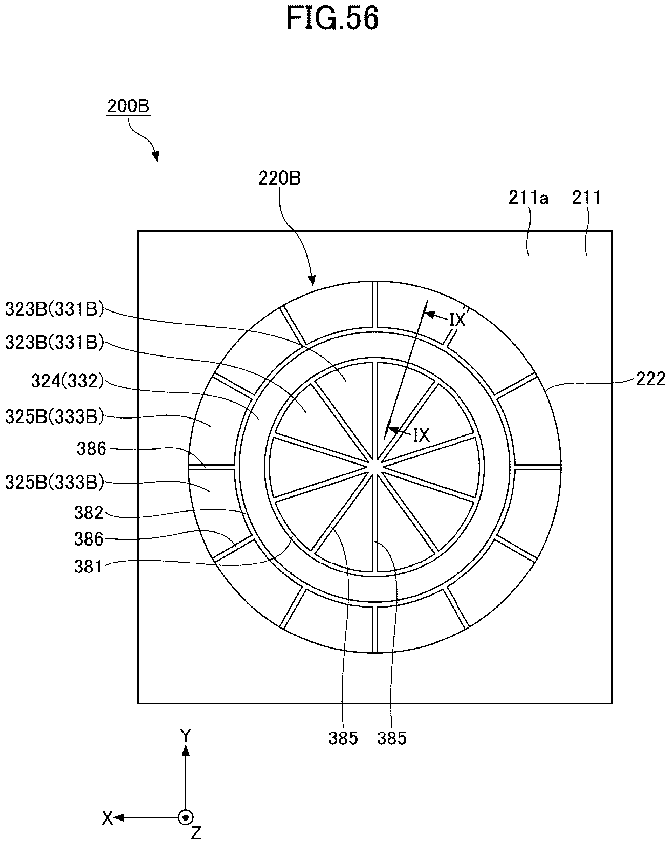

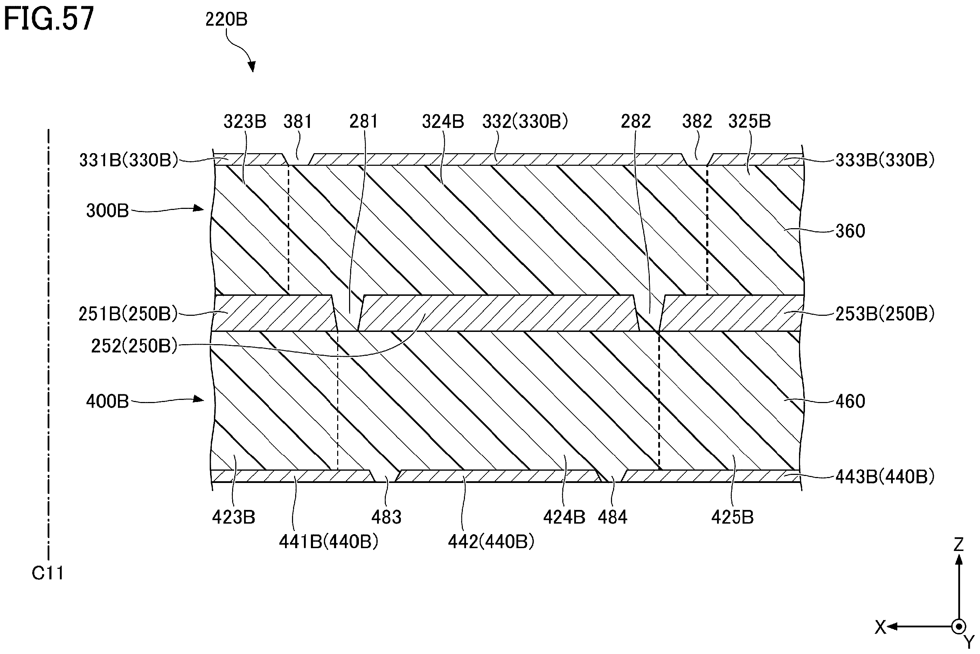

Next, an acoustic transducer 200B according to the fourth embodiment of the third aspect will be described. FIG. 56 is a plan view illustrating the acoustic transducer 200B according to the fourth embodiment of the third aspect. FIG. 57 is a cross-sectional view illustrating the acoustic transducer 200B according to the fourth embodiment of the third aspect, a cross-sectional view of the acoustic transducer 200B taken along line IX-IX in FIG. 56. The acoustic transducer 200B according to the fourth embodiment of the third aspect illustrated in FIGS. 56 and 57 differs from the acoustic transducer 200 according to the third embodiment of the third aspect illustrated in FIG. 50 in that the acoustic transducer 200B includes a plurality of upper electrodes 331B and 333B divided in the circumferential direction, a plurality of lower electrodes 441B and 443B divided in the circumferential direction, a plurality of intermediate electrodes 251B and 253B divided in the circumferential direction, and electrode-free regions 385 and 386 extending in the radial direction. In the description of the acoustic transducer 200B according to the fourth embodiment of the third aspect, the same description as that of the acoustic transducer 200 according to the third embodiment of the third aspect may be omitted.

### [Stack 300B]

As illustrated in FIG. 57, the acoustic transducer 200B includes stacks 300B and 400B. The stack 300B includes an upper electrode layer 330B, a piezoelectric layer 360, and an intermediate electrode layer 250B. The upper electrode layer 330B includes a plurality of upper electrodes 331B divided in the circumferential direction, the upper electrode 332 continuous in the circumferential direction, and a plurality of upper electrodes 333B divided in the circumferential direction. The intermediate electrode layer 250B includes a plurality of intermediate electrodes 251B divided in the circumferential direction, the intermediate electrode 252 continuous in the circumferential direction, and a plurality of intermediate electrodes 253B divided in the circumferential direction.

### [First Detection Region 323B]

The stack 300B includes a first detection region 323B, a non-detection region 324B, and a second detection region 325B. The first detection region 323B includes a plurality of upper electrodes 331B, the piezoelectric layer 360, and a plurality of intermediate electrodes 251B. The first detection region 323B includes a plurality of piezoelectric elements. In the first detection region 323B, the piezoelectric element includes the upper electrode 331B, the piezoelectric layer 360, and the intermediate electrode 251B.

### [Second Detection Region 325B]

The second detection region 325B includes a plurality of upper electrodes 333B, the piezoelectric layer 360, and a plurality of intermediate electrodes 253B. The second detection region 325B includes a plurality of piezoelectric elements. In the second detection region 325B, the piezoelectric element includes the upper electrode 333B, the piezoelectric layer 360, and the intermediate electrode 253B.

As illustrated in FIG. 56, the electrode-free regions 381 and 382 and the electrode-free regions 385 and 386 are formed in the upper electrode layer 330B.

### [Electrode-Free Region 385]

The electrode-free regions 385 divide the upper electrode into a plurality of upper electrodes in the first detection region 323B. The electrode-free regions 385 extend in the radial direction from the center of a vibration plate 220B. The plurality of electrode-free regions 385 are disposed at equal intervals in the circumferential direction. The areas of the plurality of upper electrodes 331B are substantially equal. The acoustic transducer 200B includes, for example, ten upper electrodes 331B.

### [Electrode-Free Region 386]

The electrode-free regions 386 divide the upper electrode into a plurality of upper electrodes in the second detection region 325B. The electrode-free regions 386 extend in the radial direction from the electrode-free region 382 toward the outer circumference 222 of the vibration plate 220. The plurality of electrode-free regions 386 are disposed at equal intervals in the circumferential direction.

### [Stack 400B]

As illustrated in FIG. 57, the stack 400B includes the intermediate electrode layer 250B, the piezoelectric layer 460, and the lower electrode layer 440B. The intermediate electrode layer 250B is included in both the stack 300B and the stack 400B. The lower electrode layer 440B includes the plurality of lower electrodes 441B divided in the circumferential direction, the lower electrodes 442 continuous in the circumferential direction, and the plurality of lower electrodes 443B divided in the circumferential direction.

### [First Detection Region 423B]

The stack 400B includes a first detection region 423B, a non-detection region 424B, and a second detection region 425B. The first detection region 423B includes the plurality of intermediate electrodes 251B, the piezoelectric layer 460, and the plurality of lower electrodes 441B. The first detection region 423B includes a plurality of piezoelectric elements. In the first detection region 423B, the piezoelectric element includes the intermediate electrode 251B, the piezoelectric layer 460, and the lower electrode 441B. In the first detection region 423B, the areas of the plurality of lower electrodes 441B are substantially equal.

### [Second Detection Region 425B]

The second detection region 425B includes the plurality of intermediate electrodes 253B, the piezoelectric layer 460, and the plurality of lower electrodes 443B. The second detection region 425B includes a plurality of piezoelectric elements. In the second detection region 425B, the piezoelectric element includes the intermediate electrode 253B, the piezoelectric layer 460, and the lower electrode 443B. In the second detection region 425B, the areas of the plurality of lower electrodes 443B are substantially equal.

Similar to the upper electrode layer 330B of the stack 300B, the lower electrode layer 440B and the intermediate electrode layer 250B of the stack 400B include electrode-free regions extending in the radial direction.

### [Capacitances of Piezoelectric Elements]

In the stack 300B, the capacitances of the plurality of piezoelectric elements disposed along the circumferential direction of the vibration plate 220B are equal to each other. In the stack 400B, the capacitances of the plurality of piezoelectric elements disposed along the circumferential direction of the vibration plate 220B are substantially equal.

### [Connection in Series of Piezoelectric Elements]

In the vibration plate 220B, the plurality of piezoelectric elements disposed along the circumferential direction and the radial direction are electrically connected in series.

### [Operations and Effects of Acoustic Transducer 200B according to Fourth Embodiment of Third Aspect]

The acoustic transducer 200B according to the fourth embodiment of the third aspect exhibits operations and effects similar to those exhibited by the acoustic transducer 200 according to the third embodiment of the third aspect.

In the acoustic transducer 200B, the plurality of detection regions include first detection regions 323B and 423B and second detection regions 325B and 425B. The first detection regions 323B and 423B are inner detection regions disposed closer to the center C11 of the vibration plate 220B in the radial direction of the vibration plate 220B. The second detection regions 325B and 425B are outer detection regions disposed farther from the center C11 of the vibration plate 220B in the radial direction of the vibration plate 220B. The non-detection regions 324 and 424 include: the electrode-free regions 381 and 382 formed between the inner detection regions and the outer detection regions in the circumferential direction of the vibration plate 220B; and the plurality of electrode-free regions 385 and 386 extending in the radial direction of the diaphragm and formed at intervals in the circumferential direction of the diaphragm.

According to the above acoustic transducer 200B, the electrode-free regions 385 and 386 extending in the radial direction can divide the electrode in the detection regions into a plurality of electrodes.

### [Modified Example of Acoustic Transducer 200B according to Fourth Embodiment of Third Aspect]

In the acoustic transducer 200B, the vibration plate (piezoelectric element) 220B includes a piezoelectric film, and the piezoelectric film includes the lower electrode layer 440B, the lower piezoelectric layer 460 formed over the lower electrode layer 440B, the intermediate electrode layer 250B formed over the lower piezoelectric layer 460, the upper piezoelectric layer 360 formed over the intermediate electrode layer 250B, and the upper electrode layer 330B formed over the upper piezoelectric layer 360. Between the plurality of detection regions (the first detection regions 323B and 423B and the second detection regions 325B and 425B), there is an electrode-free region (first electrode-free region) in which the upper electrode and the lower electrode are not formed, or there is an electrode-free region (second electrode-free region) in which the intermediate electrode is not formed.

In the acoustic transducer 200B, when the electrode-free regions (first electrode-free regions) are formed in the upper electrode and the lower electrode, the electrode-free regions (second electrode-free regions) do not necessarily need to be formed in the intermediate electrode. In the acoustic transducer 200B, when the electrode-free regions (second electrode-free regions) are formed in the intermediate electrode, the electrode-free regions (first electrode-free regions) 381, 382, 483, and 484 do not necessarily need to be formed in the upper electrode and the lower electrode.

In the detection region, the upper electrode, the intermediate electrode, and the lower electrode may be divided in the circumferential direction. In the circumferential direction, the divided positions (electrode-free regions) in the upper electrodes may differ from the divided positions in the intermediate electrodes. Similarly, in the circumferential direction, the divided positions in the lower electrodes may differ from the divided positions in the intermediate electrodes.

### [Circuit Diagram of Acoustic Transducer 200B according to Fourth Embodiment of Third Aspect]

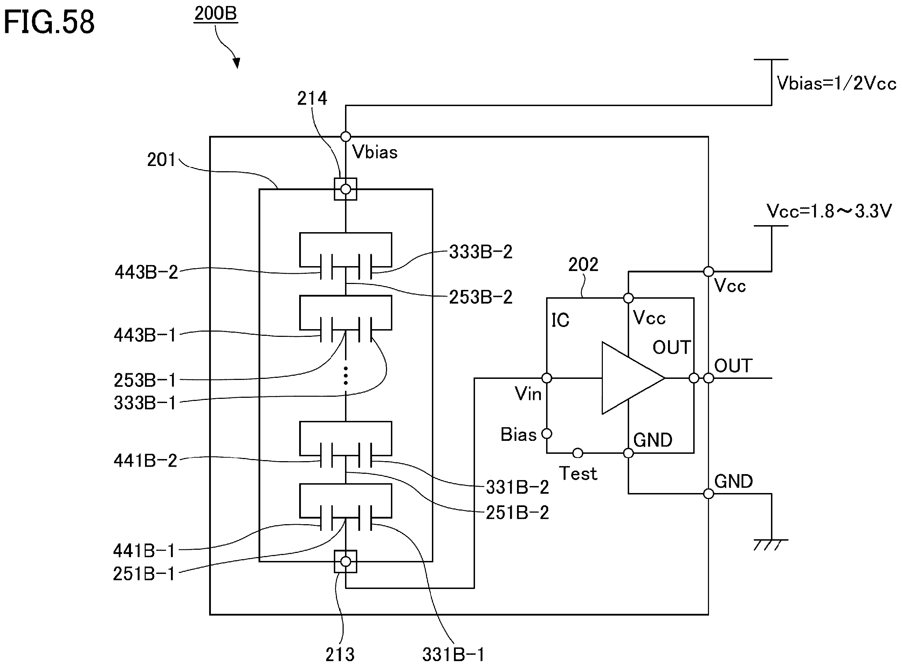

Next, a circuit diagram of the acoustic transducer 200B according to the fourth embodiment of the third aspect will be described. FIG. 58 is a circuit diagram of the acoustic transducer 200B according to the fourth embodiment of the third aspect.

As illustrated in FIG. 58, the acoustic transducer 200B includes an MEMS microphone chip 201.

The MEMS microphone chip 201 includes a vibration plate 220B. The vibration plate 220B includes the plurality of first detection regions 323B and 423B and the plurality of second detection regions 325B and 425B.

The plurality of first detection regions 323B and 423B include the upper electrodes 331B, the intermediate electrodes 251B, and the lower electrodes 441B. The plurality of second detection regions 325B and 425B include the upper electrodes 333B, the intermediate electrodes 253B, and the lower electrodes 443B. The upper electrode 331B includes upper electrodes 331B-1, 331B-2, ..., 331B-n divided into the number of n in the circumferential direction. n is a natural number. The same applies to the other upper electrodes, intermediate electrodes, and lower electrodes.

In the first detection regions 323B and 423B of the acoustic transducer 200B, it is possible to detect piezoelectric output charges between the upper electrode 331B and the intermediate electrode 251B and piezoelectric output charges between the intermediate electrode 251B and the lower electrode 441B. The plurality of piezoelectric elements disposed along the circumferential direction are connected in series.

In the second detection regions 325B and 425B of the acoustic transducer 200B, it is possible to detect piezoelectric output charges between the upper electrode 333B and the intermediate electrode 253B and piezoelectric output charges between the intermediate electrode 253B and the lower electrode 443B. The plurality of piezoelectric elements disposed along the circumferential direction are connected in series.

The MEMS microphone chip 201 includes pads 213 and 214. Electrodes of the plurality of piezoelectric elements are connected to the pads 213 and 214. The acoustic transducer 200B includes an IC 202 connected to the pad 213. The IC 202 is an amplifier configured to amplify an output signal of the piezoelectric element of the vibration plate 220B. The IC 202 may be provided with a function of performing analog-to-digital (AD) conversion after amplifying the output signal of the piezoelectric element of the vibration plate 220B.

The polarity of charges generated in the second detection regions 325B and 425B is reversed from the polarity of charges generated in the first detection regions 323B and 423B. Therefore, connection in series is achieved by reversing the interconnects between the second detection regions 325B and 425B and the first detection regions 323B and 423B.

### [Connection of Electrodes]

In the acoustic transducer 200B, the upper electrodes 331B and the intermediate electrodes 251B of the plurality of first detection regions 323B may be electrically connected in series. Similarly, the upper electrodes 333B and the intermediate electrodes 253B of the plurality of second detection regions 325B may be electrically connected in series.

In the acoustic transducer 200B, the lower electrodes 441B and the intermediate electrodes 251B of the plurality of first detection regions 423B may be electrically connected in series. Similarly, the lower electrodes 433B and the intermediate electrodes 253B of the plurality of second detection regions 425B may be electrically connected in series.

In the acoustic transducer 200B, the upper electrode and the lower electrode in each of the plurality of detection regions may be electrically connected in parallel.

### [Relationship between Sensing Area Radius Ratio and Normalized SNR]

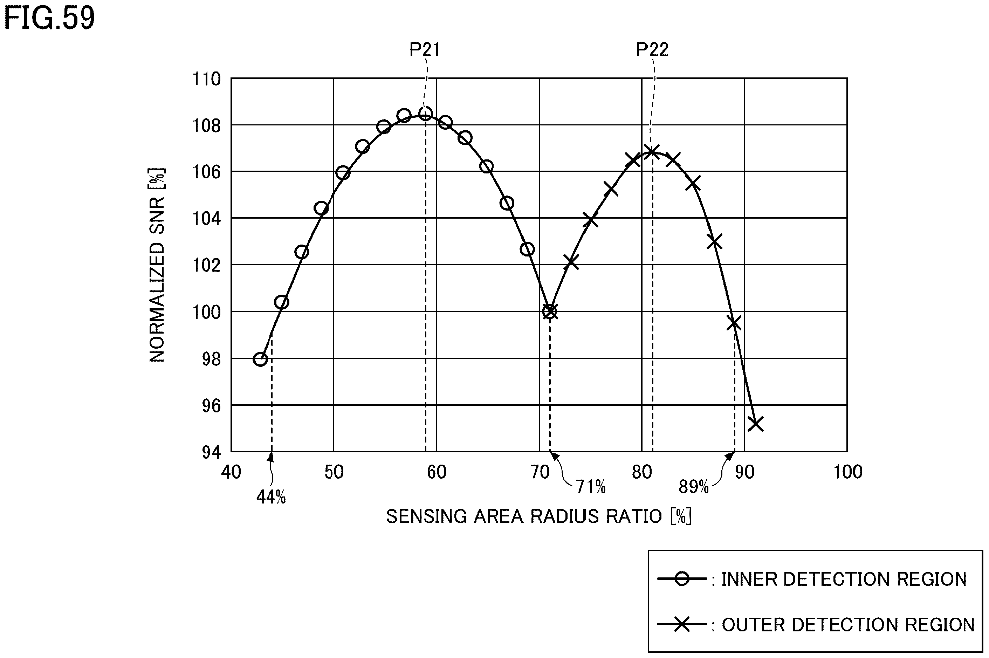

Next, a relationship between the sensing area radius ratio and the normalized SNR will be described. FIG. 59 is a graph illustrating the relationship between the sensing area radius ratio and the normalized SNR in the third aspect. In FIG. 59, the horizontal axis indicates the sensing area radius ratio [%] and the vertical axis indicates the normalized SNR [%]. The graph illustrated in FIG. 59 is a graph illustrating the relationship between the sensing area radius ratio and the normalized SNR in the acoustic transducer 200 according to the third embodiment of the third aspect illustrated in FIG. 50.

The "sensing area radius ratio" can be expressed according to the following formula (1). Sensing area radius ratio = (Electrode-divided part radius/Diaphragm radius) × 100 The "electrode-divided part radius" may be the radius of the inner detection region 323. The "diaphragm radius" may be the radius of the vibration plate 220. In FIG. 50, the diameter Φ323 of the inner detection region 323 and the diameter Φ325 of the vibration plate 220 are illustrated.

The inner diameter of the opening 221 covered by the vibration plate 220 is defined as the sensing area radius ratio of 100%. When the electrode-free region formed is 71%, the normalized SNR is defined as 100%. In FIG. 59, "O" indicates the position of the boundary between the inner detection region 323 and the non-detection region 324. In FIG. 59, "X" indicates the position of the boundary between the outer detection region 325 and the non-detection region 324.

The normalized SNR value of the inner detection region 323 is the value obtained when the boundary between the outer detection region 325 and the non-detection region 324 is 71%, and the outer diameter Φ323 of the inner detection region 323 is changed.

The normalized SNR value of the outer detection region 325 is the value obtained when the boundary between the inner detection region 323 and the non-detection region 324 is 71%, and the inner diameter Φ324 of the outer detection region 325 is changed.

In the example illustrated in FIG. 59, the normalized SNR value of the inner detection region 323 becomes the maximum at point P21. The sensing area radius ratio at point P21 is 59%.

In the example illustrated in FIG. 59, the normalized SNR value of the outer detection region 325 becomes the maximum at point P22. The sensing area radius ratio at point P22 is 81%.

When the sensing area radius ratio of the inner detection region 323 is 44% or more and 71% or less, the normalized SNR value is 100% or more. When the sensing area radius ratio of the inner detection region 323 is 49% or more and 67% or less, the normalized SNR value is 104% or more. When the sensing area radius ratio of the inner detection region 323 is 51% or more and 65% or less, the normalized SNR value is 106% or more.

The sensing area radius ratio of the inner detection region 323 is preferably 44% or more and 71% or less, more preferably 49% or more and 67% or less, and further preferably 51% or more and 65% or less.

When the sensing area radius ratio of the outer detection region 325 is 71% or more and 89% or less, the normalized SNR value is 100% or more. When the sensing area radius ratio of the outer detection region 325 is 75% or more and 87% or less, the normalized SNR value is 104% or more. When the sensing area radius ratio of the outer detection region 325 is 78% or more and 84% or less, the normalized SNR value is 106% or more.

The sensing area radius ratio of the outer detection region 325 is preferably 71% or more and 89% or less, more preferably 75% or more and 87% or less, and further preferably 78% or more and 84% or less.

When the sensing area radius ratio of the inner detection region 323 is 71% and the sensing area radius ratio of the outer detection region 325 is 71%, the divided position of the electrode may be at a position of 71%.

In the acoustic transducer 200, when the sensing area radius ratio of the outer detection region 325 is 71% or more and 89% or less, the sensing area radius ratio of the inner detection region 323 may be a value outside the range of 44% or more and 71% or less. In such a case, the normalized SNR value may be high.

In the acoustic transducer 200, when the sensing area radius ratio of the inner detection region 323 is 44% or more and 71% or less, the sensing area radius ratio of the outer detection region 325 may be a value outside the range of 71% or more and 89% or less. In such a case, the normalized SNR value may be high.

It should be noted that other embodiments in which other components are combined with the configurations and the like described in the above embodiments may be possible, and the present invention is not limited in any way to the configurations described herein. In this regard, it is possible to change the configurations of the embodiments without departing from the intent of the present invention, and appropriately determine the configurations of the embodiments in accordance with forms in which they are to be applied.

Although the embodiments of the first aspect exemplify the acoustic transducer 100 including the cantilever 20 having a beam structure supported at one end, i.e., including the free end 21 and the fixed end 22, the acoustic transducer 100 is not limited to this. The acoustic transducer 100 may have a beam structure that is a continuous beam supported at both ends, in which both ends of the beam structure each serve as the fixed end 22 and are connected to parts of the fixed frame 10 that are faced by both ends. According to the acoustic transducer 100 with this configuration, the continuous beam bends at the center in the thickness direction in response to receiving a sound pressure. The acoustic transducer 100 may include the continuous beam instead of the cantilever 20.

Although the embodiments of the first aspect describe the acoustic transducers 100, 100B, 100C, and 100D including the pair of cantilevers 20A and 20B, the acoustic transducers 100, 100B, 100C, and 100D may include a single cantilever 20 or may include three or more cantilevers 20.

Although the embodiments of the second aspect exemplify the acoustic transducers 100 and 100B to 100G including the cantilever 20 having a beam structure supported at one end, i.e., including the free end 21 and the fixed end 22, the acoustic transducers 100 and 100B to 100G are not limited to this. The acoustic transducers 100 and 100B to 100G may have a beam structure that is a continuous beam supported at both ends, in which both ends of the beam structure each serve as the fixed end 22 and are connected to parts of the fixed frame 10 that are faced by both ends. According to the acoustic transducers 100 and 100B to 100G with this configuration, the continuous beam bends at the center in the thickness direction in response to receiving a sound pressure. The acoustic transducers 100 and 100B to 100G may include the continuous beam instead of the cantilever 20 (20A to 20D).

Although the embodiments of the second aspect exemplify a case in which the upper electrode 30, the lower electrode 40, and the intermediate electrode 50 are formed in the non-detection region 24, at least one of the upper electrode 30, the lower electrode 40, or the intermediate electrode 50 may not need to be formed in the non-detection region 24, the upper electrode 30 and the lower electrode 40 may not need to be formed in the non-detection region 24, and the upper electrode 30, the lower electrode 40, and the intermediate electrode 50 may not need to be formed in the non-detection region 24.

Although the embodiments of the third aspect exemplify the acoustic transducers 100 and 100B including the cantilever 20 having a beam structure supported at one end, i.e., including the free end 21 and the fixed end 22, the acoustic transducers 100 and 100B are not limited to this. The acoustic transducers 100 and 100B may have a beam structure that is a continuous beam supported at both ends, in which both ends of the beam structure each serve as the fixed end 22 and are connected to parts of the fixed frame 10 that are faced by both ends. According to the acoustic transducers 100 and 100B with this configuration, the continuous beam bends at the center in the thickness direction in response to receiving a sound pressure. The acoustic transducers 100 and 100B may include the continuous beam instead of the cantilever 20.

Although the embodiments of the third aspect describe the acoustic transducers 100 and 100B including the pair of cantilevers 20A and 20B, the acoustic transducers 100 and 100B may include a single cantilever 20 or may include three or more cantilevers 20.

In the embodiments of the third aspect, the intermediate electrode 50 may be thicker than the upper electrode 30, and may have the same thickness as that of the lower electrode 40. The intermediate electrode 50 may be thicker than the upper electrode 30, and may be thinner than the lower electrode 40. The intermediate electrode 50 may be thicker than the lower electrode 40, and may have the same thickness as that of the upper electrode 30. The intermediate electrode 50 may be thicker than the lower electrode 40, and may be thinner than the upper electrode 30.

In the present disclosure, embodiments according to the following clauses are conceivable.

### (Clause 1)

An acoustic transducer, including:
a fixed frame; and
a piezoelectric element fixed to the fixed frame, wherein
the piezoelectric element includes
   a plurality of detection regions configured to detect a physical quantity, and
   a non-detection region configured not to detect the physical quantity, and
   electrodes of the plurality of detection regions are electrically connected in series.

### (Clause 2)

The acoustic transducer according to clause 1, wherein
the piezoelectric element is a cantilever including a fixed end and a free end, and projects from the fixed frame inward of the fixed frame,
the fixed end is one end of the cantilever fixed to the fixed frame, and the free end is another end of the cantilever, and
the cantilever includes a first cantilever and a second cantilever facing each other in a first direction that is a direction in which the cantilever projects.

### (Clause 3)

3. The acoustic transducer according to clause 2, wherein
the electrodes of the plurality of detection regions of the first cantilever and the electrodes of the plurality of detection regions of the second cantilever are electrically connected in series.

### (Clause 4)

The acoustic transducer according to clause 2 or 3, wherein
the plurality of detection regions are disposed closer to the fixed end, and
the non-detection region is disposed closer to the free end.

### (Clause 5)

The acoustic transducer according to any one of clauses 1 to 4, wherein
the piezoelectric element is a diaphragm, and
an outer circumference of the diaphragm is a fixed end that is fixed to the fixed frame.

### (Clause 6)

The acoustic transducer according to clause 5, wherein
the plurality of detection regions include
   an inner detection region that is disposed closer to a center of the diaphragm in a radial direction of the diaphragm, and
   an outer detection region that is disposed farther from the center of the diaphragm in the radial direction of the diaphragm, and
the non-detection region includes
   a circumferential electrode-free region that is formed to have a ring shape, is continuous in a circumferential direction of the diaphragm, and is formed between the inner detection region and the outer detection region, and
   a plurality of radial electrode-free regions that extend in a radial direction of the diaphragm and are formed at intervals in the circumferential direction of the diaphragm.

### (Clause 7)

The acoustic transducer according to any one of clauses 1 to 6, wherein
the piezoelectric element includes a piezoelectric film, and
the piezoelectric film includes
   a lower electrode,
   a lower piezoelectric layer formed over the lower electrode,
   an intermediate electrode formed over the lower piezoelectric layer,
   an upper piezoelectric layer formed over the intermediate electrode, and
   an upper electrode formed over the upper piezoelectric layer, and
a first electrode-free region, in which the upper electrode and the lower electrode are not formed, or a second electrode-free region, in which the intermediate electrode is not formed, is included between the plurality of detection regions.

### (Clause 8)

The acoustic transducer according to clause 7, wherein
the piezoelectric element is a diaphragm,
an outer circumference of the diaphragm is a fixed end that is fixed to the fixed frame,
in the plurality of detection regions, the lower electrodes are electrically connected in series and the upper electrodes are electrically connected in series, or the intermediate electrodes are electrically connected in series, and
the upper electrode and the lower electrode in each of the plurality of detection regions are electrically connected in parallel.

### (Clause 9)

The acoustic transducer according to clause 7, wherein
the first electrode-free region and the second electrode-free region are disposed alternately in a direction in which the plurality of detection regions are arranged.

### (Clause 10)

The acoustic transducer according to according to any one of clauses 1 to 9, wherein
the plurality of detection regions include a first detection region and a second detection region,
the first detection region includes
   a first lower electrode,
   a first lower piezoelectric layer formed over the first lower electrode,
   a first intermediate electrode formed over the first lower piezoelectric layer,
   a first upper piezoelectric layer formed over the first intermediate electrode, and
   a first upper electrode formed over the first upper piezoelectric layer,
the second detection region includes
   a second lower electrode,
   a second lower piezoelectric layer formed over the second lower electrode,
   a second intermediate electrode formed over the second lower piezoelectric layer,
   a second upper piezoelectric layer formed over the second intermediate electrode, and
   a second upper electrode formed over the second upper piezoelectric layer, and
   a lower connecting electrode and an upper connecting electrode are formed between the first detection region and the second detection region, the lower connecting electrode connecting the first lower electrode and the second intermediate electrode, and the upper connecting electrode connecting the first upper electrode and the second intermediate electrode.

### (Clause 11)

The acoustic transducer according to any one of clauses 2 to 10, wherein
the plurality of detection regions include a first detection region and a second detection region,
the first detection region includes
   a first lower electrode,
   a first lower piezoelectric layer formed over the first lower electrode,
   a first intermediate electrode formed over the first lower piezoelectric layer,
   a first upper piezoelectric layer formed over the first intermediate electrode, and
   a first upper electrode formed over the first upper piezoelectric layer,
the second detection region includes
   a second lower electrode,
   a second lower piezoelectric layer formed over the second lower electrode,
   a second intermediate electrode formed over the second lower piezoelectric layer,
   a second upper piezoelectric layer formed over the second intermediate electrode, and
   a second upper electrode formed over the second upper piezoelectric layer,
between the first detection region and the second detection region,
   the first lower electrode projects toward the second lower electrode in a second direction crossing the first direction in which the cantilever projects,
   the second intermediate electrode projects toward the first intermediate electrode in the second direction, and
   the first upper electrode projects toward the second upper electrode in the second direction, and
the acoustic transducer includes
   an interconnect configured to connect a projecting part of the first lower electrode, a projecting part of the second intermediate electrode, and a projecting part of the first upper electrode.

### (Clause 12)

The acoustic transducer according to clause 11, wherein
the interconnect includes
a first joining part that is formed over the first lower electrode and joined to the first lower electrode,
a first rising part that is connected to the first joining part and extends in a thickness direction of a piezoelectric film,
a second joining part that is connected to the first rising part, formed over the second intermediate electrode, and joined to the second intermediate electrode,
a second rising part that is connected to the second joining part and extends in the thickness direction of the piezoelectric film, and
a third joining part that is connected to the second rising part, formed over the first upper electrode, and connected to the first upper electrode.

### (Clause 13)

An acoustic transducer, including:
a fixed frame; and
a continuous beam fixed to parts of the fixed frame, the parts facing both ends of the continuous beam, wherein
the continuous beam includes
   a plurality of detection regions configured to detect a physical quantity, and
   a non-detection region configured not to detect the physical quantity, and
electrodes of the plurality of detection regions are electrically connected in series.

### (Clause 14)

An acoustic transducer, including:
a fixed frame; and
a piezoelectric element fixed to the fixed frame, wherein
the piezoelectric element includes
   a detection region configured to detect a physical quantity, and
   a non-detection region configured not to detect the physical quantity.

### (Clause 15)

The acoustic transducer according to clause 14, wherein
the piezoelectric element includes a piezoelectric film, and
the piezoelectric film includes
   a lower electrode,
   a first piezoelectric layer formed over the lower electrode,
   an intermediate electrode formed over the first piezoelectric layer,
   a second piezoelectric layer formed over the intermediate electrode, and
   an upper electrode formed over the second piezoelectric layer, and
an electrode-free region in which at least one electrode of the lower electrode, the intermediate electrode, or the upper electrode is not formed is included between the detection region and the non-detection region.

### (Clause 16)

The acoustic transducer according to clause 14 or 15, wherein
the piezoelectric element is a cantilever including a fixed end and a free end, and projects from the fixed frame inward of the fixed frame,
the fixed end is one end of the cantilever fixed to the fixed frame, and the free end is another end of the cantilever, and
the cantilever includes a first cantilever and a second cantilever facing each other in a first direction that is a direction in which the cantilever projects.

### (Clause 17)

The acoustic transducer according to clause 16, wherein
in the first direction that is the direction in which the cantilever projects, the detection region has a length, from the fixed end, 20% or more and 75% or less of an overall length of the cantilever.

### (Clause 18)

The acoustic transducer according to clause 17, wherein
in the first direction, the detection region has a length, from the fixed end, 30% or more and 60% or less of the overall length of the cantilever.

### (Clause 19)

The acoustic transducer according to clause 18, wherein
in the first direction, the detection region has a length, from the fixed end, 40% or more and 45% or less of the overall length of the cantilever.

### (Clause 20)

The acoustic transducer according to any one of clauses 16 to 19, wherein
in the first direction that is the direction in which the cantilever projects, an end of the detection region closer to the free end is formed at a position, from the fixed end, 20% or more and 75% or less of an overall length of the cantilever.

### (Clause 21)

The acoustic transducer according to clause 20, wherein
in the first direction, the end of the detection region closer to the free end is formed at a position, from the fixed end, 30% or more and 60% or less of the overall length of the cantilever.

### (Clause 22)

The acoustic transducer according to clause 21, wherein
in the first direction, the end of the detection region closer to the free end is formed at a position, from the fixed end, 40% or more and 45% or less of the overall length of the cantilever.

### (Clause 23)

The acoustic transducer according to clause 14 or 15, wherein
the piezoelectric element is a diaphragm, and
an outer circumference of the diaphragm is a fixed end that is fixed to the fixed frame.

### (Clause 24)

The acoustic transducer according to clause 23, wherein
the plurality of detection regions include
   an inner detection region that is disposed closer to a center of the diaphragm in a radial direction of the diaphragm, and
   an outer detection region that is disposed farther from the center of the diaphragm in the radial direction of the diaphragm, and
the non-detection region includes
   a first non-detection region that is provided in a circumferential direction of the diaphragm, and formed between the inner detection region and the outer detection region, and
   a plurality of second non-detection regions that extend in the radial direction of the diaphragm and are formed at intervals in the circumferential direction of the diaphragm,
a radially outward end of the inner detection region is formed at a position, from the center of the diaphragm, 44% or more and 71% or less of a radius of the diaphragm, and
a radially inward end of the outer detection region is disposed outward of the radially outward end of the inner detection region in the radial direction of the diaphragm, and is formed at a position, from the center of the diaphragm, 71% or more and 89% or less of the radius of the diaphragm.

### (Clause 25)

The acoustic transducer according to clause 24, wherein
the radially outward end of the inner detection region is formed at a position, from the center of the diaphragm, 49% or more and 67% or less of the radius of the diaphragm, and
the radially inward end of the outer detection region is formed at a position, from the center of the diaphragm, 75% or more and 87% or less of the radius of the diaphragm.

### (Clause 26)

The acoustic transducer according to clause 24, wherein
the radially outward end of the inner detection region is formed at a position, from the center of the diaphragm, 51% or more and 65% or less of the radius of the diaphragm, and
the radially inward end of the outer detection region is formed at a position, from the center of the diaphragm, 78% or more and 84% or less of the radius of the diaphragm.

### (Clause 27)

The acoustic transducer according to clause 15, wherein
the electrode-free region is a region in which the intermediate electrode is not formed.

### (Clause 28)

The acoustic transducer according to clause 15, wherein
the electrode-free region includes
a region in which the lower electrode is not formed, and
a region in which the upper electrode is not formed.

### (Clause 29)

The acoustic transducer according to clause 28, wherein
the region in which the lower electrode is not formed is formed farther from a fixed end of the piezoelectric element fixed to the fixed frame than is the region in which the upper electrode is not formed.

### (Clause 30)

The acoustic transducer according to clause 16, wherein
in a direction crossing the first direction that is the direction in which the cantilever projects, a width of the first cantilever is larger than a width of the second cantilever.

### (Clause 31)

An acoustic transducer, including:
a fixed frame; and
a continuous beam fixed to parts of the fixed frame, the parts facing both ends of the continuous beam, wherein
the continuous beam includes
   a detection region configured to detect a physical quantity, and
   a non-detection region configured not to detect the physical quantity.

### (Clause 32)

An acoustic transducer, including:
a fixed frame; and
a piezoelectric element fixed to the fixed frame, wherein
the piezoelectric element includes
   a lower electrode,
   a first piezoelectric layer formed over the lower electrode,
   an intermediate electrode formed over the first piezoelectric layer,
   a second piezoelectric layer formed over the intermediate electrode, and
   an upper electrode formed over the second piezoelectric layer, wherein
   a thickness of the intermediate electrode is larger than a thickness of the upper electrode or the lower electrode.

### (Clause 33)

The acoustic transducer according to clause 32, wherein
the piezoelectric element is a cantilever including a fixed end and a free end, and projects from the fixed frame inward of the fixed frame,
the fixed end is one end of the cantilever fixed to the fixed frame, and the free end is another end of the cantilever, and
the cantilever includes a first cantilever and a second cantilever facing each other in a first direction that is a direction in which the cantilever projects.

### (Clause 34)

The acoustic transducer according to clause 33, wherein
the piezoelectric element is a diaphragm, and
an outer circumference of the diaphragm is a fixed end that is fixed to the fixed frame.

### (Clause 35)

The acoustic transducer according to clause 33 or 34, wherein
the thickness of the intermediate electrode is 10% or more and 90% or less of a thickness of the piezoelectric element.

### (Clause 36)

The acoustic transducer according to clause 33 or 34, wherein
the thickness of the intermediate electrode is 30% or more and 70% or less of a thickness of the piezoelectric element.

### (Clause 37)

The acoustic transducer according to clause 33 or 34, wherein
the thickness of the intermediate electrode is 40% or more and 60% or less of a thickness of the piezoelectric element.

### (Clause 38)

The acoustic transducer according to any one of clauses 32 to 37, wherein
the piezoelectric element includes
   a neutral plane without generation of a tensile force or a compressive force that is generated in an interior of the piezoelectric element in response to bending of the piezoelectric element, and
the intermediate electrode includes the neutral plane.

### (Clause 39)

The acoustic transducer according to clause 38, wherein
the neutral plane is at a center of the piezoelectric element in a thickness direction of the piezoelectric element.

### (Clause 40)

The acoustic transducer according to clause 39, wherein
a thickness of the upper electrode is same as a thickness of the lower electrode.

### (Clause 41)

The acoustic transducer according to clause 39 or 40, wherein
a thickness of the first piezoelectric layer is same as a thickness of the second piezoelectric layer.

### (Clause 42)

The acoustic transducer according to clause 41, wherein
a material of the upper electrode is same as a material of the lower electrode, and
a material of the first piezoelectric layer is same as a material of the second piezoelectric layer.

### (Clause 43)

An acoustic transducer, including:
a fixed frame; and
a continuous beam fixed to parts of the fixed frame, the parts facing both ends of the continuous beam, wherein
the continuous beam includes
   a lower electrode,
   a first piezoelectric layer formed over the lower electrode,
   an intermediate electrode formed over the first piezoelectric layer,
   a second piezoelectric layer formed over the intermediate electrode, and
   an upper electrode formed over the second piezoelectric layer, and
a thickness of the intermediate electrode is larger than a thickness of the upper electrode or the lower electrode.

### REFERENCE SIGNS LIST

100, 100B, 100C, 100D, 100E, 100F, 100G, 200, 200B: acoustic transducer, 10: fixed frame, 20: cantilever, 20A: cantilever (first cantilever), 20B: cantilever (second cantilever), 20C: cantilever (first cantilever), 20D: cantilever (second cantilever), 20F: cantilever (second cantilever), 21: free end, 22: fixed end, 23, 23A, 23B, 23C, 23D: detection regions, 24: non-detection region, 25: non-detection region, 25A: non-detection region (first electrode-free region), 25B: non-detection region (second electrode-free region), 25C, 25D: non-detection region, 30: upper electrode, 31: upper electrode, 40: lower electrode, 41: lower electrode, 50, 50B, 50G: intermediate electrode, 51: intermediate electrode, 53: lower connecting electrode, 54: upper connecting electrode, 61: lower piezoelectric layer or first piezoelectric layer, 61A: lower piezoelectric layer (first lower piezoelectric layer), 61B: lower piezoelectric layer (second lower piezoelectric layer), 62: upper piezoelectric layer or second piezoelectric layer, 81: electrode-free region (region in which no upper electrode is formed), 82: electrode-free region (region in which no lower electrode is formed), 83: electrode-free region (region in which no intermediate electrode is formed, W20: width (width of first cantilever), W20F: width (width of second cantilever), 62A: upper piezoelectric layer (first upper piezoelectric layer), 62B: upper piezoelectric layer (second upper piezoelectric layer), 220, 220B: vibration plate (piezoelectric element, diaphragm), 222: outer circumference (fixed end), 323, 323B: first detection region (inner detection region), 324: non-detection region (first non-detection region), 325, 325B: second detection region (outer detection region), 331, 331B: upper electrode of detection region, 332: upper electrode of non-detection region, 333, 333B: upper electrode of detection region, 381, 382: electrode-free region, 385, 386: electrode-free region (second non-detection region), 423, 423B: first detection region (inner detection region), 424: non-detection region (first non-detection region), 425, 425B: second detection region (outer detection region), 431, 431B: upper electrode of detection region, 432: upper electrode of non-detection region, 433, 433B: upper electrode of detection region, 481, 482: electrode-free region, C11: center of diaphragm, X: X-axis direction (first direction), Y: Y-axis direction (second direction or direction crossing first direction), Z: Z-axis direction (thickness direction or plate thickness direction).

## Claims

1. An acoustic transducer, comprising:
a fixed frame; and
a piezoelectric element fixed to the fixed frame, wherein
the piezoelectric element includes
a plurality of detection regions configured to detect a physical quantity, and
a non-detection region configured not to detect the physical quantity, and
electrodes of the plurality of detection regions are electrically connected in series.

2. The acoustic transducer according to claim 1, wherein
the piezoelectric element is a cantilever including a fixed end and a free end, and projects from the fixed frame inward of the fixed frame,
the fixed end is one end of the cantilever fixed to the fixed frame, and the free end is another end of the cantilever, and
the cantilever includes a first cantilever and a second cantilever facing each other in a first direction that is a direction in which the cantilever projects.

3. The acoustic transducer according to claim 2, wherein
the electrodes of the plurality of detection regions of the first cantilever and the electrodes of the plurality of detection regions of the second cantilever are electrically connected in series.

4. The acoustic transducer according to claim 2 or 3, wherein
the plurality of detection regions are disposed closer to the fixed end, and
the non-detection region is disposed closer to the free end.

5. The acoustic transducer according to any one of claims 1 to 4, wherein
the piezoelectric element is a diaphragm, and
an outer circumference of the diaphragm is a fixed end that is fixed to the fixed frame.

6. The acoustic transducer according to claim 5, wherein
the plurality of detection regions include
an inner detection region that is disposed closer to a center of the diaphragm in a radial direction of the diaphragm, and
an outer detection region that is disposed farther from the center of the diaphragm in the radial direction of the diaphragm, and
the non-detection region includes
a circumferential electrode-free region that is formed to have a ring shape, is continuous in a circumferential direction of the diaphragm, and is formed between the inner detection region and the outer detection region, and
a plurality of radial electrode-free regions that extend in a radial direction of the diaphragm and are formed at intervals in the circumferential direction of the diaphragm.

7. The acoustic transducer according to any one of claims 1 to 6, wherein
the piezoelectric element includes a piezoelectric film, and
the piezoelectric film includes
a lower electrode,
a lower piezoelectric layer formed over the lower electrode,
an intermediate electrode formed over the lower piezoelectric layer,
an upper piezoelectric layer formed over the intermediate electrode, and
an upper electrode formed over the upper piezoelectric layer, and
a first electrode-free region, in which the upper electrode and the lower electrode are not formed, or a second electrode-free region, in which the intermediate electrode is not formed, is included between the plurality of detection regions.

8. The acoustic transducer according to claim 7, wherein
the piezoelectric element is a diaphragm,
an outer circumference of the diaphragm is a fixed end that is fixed to the fixed frame,
in the plurality of detection regions, the lower electrodes are electrically connected in series and the upper electrodes are electrically connected in series, or the intermediate electrodes are electrically connected in series, and
the upper electrode and the lower electrode in each of the plurality of detection regions are electrically connected in parallel.

9. The acoustic transducer according to claim 7, wherein
the first electrode-free region and the second electrode-free region are disposed alternately in a direction in which the plurality of detection regions are arranged.

10. The acoustic transducer according to according to any one of claims 1 to 9, wherein
the plurality of detection regions include a first detection region and a second detection region,
the first detection region includes
a first lower electrode,
a first lower piezoelectric layer formed over the first lower electrode,
a first intermediate electrode formed over the first lower piezoelectric layer,
a first upper piezoelectric layer formed over the first intermediate electrode, and
a first upper electrode formed over the first upper piezoelectric layer,
the second detection region includes
a second lower electrode,
a second lower piezoelectric layer formed over the second lower electrode,
a second intermediate electrode formed over the second lower piezoelectric layer,
a second upper piezoelectric layer formed over the second intermediate electrode, and
a second upper electrode formed over the second upper piezoelectric layer, and
a lower connecting electrode and an upper connecting electrode are formed between the first detection region and the second detection region, the lower connecting electrode connecting the first lower electrode and the second intermediate electrode, and the upper connecting electrode connecting the first upper electrode and the second intermediate electrode.

11. The acoustic transducer according to any one of claims 2 to 10, wherein
the plurality of detection regions include a first detection region and a second detection region,
the first detection region includes
a first lower electrode,
a first lower piezoelectric layer formed over the first lower electrode,
a first intermediate electrode formed over the first lower piezoelectric layer,
a first upper piezoelectric layer formed over the first intermediate electrode, and
a first upper electrode formed over the first upper piezoelectric layer,
the second detection region includes
a second lower electrode,
a second lower piezoelectric layer formed over the second lower electrode,
a second intermediate electrode formed over the second lower piezoelectric layer,
a second upper piezoelectric layer formed over the second intermediate electrode, and
a second upper electrode formed over the second upper piezoelectric layer,
between the first detection region and the second detection region,
the first lower electrode projects toward the second lower electrode in a second direction crossing the first direction in which the cantilever projects,
the second intermediate electrode projects toward the first intermediate electrode in the second direction, and
the first upper electrode projects toward the second upper electrode in the second direction, and
the acoustic transducer includes
an interconnect configured to connect a projecting part of the first lower electrode, a projecting part of the second intermediate electrode, and a projecting part of the first upper electrode.

12. The acoustic transducer according to claim 11, wherein
the interconnect includes
a first joining part that is formed over the first lower electrode and joined to the first lower electrode,
a first rising part that is connected to the first joining part and extends in a thickness direction of a piezoelectric film,
a second joining part that is connected to the first rising part, formed over the second intermediate electrode, and joined to the second intermediate electrode,
a second rising part that is connected to the second joining part and extends in the thickness direction of the piezoelectric film, and
a third joining part that is connected to the second rising part, formed over the first upper electrode, and connected to the first upper electrode.

13. An acoustic transducer, comprising:
a fixed frame; and
a continuous beam fixed to parts of the fixed frame, the parts facing both ends of the continuous beam, wherein
the continuous beam includes
a plurality of detection regions configured to detect a physical quantity, and
a non-detection region configured not to detect the physical quantity, and
electrodes of the plurality of detection regions are electrically connected in series.
